(19) **Europäisches Patentamt**
**European Patent Office**
**Office européen des brevets**

(11) **EP 1 764 715 B1**

(12) **EUROPÄISCHE PATENTSCHRIFT**

(45) Veröffentlichungstag und Bekanntmachung des Hinweises auf die Patenterteilung:
**17.11.2010 Patentblatt 2010/46**

(51) Int Cl.:
***G06F 17/50*** *(2006.01)*

(21) Anmeldenummer: **05020124.3**

(22) Anmeldetag: **15.09.2005**

(54) **Verfahren zur Bestimmung der Güte einer Menge von Eigenschaften, verwendbar zur Verifikation and zur Spezifikation von Schaltungen**

Method for determining the quality of a set of properties, applicable for the verification and specification of circuits

Méthode pour déterminer la qualité d'un nombre des propriétés, utilisable pour la vérification et la spécification des circuits

(84) Benannte Vertragsstaaten:
**AT BE BG CH CY CZ DE DK EE ES FI FR GB GR HU IE IS IT LI LT LU LV MC NL PL PT RO SE SI SK TR**

(43) Veröffentlichungstag der Anmeldung:
**21.03.2007 Patentblatt 2007/12**

(73) Patentinhaber: **Onespin Solutions GmbH 80339 München (DE)**

(72) Erfinder:
  • **Bormann Jörg 82049 Pullach (DE)**
  • **Busch Holger, Dr. 85649 Brunnthal (DE)**

(74) Vertreter: **Hofmann, Harald et al Sonnenberg Fortmann Patent- und Rechtsanwälte Postfach 33 08 65 80068 München (DE)**

(56) Entgegenhaltungen:
**US-B1- 6 594 804**

• **GROSSE D ET AL: "Acceleration of SAT-based iterative property checking"[Online] 2005, Seiten 1-8, XP002370628 Gefunden im Internet: URL: http://www.informatik.uni-bremen.de/gr p/ag-ram/doc/konf/charme05_acc_sat_pc.pdf> [gefunden am 2006-03-06]**
• **NIMMER J W ET AL: "Static verification of dynamically detected program invariants - Integrating Daikon and ESC/Java" ELECTRONIC NOTES IN THEORETICAL COMPUTER SCIENCE, ELSEVIER, Bd. 55, Nr. 2, Oktober 2001 (2001-10), Seiten 255-276, XP004871716 ISSN: 1571-0661**
• **S. KATZ ET AL.: ""Have I Written Enough Properties?"-a Method of Comparison Between Specification and Implementation" CHARME 99, LCNS 1703, 1999, Seiten 280-297, XP002370629**
• **R. DRECHSLER ET. AL: "Design Understanding by Automatic Property Generation"[Online] XP002370630 Institute of Computer Science, University of Bremen Gefunden im Internet: URL: http://www.informatik.uni-bremen.de/gr p/ag-ram/doc/work/04sasimi_designUnd.pdf> [gefunden am 2006-03-03]**

**Beschreibung**

Die vorliegende Erfindung betrifft allgemein ein Verfahren zur Bestimmung der Güte einer Menge von einen Automaten beschreibenden Eigenschaften. Bei einem Automaten der in Frage stehenden Art kann es sich sowohl um Software als auch Hardware handeln. Im Sinne dieser Anmeldung ist ein Automat geeignet mittels Eigenschaften beschrieben zu werden. Solche Eigenschaften sind dem Fachmann aus dem Gebiet der funktionalen Verifikation digitaler Schaltungen generell bekannt. Ein exemplarischer Automat ist mithin eine digitale Schaltung.

Bei der funktionalen Verifikation wird eine RTL-Beschreibung einer Schaltung daraufhin geprüft, ob sie richtig funktionieren wird. Die Qualität der RTL-Beschreibung nach der funktionalen Verifikation ist entscheidend für den Erfolg eines Schaltungsentwurfsprojekts. Verbleibende Fehler führen leicht zu hohen Kosten-, Zeit- und Ansehensverlusten.

Weiterhin ist der Einsatz von Simulation als Hauptarbeitspferd bei der funktionalen Verifikation üblich. Dazu werden automatisch oder vom Benutzer Eingabemuster vorgegeben und die durch die Simulation erzeugten Ausgabemuster mit den Erwartungen verglichen. Fehler werden erkannt, wenn ein Ausgabemuster nicht mit den Erwartungen übereinstimmt. Automatische Mechanismen zur Fehlererkennung bei der Simulation werden im Folgenden Monitore genannt.

Um einen Fehler zu erkennen, muss ein geeignetes Eingabemuster vorgegeben worden sein, zu dem die Simulation ein Ausgabemuster erzeugt, in dem der Fehler aufscheint. Schon bei kleinen Schaltungen ist die Menge aller möglichen Eingabemuster sehr groß. Ferner ist der Faktor zwischen der Laufzeit einer realen Schaltung und ihrer Simulation im Bereich von $10^6$. Daher können im Vergleich mit der Gesamtheit nur wenige Eingabemuster simuliert werden, sodass viele funktionale Fehler unentdeckt bleiben.

Zur funktionalen Verifikation werden in immer stärkerem Maße sogenannte Eigenschaftsprüfer eingesetzt. Eigenschaftsprüfer erhalten als Eingabe eine "Eigenschaft" genannte, in einer formalen Sprache beschriebene Beziehung über gewisse Aspekte des Verhaltens dieser Schaltung. Als Ergebnis liefert ein Eigenschaftsprüfer in meist erstaunlich kurzer Zeit

- entweder die Nachricht, dass die Eigenschaft durch den Eigenschaftsprüfer bewiesen wurde. In diesem Fall wird sich die in der Eigenschaft beschriebene Beziehung zwischen den Verhaltensaspekten immer einstellen, egal wie die Schaltung betrieben wird,

- oder eine Widerlegung, in der ein Eingabemuster für die Schaltung beschrieben wird, das die Beziehung zwischen den Verhaltensaspekten verletzt. Diese Widerlegung wird vom Eigenschaftsprüfer generiert.

Die automatische Erzeugung von Gegenbeispielen und die schnelle Prüfung der Eigenschaft auf allen möglichen Eingabemustern ist für die funktionale Verifikation ein großer Fortschritt gegenüber der Simulation.

Deshalb werden heute von innovativen Verifikationsgruppen auch Eigenschaftsprüfer eingesetzt. Sie verifizieren aber nur punktuell als kritisch betrachtete Verhaltenszusammenhänge, die von einem Verifikationsingenieur aufgrund von Gespür und Erfahrung ausgewählt wurden. Dies erlaubt jedoch nur graduelle Verbesserungen der Qualität der RTL-Beschreibung nach der Verifikation. Im Ergebnis verbleiben noch immer relativ viele Fehler im Design.

Im Umfeld der Schaltungsverifikation mittels Simulation wurden bereits Verfahren zur Bewertung der Qualität der Verifikationsumgebung, die sogar Maßzahlen berechnen, die mit dieser Qualität in Zusammenhang stehen sollen, vorgeschlagen. Hierin hat die Anzahl und die Verschiedenartigkeit (Coverage) der zur Simulation verwandten Eingabemuster einerseits die größte Bedeutung für die Qualität der Verifikationsumgebung, andererseits verursacht das Streben nach vielen verschiedenartigen Eingabemustern auch die größten Aufwände.

Die entsprechenden Verfahren sind bereits seit Jahren in Gebrauch und werden durch kommerzielle EDA-Werkzeuge unterstützt (siehe z.B.

D. Dempster, M. Stuart: "Verification Methodology Manual - Techniques for Verifying HDL Designs", Teamwork International, 2nd edition, 2001; und S. Tarisan, K. Keutzer: "Coverage Metrics for Functional Validation of Hardware Designs", IEEE Design & Test of Computers. 2001.) Die Metriken zur Bestimmung der Maßzahlen sind oft auf den Code bezogen, so die Zeilenabdeckung, Pfadabdeckung, Zuweisungsabdeckung und Abdeckung von Zuständen expliziter Zustandsautomaten aus dem RTL-Code.

Solche Methoden zur Messung der Qualität einer Verifikation wurden zuerst für die Softwareverifikation entwickelt. Im Unterschied zu sequentieller Software operiert Hardware aber in Form paralleler Prozesse. Die sich daraus ergebenden Abhängigkeiten werden von den Methoden daher nicht berücksichtigt, sodass die sich ergebenden Qualitätsmaßzahlen nicht verlässlich sind. Daher sind alternative Maßzahlen vorgeschlagen worden, z. B. solche, die auf Signale bezogen sind und etwa die Zuweisung aller möglichen Werte verlangen. Daneben gibt es Funktionale Metriken, die anzeigen, wie oft bestimmte Funktionalität ausgeführt wurde.

Eine inhärente Schwäche aller dieser Ansätze ist jedoch, dass das Erreichen eines Maßes von 100% noch längst nicht die vollständige Verifikation aller Funktionalität absichert. Einerseits erreichen diese Ansätze bereits 100% Coverage, wenn noch gar nicht alle Funktionalität und damit alle möglichen Fehlerquellen der untersuchten Schaltung ausgelöst wurden, andererseits gibt es keine systematische Prüfung, ob die Verifikationsumgebung in der Lage ist, jeden aufscheinenden Fehler auch wirklich zu identifizieren.

Die Eigenschaftsprüfung ist beispielhaft beschrieben in: A.Biere, A.Cimatti, M.Fujita, Y.Zhu: "Symbolic Model Checking using SAT procedures instead of BDDs" Proc. of 36th Design Automation Conference, 1999.; und in: "Formale Verifkation für Nicht-Formalisten (Formal Verification for Non-Formalists", Bormann, J. and Spalinger, C: (2001), Informationstechnik und Technische Informatik, Vol. 43, Issue 1/2001, Oldenburg Verlag.

Bei der Qualitätssicherung einer auf Eigenschaftsprüfung basierenden Verifikationsumgebung geht es gerade nicht um die Vielfalt und Verschiedenheit der Eingabemuster, denn ein Eigenschaftsprüfer arbeitet, als ob er alle Eingabemuster untersuchen würde. Statt dessen geht es um die Vollständigkeit des Eigenschaftssatzes, also darum, ob jeder Schaltungsfehler beim Beweis von wenigstens einer der Eigenschaften aufgedeckt wird.

Arbeiten hierzu sind dokumentiert, z. B. in: Hojati, R.: "Determining Verification Coverage Using Circuit Properties" US Patent 6594804, granted July 15th, 2003; Hoskote, Kam, Ho, and Zhao: "Coverage Estimation for Symbolic Model Checking" Proc. of 36th Design Automation Conference, 1999; und in: Hoskote, Y. "Property Coverage in Formal Verification", Patent WO200079421-A2. Diese Ansätze basieren allesamt darauf, nacheinander Fehler in die Schaltung zu injizieren und dann zu prüfen, ob mindestens eine der Eigenschaften durch den Eigenschaftsprüfer auf der so modifizierten Schaltung widerlegt wird. Wenn jeder injizierte Fehler zu einer Widerlegung führt, wird die Qualität des Eigenschaftssatzes als ausreichend hoch bezeichnet. Ansonsten wird eine Maßzahl über den Anteil derjenigen injizierten Fehler bestimmt, die von dem Eigenschaftssatz aufgedeckt werden.

Bei den Bekannten Verfahren wird entweder als Fehler injiziert, dass Signale in verschiedenen erreichbaren Zuständen invertiert werden oder es wird in der Netzliste das Gatter verändert, an dessen Ausgang das abzudeckende Signal abgegriffen wird.

Diese Verfahren sind heuristisch. Es gibt keine Garantie dafür, dass andere als die injizierten Fehler von dem Eigenschaftssatz identifiziert werden. Die Verfahren benötigen neben der Eigenschaftsmenge auch zwingend die Schaltungsbeschreibung.

Nachdem wie oben beschrieben Eigenschaften lediglich punktuell und nach der Erfahrung eingesetzt werden, besteht ein Bedarf an einem Verfahren, welches die Güte einer Menge an Eigenschaften reproduzierbar und zuverlässig angeben kann, insbesondere in der Form einer Masszahl, die dann mit einem Vorgabewert in Übereinstimmung gebracht werden kann, indem die Menge erweitert oder angepasst wird.

Es besteht ferner ein Bedarf an Verfahren zur zuverlässigeren Verifikation und zur Spezifikation von Schaltungen, basierend auf der reproduzierbaren Güte einer Menge von Eigenschaften.

Aus der Veröffentlichung Grosse et al. "Acceleration of SAT-based iterative property checking" http://www.in-informatik.uni-bremen/grp/ag-ram/doc/konf/charme05-acc-sat-pc.pdf ist ein Ansatz beschrieben, um einen Eigenschaftstest zu beschleunigen (vgl. Abstract, 2. Absatz "in this paper we propose a new approach to speed up SAT-based iterative checking"). Es handelt sich dabei nicht um ein Verfahren zur Bestimmung der Güte einer Menge von Eigenschaften. Es wird nicht die Güte einer Menge der Eigenschaften bestimmt und auch das Zusammenspiel von Eigenschaften nicht betrachtet.

Die Vollständigkeit der Spezifikation hängt in dieser Grosse et al.-Veröffentlichung von der Implementierung der Schaltung ab. Das Kriterium der Güte ist somit von dem eingegebenen Design abhängig, und nicht designunabhängig.

Die Veröffentlichung_Nimmer et al. "Static verification of dynamically detected program invariants" Electronic notes in computer science, elssevier, Bd55, Nr. 2, Okt. 2001, 255-276 beschreibt eine statische Verifikation von dynamisch detektierten Programm Invarianten. Es handelt sich nicht um ein Verfahren zur Bestimmung der Güte einer Menge von Eigenschaften.

Die Veröffentlichung Katz et al. "Have I written enough properties?" Charme 99, LCNS 1703, 19999, 280-297 beschreibt einen Ansatz zur Bestimmung der Qualität eines Modell-Checking-Prozesses, bei dem geprüft wird, ob eine Spezifikationsformel eine ausreichende Beschreibung liefert. Das Verfahren in dieser Katz-Veröffentlichung benötigt die Eingabe eines Designs (vgl. Abstract, 2. Absatz "the completeness of the specification with respect to a given implementation is determined as follows").

Drechsler et al. "Design understanding by automatic property generation" www.informatik.nibremen.de/grp/ag-ram/doc/work/04sasimi_designUnd.pdf beschreibt ein Verfahren, um Eigenschaften für ein vorgegebenes Design zu generieren, um dieses Design zu überprüfen. Dabei geht es nicht um miteinander in Relation stehende Eigenschaften, sondern lediglich um den Zeitpunkt der Verifikation.

Somit ist es eine Aufgabe der vorliegenden Erfindung Verfahren anzugeben, welche die Güte einer Menge von einen Automaten beschreibenden Eigenschaften bestimmen und verwenden, ohne übermäßigen Aufwand und ohne auf Erfahrungswerte zurückgreifen zu müssen.

Erfindungsgemäß werden obige Aufgaben durch die Verfahren des unabhängigen Anspruchs gelöst, wobei bevorzugte Ausführungsformen Gegenstand von abhängigen Ansprüchen sind. Durch die Feststellung der Güte einer Menge von einen Automaten beschreibenden Eigenschaften ist es möglich in Effizienterer Weise die Eigenschaften zu nutzen.

Insbesondere schlägt die Erfindung ein Verfahren zur Bestimmung der Güte einer Menge von einen Automaten beschreibenden Eigenschaften vor, umfassend, die Feststellung der Existenz zumindest einer Untermenge von miteinander in Relation stehenden Eigenschaften $(P_0, P_1, \ldots P_n)$; und die Überprüfung, ob durch das Zusammenspiel von $(P_0, P_1, \ldots P_n)$ zu mindestens einem Eingabemuster des Automaten der Wert eines vorgegebenen Ausdrucks $Q(t)$ zu mindestens einem Zeitpunkt eindeutig bestimmt wird, zu dem er durch die Betrachtung der einzelnen Eigenschaften nicht eindeutig bestimmt ist, wobei $Q(t)$ nur von Werten von Eingabe- und Ausgabegrößen zu Zeitpunkten relativ zu t abhängt.

$Q(t)$ kann dabei eine Benutzervorgabe sein oder einer Referenztabelle wie etwa der Liste der Ausgabegrößen des Automaten entnommen werden.

$Q(t)$ wird als auf einem Eingabemuster zu einem Zeitpunkt T durch eine Menge von Eigenschaften eindeutig bestimmt angenommen, wenn zu zwei Wertefolgen auf den Ausgabe- und internen Größen, die das Eingabemuster so ergänzen, dass alle Eigenschaften der Menge darauf gelten, der Wert von $Q(T)$ auf der einen Ergänzung gleich dem Wert von $Q(T)$ auf der anderen Ergänzung ist.

Dass die einzelnen Eigenschaften keinen Ausgabewert und damit auch keinen Wert $Q(t)$ eindeutig bestimmen, ist für die Eigenschaftsprüfung typisch, denn die Eigenschaften sind oft von der Form

forall t:

((Bedingung 1 über Werte interner Größen zum Zeitpunkt t) und

(Bedingung über Eingabewerte zum Zeitpunkt t) und

(Bedingung über Eingabewerte zum Zeitpunkt t+1) und

(Bedingung über Eingabewerte zum Zeitpunkt t+2) und

…und

(Bedingung über Eingabewerte zum Zeitpunkt t+n))

=>

((Ausgabegrößen haben zum Zeitpunkt t bestimmte Werte) und

(Ausgabegrößen haben zum Zeitpunkt t+1 bestimmte Werte) und

…und

(Ausgabegröße haben zum Zeitpunkt t+n bestimme Werte) und

(Bedingung 2 über interne Größen zum Zeitpunkt t+n)

Das Zeichen => steht dabei für die logische Implikation. Die Eigenschaft alleine bestimmt keine Ausgabegrößen eindeutig, weil die Ergänzungen zu einem Eingabemuster immer so gewählt werden können, dass sie die Bedingung 1 verletzen und dann die Werte der Ausgabegrößen ganz widersprüchlich gewählt sein können. Derartige Ergänzungen erfüllen die Eigenschaft, und zeigen, dass kein Ausgabewert eindeutig bestimmt ist. Die Ausgabewerte würden von der obigen Eigenschaft für ein Eingabemuster eindeutig bestimmt werden, wenn sie mit einer Reseteigenschaft kombiniert wird, die sicherstellt, daß die Belegung der internen Signale nach der Aktivierung des Reseteingangs die Bedingung 1 erfüllt.

Die Erfindung basiert somit auf der Prüfung, ob einzelne Eigenschaften, die gemäß dem Stand der Technik nur singulär zum Einsatz kommen und berücksichtigt werden, miteinander in Relation stehen.

Anhand dieses Grundkonzeptes können Eigenschaften systematisch identifiziert und verwendet werden und zum Beispiel Eigenschaftsketten bilden, die eine von internen Signalen unabhängige Aussage über das Ein-/Ausgabeverhalten des Automaten über einen längeren Zeitraum machen.

Nach einer bevorzugten Ausführungsform bilden die in Relation stehenden Eigenschaften eine Folge von Eigenschaften, die mit einer Eigenschaft beginnt, die das Initialisierungsverhalten des Automaten beschreibt und eine Aussage über das Ein-/ Ausgabeverhalten des Automaten oder auch einer Schaltung über einen längeren Zeitraum machen, wobei diese Aussage überhaupt nicht mehr von internen Signalen abhängig ist.

Vorteilhafterweise werden diejenigen Eigenschaften an den Benutzer gemeldet, die bei der Bildung der Folge von Eigenschaften nicht berücksichtig wurden. Hierdurch ist es möglich, in effizienter Weise die Menge der Eigenschaften anzupassen oder zu komplettieren, da entweder die in Frage stehende Eigenschaft umformuliert oder zu dieser eine Vorgänger- und/oder Nachfolger-Eigenschaft bereitzustellen ist.

Wenn die Eigenschaften die Form $P_i$ = forall t: $A_i(t) => Z_i(t)$ haben mit implikativ verknüpften Booleschen Ausdrücken $A_i$ und $Z_i$, die von Werten der Eingabe-, Ausgabe- und internen Größen zu Zeitpunkten relativ zu t abhängen, kann im Feststellungsschritt vorteilhaft geprüft werden, ob eine Folge von Referenzzeitpunkten $T_1$, $T_2$, ... $T_n$ existiert, so dass die durch die Verkettung der Eigenschaften bezüglich der Referenzzeitpunkte gegebene Eigenschaft

$$E = \text{forall } t. \quad (A_0(t) => Z_0(t)) \text{ und}$$
$$((A_0(t) \text{ und } A_1(T_1)) => Z_1(T_1)) \text{ und}$$
$$((A_0(t) \text{ und } A_1(T_1) \text{ und } A_2(T_2)) => Z_2(T_2)) \text{ und}$$
$$\ldots \text{und}$$
$$((A_0(t) \text{ und } A_1(T_1) \text{ und } \ldots \text{ und } A_n(T_n)) => Z_n(T_n))$$

das Ein-/Ausgabeverhalten bereits so beschreibt, dass mindestens ein Eingabemuster gefunden werden kann, auf dem E zu mindestens einem Zeitpunkt den Wert von Q(t) eindeutig beschreibt.

Zu einer Menge von Eigenschaften wird automatisch bestimmt, welche Eigenschaften aufeinanderfolgen dürfen, und wie die Referenzzeitpunkte dabei zu bilden sind. Dadurch ist ein Graph bestimmt, dessen einzige Quelle die Eigenschaft über das Initialisierungsverhalten des Automaten ist und dessen endliche, in der Reseteigenschaft beginnenden Pfade die Mengen oder Folgen der untereinander in Relation stehenden Eigenschaften bilden. Für jede Eigenschaft und jedes Ausgabesignal werden Zeitbereiche berechnet, an denen das Ausgabesignal eindeutig definiert ist, sofern die Eigenschaft in einer Folge steht, die mit der Initialisierungs- oder Reseteigenschaft beginnt und bei der die Referenzzeitpunkte entsprechend den berechneten Werten gewählt werden. Auf der Basis dieser Zeitbereiche lässt sich dann auch entscheiden, zu welchen Zeitpunkten Q(t) eindeutig definiert ist.

Vorteilhafterweise werden die Mengen von Eingabemustern beschrieben, auf denen Q(t) zu jeweils mindestens einem Zeitpunkt eindeutig bestimmt ist.

Wenn die Eigenschaften in der oben beschriebenen implikativen Form gegeben sind, besteht die Menge von Eingabemustern, auf denen Q(t) zu jeweils mindestens einem Zeitpunkt eindeutig bestimmt ist, aus denjenigen Eingabemustern, zu denen es jeweils eine Wertefolge der internen und Ausgabegrößen gibt, sodaß es mindestens einen Zeitpunkt t gibt, für den auf diesen Wertefolgen $A_0(t)$ und $Z_0(t)$ und $A_1(T_1)$ und $Z_1(T_1)$ und ... und $A_n(T_n)$ gilt.

Im Allgemeinen werden die Referenzzeitpunkte von t und von Werten der Eingabegrößen zu Zeitpunkten relativ zu t abhängen. Es ist aber vorteilhaft, wenn die Referenzzeitpunkte nur von t abhängen.

Die in Relation stehenden Eigenschaften stehen bevorzugt in einer Nachfolgebeziehung, wobei insbesondere für $i \neq 0$ die Werte auf Ausgabe- und internen Signalen, die bei geeigneter Wahl des Eingabemusters $Z_{i-1}(t)$ erfüllen können, auch den Booleschen Ausdruck $A_i(t')$ für eine geeignete Eingabefolge und einen Zeitpunkt t' erfüllen können.

Die Bedingung hängt eng mit der Bedingung zusammen, dass $A_i(t)$ und $Z_{i-1}(t)$ bis auf zeitliche Verschiebung syntaktisch gleiche Teilausdrücke über Ausgabe- und interne Größen enthalten.

Indem durch eine Nachfolgerrelation, die zwischen den Elementen einer endlichen Eigenschaftsmenge sicherstellt, dass eine Eigenschaftsfolge immer weiter verlängert werden kann, ist es möglich, auch unendlich lange Zeitbereiche auf einem Eingabemuster zu untersuchen und Aussagen darüber zu machen, zu welchen Zeitpunkten Q(t) eindeutig definiert ist. Insbesondere kann festgestellt werden, dass Q(t) auf einem Eingabemuster für alle Zeitpunkte nach einem ersten Zeitpunkt eindeutig bestimmt ist, insbesondere indem man einen Graphen bestimmt, dessen endliche Pfade alle möglichen Eigenschaftsfolgen bestimmen.

Um weitere Untermengen zu ermitteln zu können wird vorteilhafter Weise der Schritt des Feststellens der Existenz von zumindest einer Untermenge von miteinander in Relation stehenden Eigenschaften wiederholt. Hierdurch ist es z.B. möglich, sämtliche auf der Basis der Eigenschaften möglichen Eigenschaftsketten zu ermitteln.

Bevorzugt wird das Überprüfen, ob zu allen Eingabemustern und zu allen Ausgabegrößen eines Automaten und zu allen Zeitpunkten nach einem ersten Zeitpunkt die Ausgabegrößen des Automaten eindeutig bestimmt sind.

Bevorzugt wird eine Gütemaßzahl ermittelt und ausgegeben, die der Wahrscheinlichkeit entspricht, dass zu einem beliebigen Eingabemuster, das mit der Initialisierung der Schaltung beginnt, zu einem beliebigen Zeitpunkt und zu einer beliebigen Ausgabegröße der Wert dieser Ausgabegröße an diesem Zeitpunkt durch die Eigenschaft eindeutig bestimmt ist.

Die Erfindung schlägt auch ein Verfahren zur funktionalen Verifikation digitaler Schaltungen vor, bei welchem die Schaltung mit einer Menge von Eigenschaften überprüft wird, deren Güte wie vorangehend beschrieben bestimmt wurde und einer definierten Vorgabe entspricht. Bei der definierten Vorgabe kann es sich um einen Festgelegten Schwellenwert handeln oder um einen vom Anwender eingegebenen Wert, bei welchem die Güte für ausreichend erachtet wird, weil z.B. eine weitere Verbesserung nur durch unverhältnismassigen Mehraufwand erzielt werden kann. Bei der sukzessiven Entwicklung der Eigenschaften kann die Güte überwacht werden und aus der Differenz zwischen der Vorgabe und dem Ist-Wert Rückschlüsse auf die noch zu erbringenden Aufwände gemacht werden.

Die Erfindung schlägt des weiteren ein Verfahren zur Spezifikation von digitalen Schaltungen vor, bei welchem die Spezifikation erstellt wird, ausgehend von einer Menge von Eigenschaften, deren Güte wie vorangehend beschrieben bestimmt wurde und einer definierten Vorgabe entspricht. Bei der sukzessiven Entwicklung der Eigenschaften kann die Güte überwacht werden und aus der Differenz zwischen der Vorgabe und dem Ist-Wert Rückschlüsse auf die noch zu erbringenden Aufwände gemacht werden.

Die Erfindung schlägt ein Verfahren zur simulativen Verifikation digitaler Schaltungen vor, bei welchem Monitore zur Fehlererkennung verwendet werden, wobei die Monitore Automaten darstellen, und die Qualität der Monitore bestimmt wird anhand der Güte einer den Monitor beschreibenden Menge von Eigenschaften, bestimmt wie vorangehend beschrieben. Auf diese Weise kann zum ersten Mal die Qualität der Monitor systematisch überwacht werden.

Die Erfindung schlägt schließlich ein Verfahren zur simulativen Verifikation digitaler Schaltungen vor, bei dem die Coverage bestimmt wird durch Monitore, die aus den Annahmen eines Satzes von Eigenschaften gewonnen werden, deren Güte wie vorausgehend dargelegt ermittelt wurde und einer definierten Vorgabe entspricht. Insbesondere kann damit sichergestellt werden, dass die Coverage von einem vollständigen Eigenschaftssatz abgeleitet wird und damit einerseits funktionale Aspekte ausdrückt und andererseits alle Funktionalität eines Moduls überdeckt. Diese Coverage vereinigt also die Passgenauigkeit funktionaler Coverage mit der Breite der Überdeckung von Codebasierter Coverage und ist damit insbesondere für die Systemsimulation besonders geeignet.

Zusammenfassend erlaubt die Erfindung also, eine Menge von Eigenschaften daraufhin zu überprüfen, ob sie nicht nur kritische Verhaltenszusammenhänge punktuell, sondern die gesamte Funktion der zu untersuchenden Schaltung überdecken. Wenn die Eigenschaften alle auf dem Automaten (z. B. Software oder Schaltung) durch einen Eigenschaftsprüfer bewiesen sind, bleiben nur Fehler unentdeckt, die auch in den Eigenschaften stehen. Das Hauptproblem der Simulation, dass Fehler unentdeckt bleiben, weil sie in keinem der erzeugten Ausgabemuster vorkommen, wird vermieden. Dadurch steigt die Qualität, die die RTL-Beschreibung nach Abschluss der Verifikation hat. Die Erfindung erlaubt somit erstmalig eine Schaltungsverifikation ausschließlich mit Eigenschaftsprüfung durchzuführen.

Dass die Mechanismen zur Fehlererkennung (d.h. die Monitore oder die Eigenschaften) selber fehlerhaft sein können, und damit Schaltungsfehler verbergen, ist eine Eigenart jeder funktionalen Verifikation. Auch bei Simulation gibt es dieses Problem, das sich dort darin niederschlägt, dass die Monitore Fehler nicht erkennen, obwohl sie in einem Ausgabemuster auftreten. Wenn das passiert, wurde der dafür verantwortliche Monitor entweder unvollständig auskodiert, d.h. er führt in einer von der Simulation erzeugten Situation gar keine Prüfung durch, oder aber der Monitor erwartet tatsächlich einen falschen Wert.

Erfindungsgemäß kann sichergestellt werden, daß die Eigenschaften zu jedem Zeitpunkt alles Verhalten prüfen. Unvollständigkeit der Eigenschaften wird also automatisch identifiziert. Damit werden auch solche Fehler vermieden, die durch Unvollständigkeit der Verifikationsumgebung sonst unentdeckt bleiben würden.

In diesem Zusammenhang ist anzumerken, dass die Erfindung nicht auf die Anwendung im Umfeld eines Eigenschaftsprüfers beschränkt ist. Sie kann auch Unvollständigkeiten bei Monitoren identifizieren. Dazu müssen die Monitore aus Eigenschaften generiert werden, die entsprechend überprüft wurden. Die Generierung von Monitoren aus Eigenschaften ist dem Fachmann geläufig. Verfahren zur Qualitätssicherung von Monitoren sind bis dato nur bekannt durch Code-Review und Wiederverwendung, was jedoch mit dem erfindungsgemässen Ansatz nicht vergleichbar ist.

Die Eigenschaften beschreiben das Automaten- oder Schaltungsverhalten üblicherweise abstrakter als die RTL-Beschreibung. Sie beschreiben das Automaten- bzw. Schaltungsverhalten meist über mehrere Takte, sodass die Abläufe in einem Automaten / einer Schaltung allgemeingültig und geschlossen dargestellt werden. Dadurch geben sie dem Verifikationsingenieur mehr Überblick als die RTL-Beschreibung, sodass zusätzlich Fehler in den Eigenschaften vermieden werden. Die Erfindung überprüft, ob eine Menge von Eigenschaften die Qualität einer Automaten-/ Schaltungsbeschreibung auf einem höheren Abstraktionsniveau hat.

Beim Stand der Technik bezüglich der Simulation ist die Auswertung gewisser Bedingungen mit dem Ziel, die Anzahl und Vielfalt der simulierten Eingabemuster und damit die Wahrscheinlichkeit dafür zu bewerten, dass fehlerhafte Automaten-/Schaltungsteile auch wirklich ausgeführt wurden (Coverage). Die dafür eingesetzten Bedingungen orientieren sich häufig an dem Text der Automaten-/Schaltungsbeschreibung. In diesem Fall wird mit Bedingungen gearbeitet, die durch die Ausführung einer Zeile (oder auch nur eines Teils der Zeile) in der Automaten-/Schaltungsbeschreibung erfüllt werden. Diese Vorgehensweise hat den Vorteil, daß derartige Bedingungen flächendeckend jeden Teil des Automaten bzw. der Schaltung berücksichtigen. Sie wird aber als unzulänglich betrachtet, weil sie die parallele Ausführung von Automaten-/Schaltungsteilen nicht berücksichtigt: Daher werden die textorientierten Bedingungen ergänzt durch Bedingungen, die bei bestimmten Teilabläufen erfüllt werden (funktionale Coverage). Derartige Bedingungen werden heutzutage nur punktuell definiert, wo sie nach Gespür und Erfahrung des Verifikationsingenieurs erforderlich sind. Die Erfindung erlaubt die Definition eines Satzes derartiger Bedingungen, die jeweils dann erfüllt sind, wenn einzelne Eigenschaften das Automaten-/Schaltungsverhalten beschreiben. Ein solcher Satz von Bedingungen berücksichtigt einerseits alle Automaten-/Schaltungsteile und andererseits auch ihre Parallelausführung. Es sind keine Verfahren bekannt, mit denen Bedingungssätze ähnlicher Qualität erzeugt werden können.

All dies trägt dazu bei, dass die Anzahl der in einem Design verbliebenen Fehler nach Abschluss einer Verifikation, die die vorliegende Erfindung nutzt, weit geringer ist, als nach einer simulationsbasierten Verifikation. Durch die Effizienz der Eigenschaftsprüfer spart eine solche Verifikation meist deutlich Arbeitsaufwand.

Dabei liefert die Erfindung bevorzugt ein klares Kriterium zur Beendigung der Verifikation per Eigenschaftsprüfer. Wenn ein Eigenschaftssatz vollständig ist oder dem Vorgabewert genügt, ist die Verifikation beendet, andernfalls muss sie fortgesetzt werden. Solche Kriterien kennen die Verfahren nach dem Stand der Technik nicht. Hier wird die Verifikation fortgesetzt, bis entweder das Zeit- oder Geldbudget verbraucht ist, oder bis bestimmte Vorgaben erfüllt sind, die heuristisch nahe legen, daß nun das Restrisiko unterhalb eines tolerierbaren Wertes gesunken ist.

Die Erfindung kann auch eingesetzt werden, bevor ein Eigenschaftssatz überhaupt mit einem Eigenschaftsprüfer gegen einen Automaten bzw. eine Schaltung verifiziert wird. Das wird wichtig, wenn ein solcher Eigenschaftssatz die Rolle einer Spezifikation spielen soll. Insofern kann die Erfindung eine notwendige Bedingung für die Qualität einer Spezifikation bereitstellen. Diese Bedingung ist nicht hinreichend: Es gibt Eigenschaftssätze, die als vollständig bezeichnet werden können, obwohl es keine Schaltung gibt, die alle Eigenschaften eines solchen Eigenschaftssatzes erfüllen.

Zur Steuerung eines Verifikationsprozesses liefert die Erfindung bevorzugt eine Vollständigkeitsmaßzahl, die es während des Prozesses erlaubt, den Fortschritt der Verifikation darzustellen. Diese Maßzahl wächst mit wachsender Eigenschaftsmenge und bekommt nur den Wert 1, wenn die Eigenschaftsmenge vollständig ist. Damit lässt sich das Verifizieren mit einem Eigenschaftsprüfer wesentlich präziser überwachen, als mit allen bisher bekannten Verfahren.

Weitere Vorteile und Merkmale der Erfindung und ein detaillierteres Verständnis ergeben sich aus der nachfolgenden Beschreibung von derzeit bevorzugten Ausführungsformen, wobei die Beschreibung als rein illustrativ und nicht als einschränkend anzusehen ist, wobei auf die beiliegenden Zeichnungen Bezug genommen wird, in denen gilt:

Fig. 1 beschreibt einige Beispiele für Teileigenschaftsgraphen

Fig.2 zeigt ein Verfahren zur Prüfung der Vollständigkeit

Fig.3 beschreibt ein Verfahren zur funktionalen Verifikation mit einem Eigenschaftsprüfer entsprechend des Stands der Technik

Fig.4 zeigt ein Verfahren zur Bestimmung redundanter Vorgaben für den Vollständigkeitsprüfer und die Bestimmung der Maßzahl

Fig.5 zeigt ein Verfahren zur Bestimmung einer Vollständigkeitsmaßzahl

Fig.6 zeigt den Graphen des vollständigen Eigenschaftsautomaten des Beispiels

Fig.7 zeigt den Graph eines unvollständigen Eigenschaftsautomaten

Fig.8 zeigt den mit Zwischenergebnissen der Ermittlung der Vollständigkeitsmaßzahl annotierten Ausführungsbaum des Eigenschaftsautomaten aus Fig. 7

Die Beispiele beziehen sich auf Schaltungen als einen der möglichen Automaten und werden nachfolgen in der temporalen Sprache ITL dargestellt. Die Erfindung ist jedoch weder auf diese temporale Logik noch auf Schaltungen beschränkt. Die Verfahren können auch mit allen anderen linearen temporalen Logiken wie beispielsweise LTL, PSL oder SVA durchgeführt werden und auch Anwendung finden auf Software oder andere Automaten. Die Beschriebenen Verfahren können sowohl hardwaretechnisch als auch als Software implementiert werden.

Die temporale Logik wird zur Beschreibung der Beziehung zwischen Verhaltensaspekten in den Eigenschaften benutzt. In der folgenden Darstellung wird eine leichte Modifikation der Sprache ITL, der Eingabesprache eines Eigenschaftsprüfers verwendet. In dieser Sprache werden zeitliche Aspekte durch Rückgriff auf Zeitpunkte beschrieben. Zeitpunkte entsprechen Taktzyklen bei synchronen Digitalschaltungen.

Kernstück von ITL sind logische Zeilen einer der drei Formen

- at <Zeitpunkt>: <boolesche Bedingung>;
- during [<Zeitpunkt$_1$>, <Zeitpunkt$_2$>]: <boolesche Bedingung>;
- within [<Zeitpunkt$_1$>, <Zeitpunkt$_2$>]: <boolesche Bedingung>;

Die erste Form verlangt die Gültigkeit der booleschen Bedingung am angegebenen Zeitpunkt, die zweite für alle Zeitpunkte in dem Intervall und die dritte für mindestens einen Zeitpunkt im Intervall. Wenn das Intervall leer ist, ist die zweite Form trivialerweise erfüllt und die dritte Form trivialerweise nicht erfüllt.

Die Auswertung einer Booleschen Bedingung an einem bestimmten Zeitpunkt T erfolgt bei allen üblichen Operatoren durch Auswertung der Teilausdrücke an diesem Zeitpunkt T, bis ein Teilausdruck durch ein Signal gegeben ist, dessen Wert zum Zeitpunkt T dann eingesetzt wird. Zur Auswertung eines Teilausdrucks der Form next(Term, n) oder prev(Term, n) wird Term zum Zeitpunkt T+n bzw. T-n ausgewertet. Zur Auswertung eines Teilausdrucks der Form Term @ T' wird Term zum Zeitpunkt T' ausgewertet.

Zeitpunkte werden relativ zu einem beliebigen aber festen Zeitpunkt t, oder relativ zu davon abgeleiteten Zeitvariablen angegeben, die ihrerseits wieder relativ zu t deklariert werden. Damit soll ausgedrückt werden, dass eine Eigenschaft an jedem beliebigen Zeitpunkt eines gedachten unendlichen Simulationslaufs geprüft werden soll.

Zeitvariablen werden deklariert durch eine Liste von Ausdrücken

$T_1 = B_1 + n_1 .. m_1,$
$T_2 = B_2 + n_2 .. m_2,$
....;

Dabei bezeichnen die $B_i$ entweder t oder eine weiter oben in der Liste deklarierte Zeitvariable Tj und heißen Basiszeitvariable von $T_i$. Eine erlaubte Belegung der Zeitvariablen muß die oben angegebenen Bedingungen erfüllen, also muss $B_i + n_i <= T_i <= B_i + m_i$ gelten. Zeitvariablen werden meistens verwandt, um zu beschreiben, wie sich die betrachtete Schaltung mit ihrer Umgebung synchronisiert. Dabei werden häufig Signalflanken in den Annahmen durch Bedingungen in der Form

$$\text{during } [B_i + n_l, T_i - 1]: \qquad \text{signal} \mathrel{/=} \text{Wert};$$

$$\text{at} \qquad T_i: \qquad \text{signal} = \text{Wert};$$

genutzt, um eine Zeitvariable $T_i$ festzulegen. Diese Bedingungen wird Lokalisationsbedingungen genannt.

Logische Zeilen bilden Bedingungen wie folgt: Im einfachsten Fall ist eine Bedingung eine Logische Zeile. Die Abfolge zweier Bedingungen entspricht ihrer Konjunktion.
Disjunktion wird ausgedrückt durch

```
either
     <Bedingung 1>;
or  <Bedingung 2>;
or  ...
end either;
```

Es werden auch temporallogische Operatoren zwischen den Bedingungen verwendet, solange diese Bedingung nicht direkt mit einem Eigenschaftsprüfer zu beweisen ist.

Eine Eigenschaft hat die Form

```
theorem <name>;
for timevars: <Zeitvariablendeklaration>;
assume:
     <Bedingung 1>;
```

```
prove:
     <Bedingung 2>;
end theorem;
```

Die Bedingung 1 soll Annahme genannt werden, die Bedingung 2 Zusicherung. Die Eigenschaft ist erfüllt, wenn für jede erlaubte Belegung von t und allen Zeitvariablen, für die die Annahme erfüllt ist, auch die Zusicherung gilt. Umgekehrt ist ein Gegenbeispiel zur Eigenschaft ein Ablauf, bei dem zu irgendeiner erlaubten Belegung von t und den Zeitvariablen die Annahme, nicht aber die Zusicherung erfüllt ist.

Teilausdrücke bis hinauf zu Bedingungen lassen sich zusammenfassen in Makros, die erforderlichenfalls parametrisiert sein können.

Als Untersuchungsfenster wird hierin das kleinste Intervall [t-n, t+m] mit n, m >= 0 genannt, sodass bei jeder Belegung der Zeitvariablen jeder Zeitpunkt, an dem irgendein Signal ausgewertet wird, zwischen t-n und t+m liegt.

t_first und t_last sollen das Untersuchungsfenster beschreiben, das sich ergibt, wenn alle logischen Zeilen durch at t: true ersetzt werden, die ihrerseits t_first oder t_last referenzieren.

Gegeben seien zwei synchrone Digitalschaltungen mit einem Rücksetzeingang. Eine Ähnlichkeit wird angenommen, wenn beide Schaltungen nach einem gemeinsamen Rücksetzen auf dieselben Eingabemuster die selben Ausgabemuster produzieren.

Eine Menge von Eigenschaften wird als vollständig angesehen, wenn zwei beliebige Schaltungen, die jeweils alle Eigenschaften dieser Menge erfüllen, einander ähnlich sind.

Der Vollständigkeitsprüfer untersucht Eigenschaften eines bestimmten Typs, der Operationseigenschaften genannt wird. Zunächst wird die Theorie für Eigenschaften dargestellt, die in Bezug auf ihre Ausdrucksmächtigkeit stark beschränkt sind. Von dieser anschaulicheren Darstellung wird nachfolgend verallgemeinert.

Es wird von Eigenschaften der folgenden Grundform ausgegangen:

```
theorem grundform;

assume:

at   t:   Anfangszustand(<interne Signale>);


at   t:   Trigger₀(<Eingabesignale>);

at   t+1: Trigger₁(<Eingabesignale>);

at   t+2: Trigger₂(<Eingabesignale>);


prove:

at   t:   Ausgabebeschreibung₀(<Ausgangssignale>);

at   t+1: Ausgabebeschreibung₁(<Ausgangssignale>);

at   t+2: Ausgabebeschreibung₂(<Ausgangssignale>);

at   t+3: Ausgabebeschreibung₃(<Ausgangssignale>);

at   t+4: Ausgabebeschreibung₄(<Ausgangssignale>);

...

at   t+n: Ausgabebeschreibungₙ(<Ausgangssignale>);


at   t+n: Endzustand(<interne Signale>);

end theorem;
```

Anfangszustand, Trigger$_i$, Ausgabebeschreibung$_i$ und Endzustand sind dabei als Makros zu denken. Die Eigenschaft beschreibt im wesentlichen: "Wenn die Schaltung in einem gewissen Zustand ist, der durch das Makro Startzustand beschrieben wird, und wenn sie Eingabemuster sieht, die durch die Makros Trigger$_i$ beschrieben werden, dann liefert sie Ausgangsmuster entsprechend Ausgabebeschreibung$_i$ ab und begibt sich in den Endzustand".

Die Grundidee hinter diesen Eigenschaften ist aus Kettengliedern Ketten zu bilden. Die Kettenglieder verfügen über Enden, entsprechend jeweils dem Anfangs- und Endzustand einer Eigenschaft in der obigen Form. Entsprechend kann man unter gewissen Bedingungen Ketten aus Eigenschaften bilden. Ein Ziel der Erfindung ist es, durch lokale Untersuchung von jeweils wenigen Eigenschaften sicherzustellen, dass zu jedem möglichen unendlichen Eingabemuster durch Übereinanderlegen von zueinander passenden Start- und Endzuständen eine unendliche Kette von Eigenschaften gebildet werden kann, deren Trigger von dem Eingabemuster erfüllt wird, und deren Ausgabebeschreibungen das Ausgabemuster vollständig und eindeutig beschreiben.

Diese wird wie folgt formalisiert:

Ein logischer Ausdruck P wird als abhängig von einer Größe s bezeichnet, wenn es eine Belegung der übrigen syntaktisch in P vorkommenden Größen gibt, sodass durch unterschiedliche Wahl eines Wertes für s der Ausdruck P wahr oder falsch gemacht werden kann.

Gegeben sei eine Eigenschaftsfolge $P_0, P_1, P_2, \ldots P_n$ von Eigenschaften der Form $P_i$ = forall t: $a_i(t) => z_i(t)$, mit implikativ verknüpften Booleschen Ausdrücken $a_i(t)$ und $z_i(t)$, die von Werten der Eingabe-, Ausgabe- und internen Größen eines Automaten zu Zeitpunkten relativ von t abhängen, und eine Folge von Referenzzeitpunkten $T_1, T_2, \ldots, T_n$, die von t und von Werten der Eingabegrößen relativ zu t abhängen dürfen. Als dazu gehörig bezeichnen wir die Eigenschaft

$$\text{forall t: } (a_0(t) => z_0(t)) \text{ and}$$
$$((a_0(t) \text{ and } a_1(T_1(t))) => z_1(T_1(t))) \text{ and}$$
$$(a_0(t) \text{ and } a_1(T_1(t)) \text{ and } a_2(T_2(t))) => z_2(T_2(t))) \text{ and } \ldots$$

$$\text{Wir nennen die Folge } P_0, P_1, P_2, \ldots P_n \text{ mit Referenzzeitpunkten } T_1, T_2, \ldots T_n \text{ eine Kette, wenn}$$
$$\text{es } P'_0, P'_1, P'_2, \ldots P'_n \text{ der Form}$$

$$P'_i = \text{forall t: } a'_i(t) => z_i(t)$$

Wir nennen die Folge $P_0, P_1, P_2, \ldots P_n$ mit Referenzzeitpunkten $T_1, T_2, \ldots T_n$ eine Kette, wenn es $P'_0, P'_1, P'_2, \ldots P'_n$ der Form

$P'_i$ = forall t:$a'_i(t) => z_i(t)$

gibt, deren $a'_i$ nur von Werten auf Eingabegrößen zu Zeitpunkten relativ zu t abhängen, und deren zugehörige Eigenschaft äquivalent ist zur Eigenschaft, die zu der Ausgangsfolge gehört. In einer Kette hängt es nur von den Eingabesignalen ab, ob und an welcher Stelle das Verhalten der Ausgabe- und internen Signale durch die $z_i$ beschrieben wird. Mit dieser Forderung sind Folgen $P_0, P_1, P_2, \ldots P_n$ mit Referenzzeitpunkten $T_1, T_2, \ldots, T_n$, trivialerweise Ketten, wenn die $a_i$ nur von Eingabesignalen abhängen. Aber auch ein $a_i$, das von internen oder Ausgabesignalen abhängt, kann zu einer Kette gehören, wenn etwa $z_{i-1}$ genügend Information über diese Signale zur Verfügung stellt. Wie dies getestet werden kann, ist Teil der hier beschriebenen Erfindung.

Ein internes oder Ausgabesignal s ist bezüglich einer Kette $P_0, P_1, P_2, \ldots P_n$ mit Referenzzeitpunkten $T_1, T_2, \ldots T_n$ determiniert zu einem Zeitpunkt Z, der durch eine Funktion gegeben ist, die von t und Eingabesignalen abhängen darf, wenn sein Wert zum Zeitpunkt Z durch die Kette eindeutig bestimmt wird. Bei einer Kette ist damit sichergestellt, dass s zum Zeitpunkt $Z(t0)$ immer den selben Wert hat, wann immer ab einem gewissen t0 eine gewisse Folge von Eingabegrößen auftaucht, und diese Folge von Eingabegrößen nacheinander $a'_0(t_0), a'_1(T_1(t_0)), a'_2(T_2(t_0)), \ldots a'_n(T_n(t_0))$ erfüllt.

Wenn eine Kette ein Ausgabesignal zu einem Zeitpunkt determiniert, gibt es demnach eine Funktion, die nur von Eingabesignalen abhängt, die den Wert des Ausgabesignals zu diesem Zeitpunkt bestimmt. Ketten, die Ausgangsgrößen zu einigen Zeitpunkten determinieren, spezifizieren damit Ein-/Ausgabeverhalten unabhängig von einer individuellen Schaltung. Es ist Teil dieser Erfindung, wie untersucht werden kann, wann eine Kette das Verhalten auf Ausgabe- und internen Signalen determiniert.

Als zu einer unendlichen Folge $P_0$, $P_1$, $P_2$, ... von Eigenschaften (die durchaus aus einer endlichen Menge von Eigenschaften kommen können und dann mehrfach auftreten) und $T_1$, $T_2$, ... gehörend bezeichnen wir ein Folge $K_0$, $K_1$, $K_2$, ... von Eigenschaften, wobei $K_n$ die jeweils zu den $P_0$, $P_1$, .. $P_n$ gehörende Eigenschaft ist. Eine unendliche Folge $P_0$, $P_1$, $P_2$, ... mit entsprechenden Referenzzeitpunkten heißt (unendliche) Kette K, wenn jede endliche Teilfolge $P_0$, $P_1$, .. $P_n$ eine Kette $K_n$ ist. Eine unendliche Kette K determiniert ein Ausgabesignal s zu einem Zeitpunkt Z, wenn es einen Index k gibt, sodass alle $K_i$ mit i > k das Ausgabesignal zu dem Zeitpunkt Z determinieren.

Wenn aus einer Menge von Eigenschaften zu jedem möglichen Eingabestimulus eine unendliche Kette gebildet werden kann, die diesen Eingabestimulus abdeckt, und die alle Ausgabesignale zu allen Zeitpunkten mit Ausnahme eines Anfangsteilstücks determiniert, so ist diese Menge im obigen Sinn vollständig.

Die Bedingungen zur Prüfung auf Vollständigkeit sind für Eigenschaften der obigen Form "grundform":

1.) Existenz einer Reset-Eigenschaft. Diese Eigenschaft ist dadurch charakterisiert, dass ihr Anfangszustand trivial ist, also = true ist.

2.) Für jede Eigenschaft P der Eigenschaftsmenge muss eine Eigenschaftsmenge $N_P$ von Nachfolgern von P existieren, die folgende Bedingung erfüllt:

2a) Für jedes Q aus $N_P$ muss gelten $Endzustand_P$ => $Anfangszustand_Q$. (=> steht für Implikation) Damit ist es gerechtfertigt, dass Q in $N_P$ aufgenommen wurde.

2b) Bilden der Disjunktion über alle Trigger der Eigenschaften aus $N_P$, d.h. die Eigenschaft

```
theorem case_split_very_simple;
prove:
either
        at t:       Trigger₀ von Eigenschaft 1;
        at t+1:     Trigger₁ von Eigenschaft 1;
        at t+2:     Trigger₂ von Eigenschaft 1;
        ...
or
        at t:       Trigger₀ von Eigenschaft 2;
        at t+1:     Trigger₁ von Eigenschaft 2;
        ...
or
        ...
end either;
end theorem;
```

Wenn diese Eigenschaft bewiesen werden kann, ist es bekannt, dass immer eine Eigenschaft Q angegeben werden kann, mit der es weitergeht, wenn der Endzustand von P erreicht ist. Wenn diese Eigenschaft für die Nachfolgermenge jeder Eigenschaft bewiesen ist, erlangt man bereits Kenntnis um die Möglichkeit, für jedes Eingabemuster eine Kette zu bilden, die es überdeckt.

2c) Die Bedingung

```
at t: Ausgabebeschreibung0;
at t+1: Ausgabebesehreibung1;
```

. . .

werde mit Out(t) bezeichnet. Es werden zu jedem Ausgabesignal o ein Zeitpunkt $Z_{P_o}$ derart bestimmt, dass einen typkorrekte Konstante w existiert, sodass Out(t) => at $Z_{P_o}$ : o = w gilt.

Zu jedem Q aus $N_P$ wird eine Eigenschaft Q' gebildet, indem t durch t + $n_P$ ersetzt wird, sodass der Startzustand von Q' zu dem Zeitpunkt angenommen wird, an dem der Endzustand von P zugesichert wird. t+$n_p$ wird im Folgenden als Referenzzeitpunkt von P für Q bezeichnet. Outp(t) and $Out_Q$(t+$n_P$) ist die Ausgabebeschreibung für den Fall, dass P von Q gefolgt wird. Vorausgesetzt, dass es zu jedem Ausgabesignal o zu jedem Zeitpunkt T aus dem Intervall [$Zp_o$, $Z_{Q_o}$] einen typkorrekten Wert w gibt, sodass gilt $Out_P$(t) and $Out_Q$(t+$n_P$) => at T: o = w

Damit ist dann sichergestellt, dass die Ausgabewerte entlang der Kette eindeutig bestimmt sind, möglicherweise mit Ausnahme einiger Zeitpunkte, die von der Reseteigenschaft überstrichen werden.

Wenn die Eigenschaften unter Berücksichtigung von Umgebungsbedingungen entwickelt wurden, wird die Konsistenzeigenschaft case_split_very_simple nicht mehr bewiesen werden können. Als Gegenbeispiele werden dann Eingabemuster erzeugt, bei denen die Umgebungsbedingungen verletzt sind. Daher muß bei Umgebungsbedingungen statt der Eigenschaft case_split_very_simple die Eigenschaft

```
theorem case_split_simple;

assume:

Umgebungsbedingung;


prove:

either

        at t:        Trigger0 von Eigenschaft 1;


                at t+1:    Trigger1 von Eigenschaft 1;

                at t+2:    Trigger2 von Eigenschaft 1;

                ...

        or

                at t:        Trigger0 von Eigenschaft 2;

                at t+1:    Trigger1 von Eigenschaft 2;

                ...

        or

                ...

        end either;

        end theorem;
```

bewiesen werden.

Es wird der Begriff von Teileigenschaften eingeführt, mit denen phasenweise beschrieben wird, wie das betrachtete Modul mit Nachbarmodulen kommuniziert. Eine Teileigenschaft ist ein Anfangsstück einer längeren Eigenschaft. Wenn A und C die Annahme und Zusicherung der längeren Eigenschaft ist, und a und c die entsprechenden Teile der Teileigenschaft, so muss A => a und C => c gelten. Ferner muss die Teileigenschaft auf der untersuchten Schaltung gelten.

Zur Motivation und zur Illustration der Notwendigkeit von Teileigenschaften wird die folgende Eigenschaftsmenge betrachtet. Sie beschreibt ein Modul, das mit einem Nachbarmodul kommuniziert. Dieses Nachbarmodul soll in einer Umgebungsbedingung beschrieben werden. Dieses Nachbarmodul sichert zu dass es "10" oder "01" produziert, wann immer out_sig auf "001" gesetzt wird. Das wird in der Umgebungsbedingung E=(out_sig="001" => next(in_sig) ="10"ornext(in_sig)="01") beschrieben. Die nachfolgend angegebenen Eigenschaften $t_2$ und $t_3$ beschreiben auch tat-sächlich die Kommunikation mit dem Nachbarmodul: Ein Request führt zur Aussendung von "001". Das Nachbarmodul gibt in_sig = "10" oder "01" zurück und abhängig davon wird ein weiterer Wert auf out_sig produziert.

```
theorem t₁;
assume:
at    t:    state = idle;
at    t:    request = '0';
prove:
at    t+1: state = idle;
at    t+1: out_sig = "000";
end theorem;


    theorem t₂:
    at    t:    state = idle;
    at    t:    request = '1';
    at    t+3: in_sig = "10";
    prove:
    at    t+4: state = idle;
    at    t+1: out_sig = "000"
    at    t+2: out_sig = "001";
    at    t+3: out_sig = "000";
    at    t+4: out_sig = "101";
    end theorem;
```

```
theorem t₃:
at    t:    state = idle;
at    t:    request = '1';
at    t+3: in_sig = "01";
prove:
at    t+4: state = idle;
at    t+1: out_sig = "000";
at    t+2: out_sig = "001";
at    t+3: out_sig = "000";
at    t+4: out_sig = "110";
end theorem;
```

Diese Eigenschaften seien alle in einer Nachfolgermenge enthalten. Die Eigenschaft state_split_simple zu dieser Nachfolgermenge ist selbst unter der Umgebungsbedingung E nicht zu beweisen. Ein Gegenbeispiel zu state_ split_simple wird etwa zum Zeitpunkt t zeigen, dass state auf idle gesetzt wird und auch request aktiv ist, setzt aber in_ sig auf "11" zum Zeitpunkt t+3, sodass keine der Annahmen von $t_1$, $t_2$ oder $t_3$ erfüllt ist.

Dieses Problem entsteht, weil in die Untersuchung nicht einfließt, dass nach einem Request auf jeden Fall out_sig = "001" ist und daher zum Zeitpunkt t+3 nur ausgewählte Werte auf in_sig auftauchen dürfen. Die in $t_2$ und $t_3$ beschriebene Kommunikation hat also zwei Phasen: einerseits die Generierung von "001" und andererseits die Generierung von "101" bzw. "110". Die Untersuchung der Kommunikation wird daher phasenweise durchgeführt. Zunächst wird die Generierung von "001" beschrieben:

```
theorem partial:
at t: state = idle;
at t: request = '1';
prove:
at t+1: out_sig = "000";
at t+2: out_sig = "001";
end theorem;
```

Diese Eigenschaft entsteht, indem $t_2$ oder $t_3$ zum Zeitpunkt t+2 abgeschnitten werden. Eine solch abgeschnittene Eigenschaft muss im allgemeinen separat mit dem Eigenschaftsprüfer bewiesen werden.
Die Eigenschaft case_split_simple lässt sich mit den Annahmen von partial und $t_1$ beweisen.

Erst in der nächsten Phase wird die Eingabe in_sig ausgewertet. Für die Verifikation, dass partial durch $t_2$ oder $t_3$ fortgesetzt wird, wird die Eigenschaft

```
theorem partial_consistency;
assume:
at t: state = idle;
at t: request = '1';
at t+1: out_sig = "000";
at t+2: out_sig = "001";
Umgebungsbedingung;
prove:
either:
    at t: request = '1';
    at t+3: in_sig = "10";
or
    at t: request = '1';
```

```
    at t+3: in_sig = "01";
  end either;
  end theorem;
```

automatisch aufgebaut und bewiesen. Diese Eigenschaft wird so aufgebaut, dass Annahme und Zusicherung der Teileigenschaft in die Annahme der Konsistenzeigenschaft aufgenommen wird. Das ist möglich, weil die Eigenschaft partial separat bewiesen wurde. Dadurch wird aber auch die Umgebungsbedingung anwendbar, sodass in Folge die Eigenschaft tatsächlich bewiesen werden kann.

Teileigenschaften sind meist Anfangsstücke anderer Eigenschaften. Die längsten Eigenschaften, also diejenigen, die die volle Kommunikation beschreiben werden als Haupteigenschaften bezeichnet. Es wird gefordert, dass die Teileigenschaften so gebildet sind, dass es zu jeder Haupteigenschaft P eine endliche, eindeutig bestimmte Folge $Q_n$ von Teileigenschaften gibt, bei der $Q_n$ jeweils Teileigenschaft von $Q_{n+1}$ ist und P das letzte Element dieser Folge ist.

Wie oben exemplifiziert, kann eine Teileigenschaft Q einer Haupteigenschaft P auch Teileigenschaft einer anderen Haupteigenschaft P' sein. Dabei soll es auf Verschiebungen nicht ankommen: Unter der Annahme, dass der Zeitpunkt t in P' durch ein t + i mit einer ganzen Zahl i ersetzt wird, bevor geprüft wird, ob Q auch Teileigenschaft von P' ist. In diesem Fall muss gelten, dass Q in den Teileigenschaftenfolgen von P und P' auftaucht. Damit bilden die Teileigenschaften aller Haupteigenschaften einen Graph, der wie folgt charakterisiert ist:

- gerichtet und zyklenfrei

- zu jeder Teileigenschaft gibt es einen Pfad zu mindestens einer Haupteigenschaft

- Jede Haupt- oder Teileigenschaft hat höchstens einen Vorgänger in dem Graphen.

Solch einen Graph wird Teileigenschaftsgraph genannt.

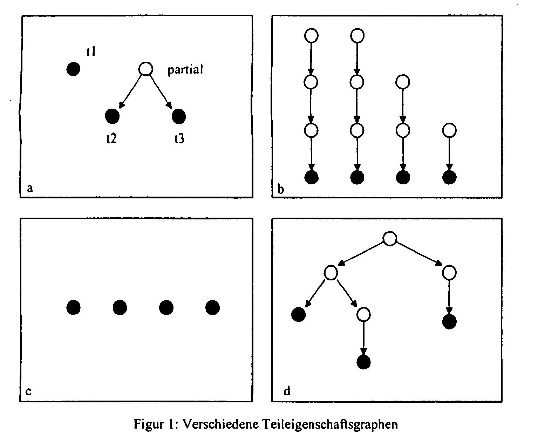

Fig. 1 zeigt verschiedene Teileigenschaftsgraphen, Fig. 1a) ist der Teileigenschaftsgraph des obigen Beispiels.

Der Vollständigkeitsprüfer erhält eine annotierte Eigenschaftsmenge (1) mit folgenden Informationen:

- Name, Modus (input, output, internal) und Typ jedes Signals, das in den Eigenschaften referenziert wird.

- Eine Eigenschaften $P_{reset}$ werde als Reseteigenschaft besonders herausgestellt.

- Eine Haupteigenschaftsmenge, die nachfolgend beschrieben wird. Die Elemente dieser Eigenschaftsmenge heißen Haupteigenschaften.

- Ein Graph von Teileigenschaften (Teileigenschaftsgraph), der nachfolgend beschrieben wird.

Jedes Element der Haupteigenschaftsmenge aus (1) stellt die folgenden Informationen zur Verfügung:

Zeitvariablenmenge TT, bestehen aus Zeitvariablen $T_i$:

$T_0$ entspreche t, für i > 0 ist jede Zeitvariable gekennzeichnet durch

- Basiszeitvariable $B_i$ für i > 0: $B_i$ entspricht einem $T_j$ mit j < i.

- Zeitbereich $[Z_i, z_i]$, sodass die Zeitvariablendeklaration $T_i = B_i + Z_i .. z_i$ ist.

- Lokalisationsbedingung der Form $L_i$ = during $[B_i + Z_i, T_i-1]$: not $l_i$; at $T_i$: $l_i$ mit einer geeignet gewählten Booleschen Bedingung $l_i$, die die Belegung der Zeitvariablen $T_i$ beschreibt.

Es wird vorausgesetzt, dass alle nachfolgend beschriebenen Eigenschaftsteile ausschließlich unter Verwendung der $T_i$ beschrieben werden. Die Variable t, die als Keyword in ITL vorhanden ist, darf nicht referenziert werden.

Die Bezeichnungen "Voraussetzung" und "Folgerung" wurden gewählt, um die Anteile dieser besonders annotierten Eigenschaften von den Annahmen und Zusicherungen zu unterscheiden, die in jeder ITL-Eigenschaft vorkommen können. Zum Beweis einer solchen annotierten Eigenschaft auf einer Schaltung wird die Voraussetzung zu einem Teil der Annahme und die Folgerung zu einem Teil der Zusicherung einer ITL-Eigenschaft.

Es wird eine Umgebungsbedingung E über das Verhalten der Eingabesignale im Anschluss an Stellen, an denen die Eigenschaft untersucht wurde angenommen. Teil der Umgebungsbedingung soll sein, dass der Reset nirgends aktiviert wird. Das Zusammenspiel zwischen Umgebung und betrachteter Schaltung muss also im allgemeinen der Eigenschaft

```
theorem environment_constraint;
for timepoints:
    T0 = t,
    T1 = B1 + Z1 .. z1,
    T2 = B2 + Z2 .. z2,
    ...;
assume:
    L1; L2; L3; ...
    A;
prove:
    E;
end theorem;
```

genügen. Häufig lässt sich E aber ohne zusätzliche Voraussetzungen beweisen.

Annahme eines Determiniertheitsbereich $[K_i, k_i]$ für jeden Output $o_i$: In diesem Zeitbereich soll die Eigenschaft das Verhalten der Ausgänge eindeutig beschreiben.

Annahme von Dateninterpretationsfunktionen $D_1, D_2, ...$ mit Auswertungszeitpunkten $p_1, p_2, ...$: Die Auswertungszeitpunkte liegen dabei jeweils typischerweise in der Nähe der Referenzzeitpunkte aus der Nachfolgermenge (s. u.). Mit der Angabe der Dateninterpretationsfunktion bezeichnet der Benutzer, welche im Zustand gespeicherten Daten für die Funktion der Schaltung so wichtig sind, dass sie an die nachfolgende Eigenschaft weitergereicht werden müssen. Durch die Folge der von den Dateninterpretationsfunktionen beschriebenen Werte entlang einer Eigenschaftskette soll sich ergeben, wie diese Daten aus Eingaben berechnet werden.

Nachfolgermenge NN von Eigenschaften $N_1, N_2, ...$ zusammen mit jeweils einem Referenzzeitpunkt $R_1, R_2, ....$ Jeder Referenzzeitpunkt muss größer sein als $T_0$. Ferner darf $P_{reset}$ nicht in einer Nachfolgermenge vorkommen.

Der Teileigenschaftsgraph entspreche der Charakterisierung in dem vorhergehenden Abschnitt. Eine Eigenschaft Q in diesem Graphen werde beschrieben durch eine Zeitvariablenmenge $TT_Q$, eine Annahme $A_Q$ und eine Zusicherungen $C_Q$. $TT_Q$ soll mit jeder Zeitvariable auch ihre Basiszeitvariable enthalten und Teilmenge einer Zeitvariablenmenge TT aus der Haupteigenschaftsmenge aus (1) sein. Gibt es eine Kante q -> Q in diesem Teileigenschaftsgraphen, so soll $TT_q$ eine Untermenge von $TT_Q$ sein, $A_Q => A_q$ und $C_Q => C_q$ gelten. Isolierte Knoten des Graphen können sowohl Quellen als auch als Senken dieses Graphen sein. An den Senken dieses Graphen sollen die Eigenschaften aus der Haupteigenschaftsmenge aus (1) stehen. Wenn es von einer Quelle Pfade zu zwei Haupteigenschaften gibt, können die nur gemeinsam oder gar nicht in einer Nachfolgermenge auftreten. Wenn sie in einer Nachfolgermenge auftreten, müssen die Referenzzeitpunkte R der beiden Eigenschaften gleich sein.

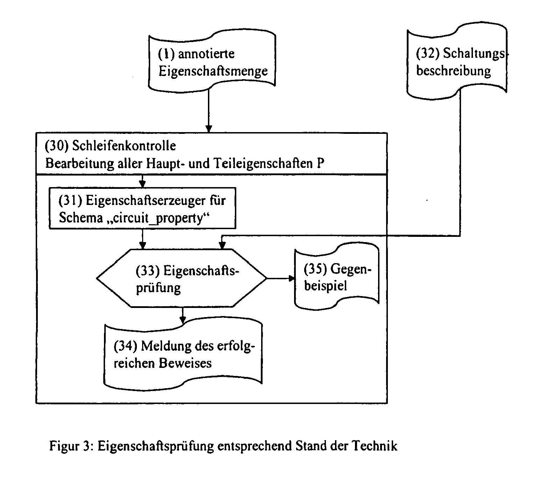

Die Verifikation der auf der Schaltung zu prüfenden Eigenschaften ist in Fig. 3 beschrieben. Die auf der Schaltung zu prüfenden Eigenschaften werden unter der Schleifenkontrolle (30) abgearbeitet, die sicherstellt, dass jede Haupt- oder Teileigenschaft P aus der annotierten Eigenschaftsmenge (1) überprüft wird. Aus P wird mit Hilfe des Eigenschaftserzeugers (31) eine zur Verwendung mit einem Eigenschaftsprüfer geeignete Eigenschaft nach dem folgenden Schema:

```
theorem circuit_property;
for timepoints:
    T_0 = t,
    T_1 = B_1 + Z_1 .. z_1,
    T_2 = B_2 + Z_2 .. z_2,
    ...;
assume:
    L_1; L_2; L_3; ...
    A;
prove:
    C;
end theorem;
```

Diese wird gegen die Schaltungsbeschreibung (32) (die etwa in VHDL RTL gegeben ist) durch die Anwendung (33) eines Eigenschaftsprüfers geprüft. Dadurch wird die Eigenschaft entweder bewiesen oder widerlegt. Das positive Beweisresultat (34) oder die Widerlegungssequenz (35) wird dem Benutzer übergeben. Die Vorgehensweise entsprechend Verifikation dieser Eigenschaften entspricht üblicher Praxis des Verifizierens mit Eigenschaftsprüfem. Es müssen sowohl die Haupt- als auch die Teileigenschaften verifiziert werden.

Die Schritte (30) bis (35) können vor oder nach den Schritten (2) bis (25) durchgeführt werden.

Die in der Schaltungseigenschaft nicht verwandten Elemente der annotierten Eigenschaftsmenge (1) werden zur Bildung von Konsistenzeigenschaften benötigt, die während der Vollständigkeitsprüfung vom Vollständigkeitsprüfer erzeugt und durch einen Eigenschaftsprüfer bewiesen werden. Dazu wird aus der annotierten Eigenschaftsmenge (1) durch den Modellerzeuger (2) ein triviales Modell (3) erzeugt. Dieses triviale Modell ist ein spezieller endlicher Automat, in dem alle in der annotierten Eigenschaftsmenge (1) aufgeführten Signale doppelt und unterscheidbar als Eingabesignale aufgeführt werden. Jeweils zusammengehörende Signale sollen nachfolgend mit s und s° angegeben werden. Damit enthält das triviale Modell (3) zwar die Typinformation, aber keine Auskunft über das Schaltungsverhalten selbst. Der Vollständigkeitsprüfer kennt damit nur dasjenige Signalverhalten, das durch die Haupt- und Teileigenschaften beschrieben ist.

Nachfolgend wird beschrieben, wie aus den Haupt- und Teileigenschaften Konsistenzeigenschaften erzeugt werden, die auf dem trivialen Modell (3) durch einen Eigenschaftsprüfer

bewiesen werden. Wenn das für alle erzeugten Konsistenzeigenschaften gelingt, ist die Vollständigkeit des Satzes der Haupteigenschaften bewiesen. Zum Aufbau der Konsistenzeigenschaften werden zunächst zu allen Haupt- und Teileigenschaften durch den Eigenschaftskopierer (4) Kopien in den unterschiedlichen Variablensätzen des trivialen Modells (3) erzeugt. Die zwei Kopien einer Eigenschaft werden mit P und P° bezeichnet und analog für alle Teile A, A°, C, C°, .. usf. Bei diesem Kopieren sollen auch die Zeitvariablensätze unterscheidbar gemacht werden, sodass Zeitvariablen $T°_0$, $T°_1$, .. entstehen. Die Informationen $B_i$, $p_i$, $N_i$ und $R_i$ werden durch den Kopiervorgang (4) nicht modifiziert.

Unter der Schleifenkontrolle (5) wird zu jeder Haupteigenschaft P und zu jeder Nachfolgeeigenschaft P' aus der Nachfolgermenge von P eine erste Konsistenzeigenschaft bestimmt. Dafür werden zunächst die Eigenschaften P' und P°' in (5') so kopiert, dass alles bis auf die Zeitvariablen übernommen wird, und die Zeitvariablen so ersetzt werden, dass sie von den Zeitvariablen in P und P° unterscheidbar werden. Diese "frischen" Zeitvariablen werden mit $T'_i$ und $T°'_i$ angegeben. In dem Generator für den ersten Test (6) wird aus den obigen Eigenschaften entsprechend des folgenden Schemas eine erste Konsistenzeigenschaft generiert.

```
theorem first_test
for timepoints:
    T₀ = t,
    T₁ = B₁ + Z₁ .. z₁,
    T₂ = B₂ + Z₂ .. z₂,
    ...
    T°₀ = T₀,
    T°₁ = T₁,
    ....
    T'₀ = R,
    T'₁ = B'₁ + Z'₁ .. z'₁,
    T'₂ = B'₂ + Z'₂ .. z'₂,
    ...
    T'°₀ = T'₀,
    T'°₁ = T'₁,
    ...;

assume:
    during [t_first, t_last]:     inputs = inputs°;
    L₁; L₂; ....
    A; C;
    L°₁; L°₂; ....
    A°; C°;
    at   p₀:        D₀ = D°₀;



    at   p₁:        D₁ = D°₁;
    ...
    during [K₀, k₀]:    O₀ = O°₀;
    during [K₁, k₁]:    O₁ = O°₁;
    ....
    L'₁; L'₂; ....
    A';
prove:
    L'°₁; L'°₂; ...
    A°';
end theorem;
```

Dabei ist R der Referenzzeitpunkt, der zusammen mit P' in der Nachfolgemenge von P angegeben wird.

Im Einzelnen wird die Eigenschaft wie folgt gebildet: In Zeile 4 bis 6 werden alle Zeitvariablendeklarationen aus P eingeführt. In Zeile 7 bis 9 werden die korrespondierenden Zeitvariablen aus P° mit ihren Partner gleichgesetzt. In Zeile 10 wird der Anfangszeitpunkt von P' auf den Referenzzeitpunkt aus P gesetzt und anschließend in Zeile 11 bis 13 die Zeitvariablen entsprechend ihrer Deklaration in P' eingeführt. Die dazu korrespondierenden Zeitvariablen aus P'° werden ihnen in Zeile 14 bis 16 gleich gesetzt. Die Zeile 19 deutet an, dass die in der annotierten Eigenschaftsmenge (1) als Eingabesignale klassifizierten Signale und ihre jeweiligen Kopien einander gleich gesetzt werden. In Zeile 20 und 22 werden alle Lokalisationsbedingungen aus P und P° angegeben, während in Zeile 21 und 23 die entsprechenden Annahmen und Beweisziele eingetragen werden. In Zeile 24 bis 26 wird die Gleichheit aller Dateninterpretationsfunktionen zu ihren jeweiligen Auswertungszeitpunkten angenommen. In Zeile 27 und 28 wird ferner die Gleichheit aller Ausgabewerte während des Zeitraums angenommen, in dem P bzw. P° für ihre Bestimmung zuständig sind. In Zeile 30 und 31 erfolgt die Annahme aller Lokalisationsbedingungen aus P' und die Voraussetzung aus P'. In Zeile 33 und 34 sollen alle Lokalisationsbedingungen und die Voraussetzung aus P'° stehen.

Die Gültigkeit der so erhaltenen Eigenschaft auf dem trivialen Modell (3) wird durch den Einsatz (7) eines Eigenschaftsprüfers nachgewiesen. Dieser liefert entweder einen Beweis oder eine Widerlegung (8), die dem Benutzer übergeben wird.

In dem Generator (9) für eine zweite Konsistenzeigenschaft wird eine weitere Eigenschaft entsprechend des folgenden Schemas angefertigt.

```
theorem second_test
for timepoints:
        T₀ = t,
        T₁ = B₁ + Z₁ .. z₁,
        T₂ = B₂ + Z₂ .. z₂,
        ...
        T°₀ = T₀,
        T°₁ = T₁,
        ....
        T'₀ = R,
        T'₁ = B'₁ + Z'₁ .. z'₁,
        T'₂ = B'₂ + Z'₂ .. z'₂,
        ...
        T'°₀ = T'₀,
        T'°₁ = T'₁,
        ...;

assume:
        during [t_first, t_last]:      inputs = inputs°;
        L₁; L₂; ....
        A; C;
        L°₁; L°₂; ...
        A°; C°;
        at   p₀:          D₀ = D°₀;
        at   p₁:          D₁ = D°₁;
        ...
        during [K₀, k₀]:    O₀ = O°₀;
        during [K₁, k₁]:    O₁ = O°₁;
        ....
        L'₁; L'₂; ....
        A'; C'
        L°'₁; L°'₂; ....
        A°'; C°';
prove:
        during [k₀+1, k'₀]: O'₀ = O'°₀;
        during [k₁+1, k'₁]: O'₁ = O'°₁;
        ...
        at   p'₀:          D'₀ = D'°₀;
        at   p'₁:          D'₁ = D'°₁;
        ...
end theorem;
```

Diese Eigenschaft ist bis Zeile 30 gleich der ersten Konsistenzeigenschaft. In Zeile 31 und 33 werden hier nun die Voraussetzungen und Folgerungen, sowie in Zeile 30 und 32 alle Lokalisationsbedingungen aus P' und P'° eingetragen. Bewiesen werden soll nun die Gleichheit der Werte auf allen Ausgabesignalen in Zeile 35 bis 37. Der Bereich, in dem diese Gleichheit gefordert ist, schließt sich unmittelbar an den Bereich an, in dem sie in den Zeilen 27 bis 29 angenommen wurde. Ferner wird die Gleichheit der Dateninterpretationsfunktionen an ihren Auswertungspunkten verlangt (Zeilen 38 bis 40).

Die Eigenschaft wird erneut durch den Einsatz (10) des Eigenschaftsprüfers bewiesen oder es wird eine Widerlegung (11) an den Benutzer übergeben. Nachdem die Schleifenkontrolle (4) alle Paare aufeinanderfolgender Eigenschaften P, P' entsprechend der Vorgabe in den Eigenschaften aus der Haupteigenschaftsmenge (1) bearbeitet hat, übergibt sie die Kontrolle an eine zweite Schleifenkontrolle (12), die alle Eigenschaften P aus der Eigenschaftsmenge (2) durchgeht und zu jedem P eine Eigenschaft des folgenden Schemas first_case_split aufbaut. Zur Beschreibung des Schemas wird die folgende Notation benutzt: Unter Betrachtung aller relevanten Einträge jeder Teil- oder Haupteigenschaft als durch die Zeitvariablen parametriert. Alle Quellen des Teileigenschaftsgraphen, also diejenigen Eigenschaften, zu denen es keine kürzere Teileigenschaften gibt werden abgearbeitet. Man beschränkt sich dabei auf die Quellen, von denen aus es einen Pfad durch den Teileigenschaftsgraphen gibt, der zu einer in der Nachfolgemenge von P gehörenden Haupteigenschaft N führt. Diese Quellen werden $P'_j$ genannt und bezeichnen ihre Teile mit $A'j$, $T'_{ji}$, $Z'_{ji}$, $z'_{ji}$, $L'_{ji}$ usf. $R_j$ sei der Referenzzeitpunkt, der in der Nachfolgermenge von P mit N verknüpft ist. Es wird gefordert, dass $R_j$ eindeutig bestimmt ist, auch wenn es zu $P'_j$ mehrere N gibt.

Zu jeder Quelle $P'_j$ werde eine Folge $Bel_{j1}$, $Bel_{j2}$, ... gebildet, wobei jedes Element der Folge die Form $Bel_{jn} = (T'_{j0} = R_j, T'_{j1} = R_j + u_{jn1}, T'_{j2} = R_j + u_{jn2},....)$ mit ganzen Zahlen $u_{jn1}$, $u_{jn2}$,... habe und die Folge $Bel_{jn}$ alle Möglichkeiten von Belegungen auslotet, die die Zeitvariablenmenge von $P'_j$ erlaubt. Mit $A'_j(Bel)$ wird eine Kopie von $A'_j$ beschrieben, wobei alle Zeitvariablen entsprechend der Belegung Bel belegt worden sind. In dem Eigenschaftsgenerator (13) soll eine Eigenschaft nach dem folgenden Schema gebildet werden:

```
           theorem first_case_split;

           for timevars:
                 T₀ = t,
                 T₁ = B₁ + Z₁ .. z₁,
                 T₂ = B₂ + Z₂ .. z₂,
                 ...;




        assume:
              E;
              L₁; L₂; ...
              A; C;
        prove:
              either
                    A'₁(Bel₁₁); L'₁₁(Bel₁₁); L'₁₂(Bel₁₁); ...
              or    A'₁(Bel₁₂); L'₁₁(Bel₁₂); L'₁₂(Bel₁₂); ...
              or    A'₁(Bel₁₃); L'₁₁(Bel₁₃); L'₁₂(Bel₁₃); ...
              or    ...
              or    A'₂(Bel₂₁); L'₂₁(Bel₂₁); L'₂₂(Bel₂₁); ...
              or    A'₂(Bel₂₂); L'₂₁(Bel₂₂); L'₂₂(Bel₂₂); ...
              or    ...
              or    A'₃(Bel₃₁); L'₃₁(Bel₃₁); L'₃₂(Bel₃₁); ...
              or    A'₃(Bel₃₂); L'₃₁(Bel₃₁); L'₃₂(Bel₃₁); ...
              or    ...
              or    A'ₙ(Belₙₘ); L'ₙ₁(Belₙₘ); L'ₙ₂(Belₙₘ); ...
              end either;
        end theorem;
```

In den Zeilen 4 bis 7, 11 und 12 finden sich die Zeitvariablendeklarationen, Lokalisationsbedingungen, Voraussetzungen und Folgerungen von P. Zeile 10 verlangt die Gültigkeit der zu P gehörenden Umgebungsbedingung E. Zeile 14 bis 26 zählt nun die Voraussetzungen und Lokalisationsbedingungen aller Quellen $P'_j$ mit Pfaden in die Nachfolgermenge von P auf und instantiiert alle möglichen Belegungen der jeweiligen Zeitvariablen aus dem jeweiligen $P'_j$. Durch die Anwendung des Eigenschaftsprüfers (14) wird diese Eigenschaft bewiesen oder eine Widerlegung (15) dem Benutzer übergeben.

Durch die Schleifenkontrolle (16) wird nun zu jeder Haupteigenschaft P jeder Knoten P' des Teileigenschaftsgraphen bearbeitet, der nicht selbst eine Senke in dem Graphen ist und für den es einen Pfad durch den Teileigenschaftsgraph gibt, der bei einer Eigenschaft N der Nachfolgermenge von P endet. $P''_j$ sei der Nachfolger von P' im Teileigenschaftsgraphen. Sei $Bel_{ji}$ wieder eine Aufzählung aller erlaubter Belegungen der Zeitvariablen von $P''_j$, beginnend mit $T'_0 = R$, dem zu N gehörenden Referenzzeitpunkt. Durch den Eigenschaftserzeuger (17) wird eine Eigenschaft mit dem folgenden Schema gebildet:

```
theorem second_case_split;

for timevars:
    T₀ = t,
    T₁ = B₁ + Z₁ .. z₁,




    T₂ = B₂ + Z₂ .. z₂,
    ...,
    T'₀ = R,
    T'₁ = B'₁ + Z'₁ .. z'₁,
    T'₂ = B'₂ + Z'₂ .. z'₂,
    ...;

assume:
    E;
    L₁; L₂; ...
    A; C;
    L'₁; L'₂; ...
    A'; C';

prove:
    either
            A"₁(Bel₁₁); L"₁₁(Bel₁₁); L"₁₂(Bel₁₁); ...
    or    A"₁(Bel₁₂); L"₁₁(Bel₁₂); L"₁₂(Bel₁₂); ...
    or    A"₁(Bel₁₃); L"₁₁(Bel₁₃); L"₁₂(Bel₁₃); ...
    or    ...
    or    A"₂(Bel₂₁); L"₂₁(Bel₂₁); L"₂₂(Bel₂₁); ...
    or    A"₂(Bel₂₂); L"₂₁(Bel₂₂); L"₂₂(Bel₂₂); ...
    or    ...
    or    A"₃(Bel₃₁); L"₃₁(Bel₃₁); L"₃₂(Bel₃₁); ...
    or    A"₃(Bel₃₂); L"₃₁(Bel₃₂); L"₃₂(Bel₃₂); ...
    or    ...
    or    A"ₙ(Belₙₘ); L"ₙ₁(Belₙₘ); L"ₙ₂(Belₙₘ); ...
    end either;
end theorem;
```

Diese Eigenschaft unterscheidet sich wie folgt von der Eigenschaft, die durch den Eigenschaftsgenerator (13) erzeugt wurde: Im Wesentlichen wird die Untersuchung auf diejenigen Eigenschaften P'' beschränkt, die eine Fortsetzung von P' im Sinne des Teileigenschaftsgraphen darstellen. Deswegen wurden die Zeitvariablen $T'_j$ in den Zeilen 8 bis 11 hinzugefügt und die Voraussetzungen, Folgerungen, und Lokalisationsbedingungen in den Zeilen 17 und 18.

Die Eigenschaft wird durch die Anwendung (18) des Eigenschaftsprüfers auf dem trivialen Modell (3) bewiesen oder es wird eine Widerlegung (19) erzeugt und dem Benutzer übergeben. Damit wird die Schleifenkontrolle (16) verlassen und noch zwei Konsistenzeigenschaften über $P_{reset}$ gebildet und bewiesen.

Durch den Eigenschaftsgenerator (20) wird die Reseteigenschaft $P_{reset}$ in eine Konsistenzeigenschaft überführt gemäß dem folgenden Muster:

```
theorem first_reset_test
for timepoints:
    T0 = t,
    T1 = B1 + Z1 .. z1,
    T2 = B2 + Z2 .. z2,
    ...
    T°0 = T0,
    T°1 = T1,
    ...;

assume:
    during [t_first, t_last]:    inputs = inputs°;
    L1; L2; ....
    A;
prove:
    L°1; L°2; ...
    A°;
end theorem;
```

Darin bezeichnen Zeilen 4 bis 6 die Zeitvariablen aus $P_{reset}$, die Zeilen 7 bis 9 Zeitvariablen aus $P°_{reset}$, die den zugehörigen Zeitvariablen aus $P_{reset}$ gleichgesetzt werden. Zeile 12 sorgt wieder für gleiche Eingaben in beiden Variablensätzen und in Zeile 13 und 14 wird die Gültigkeit von Lokalisationsbedingungen und der Voraussetzung aus $P_{reset}$ angenommen. Es wird unter diesen Annahmen bewiesen, dass die Lokalisationsbedingungen und die Voraussetzung auch auf dem kopierten Parametersatz gilt.

Dieses Theorem wird durch die Anwendung (21) des Eigenschaftsprüfers bewiesen oder seine Widerlegung (22) dem Benutzer übergeben. Im Eigenschaftsgenerator (23) wird zu $P_{reset}$ eine weitere Konsistenzeigenschaft entsprechend dem folgenden Schema gebildet:

```
theorem second_reset_test
for timepoints:
    T0 = t,
    T1 = B1 + Z1 .. z1,
    T2 = B2 + Z2 .. z2,
    ...
    T°0 = T0,
    T°1 = T1,
    ...;
```

```
assume:
      during [t_first, t_last]:     inputs = inputs°;
      L₁; L₂; ....
      A; C;
      L°₁; L°₂; ...
      A°; C°;
prove:
      during [K₁, k₁]:     O₁ = O°₁;
      during [K₂, k₂]:     O₂ = O°₂;
      ...;
      at   p₁:            D₁ = D°₁;
      at   p₂:            D₂ = D°₂;
      ...;
end theorem;
```

Bis Zeile 12 entspricht die Eigenschaft der Ausgabe des Eigenschaftsgenerators (20). In den Zeilen 13 bis 16 wird die Gültigkeit der Reseteigenschaft auf beiden Variablensätzen vorausgesetzt. In den Zeilen 18 bis 20 wird die Gleichheit der Ausgabesignale auf beiden Variablensätzen verlangt und in den Zeilen 21 bis 23 die Gleichheit der Dateninterpretationsfunktionen zu ihren Auswertungspunkten.

Die so erhaltene Eigenschaft wird durch die Anwendung (24) des Eigenschaftsprüfers bewiesen oder es wird dem Benutzer eine Widerlegung (25) übergeben.

Sollten alle Anwendungen (7, 10, 14, 18, 21, 24) des Eigenschaftsprüfers auf die jeweiligen Konsistenzeigenschaften einen Beweis erzielen, wird dem Benutzer die Erfolgsmeldung (26) übergeben.

**Beweis**

Es soll gezeigt werden, dass im Falle einer Erfolgsmeldung (26) durch die Eigenschaften aus der Haupteigenschaftsmenge aus (1) das Verhalten der Ausgabesignale eindeutig bestimmt ist, jedenfalls nach den in der Reseteigenschaft genannten Zeitpunkten $K_i$, und wenn die Umgebung der Schaltung den Umgebungsbedingungen entsprechend der Eigenschaft environment_constraint (s.o.) genügt, die sich für alle Haupteigenschaften ergeben.

Dazu wird angenommen, dass zwei Schaltungen S und S° vorliegen. S erfülle alle Haupt- und Teileigenschaften P und S° erfülle alle kopierten Haupt- und Teileigenschaften P°. Es soll gezeigt werden, dass S und S° einander ähnlich sind. Sei $In_0$, $In_1$,... eine Eingabefolge, bei der der Reset am Anfang entsprechend der Reseteigenschaft aktiviert wird und die die Umgebungsbedingungen E entsprechend der Eigenschaft environment_constraints erfüllt. Sei $In°_0$, $In°_1$, ... die Kopie der Eingabefolge in den Eingabesignalen von S°.

Die Beweisidee ist, dass eine Folge $P_i$ von Eigenschaften und eine Folge $s_i$ von Simulationszeitpunkten bestimmt werden können, von der der Nachweisen möglich ist,

- dass $s_i$ streng monoton wächst,
- dass $P_i$ anwendbar ist, wenn der "allgemeine aber feste Zeitpunkt t" durch $s_i$ instantiiert wird
- dass eine Folge $P°_i$ bestimmbar ist, bei der jedes $P°_i$ anwendbar ist, wenn t durch $s_i$ instantiiert wird
- und dass durch die Folgen $P_i$ und $P°_i$ gleiches Verhalten der Ausgabesignale erzwungen wird.

Dies wird durch vollständige Induktion nachgewiesen. Induktionsverankerung: Im Reset lässt sich auf $In_i$ die Reseteigenschaft anwenden. Wenn man dabei annimmt, dass dazu t = 0 gewählt wird, bleibt die Verallgemeinerung möglich.

Also gibt es eine Belegung der Zeitvariablen $T_i$ der Reseteigenschaft, sodass ihre Voraussetzung A und die Lokalisationsbedingungen $L_1$, $L_2$, ... usf. gelten. Demnach ist die Annahme der durch den Eigenschaftstransformator (16) erzeugten Eigenschaft "first_reset_test" bei dieser Zeitvariablenbelegung erfüllt. Da diese Eigenschaft ebenfalls bewiesen ist, gelten demnach auch alle korrespondierenden Lokalisationsbedingungen $L°_1$, $L°_2$, ... und die Voraussetzung A° der kopierten Reseteigenschaft. Damit ist die Annahme von $P°_{reset}$ erfüllt. Da $P°_{reset}$ selbst auf der Schaltung S° gilt, folgt daraus die Gültigkeit der Folgerung C°. Da A und $L_1$, $L_2$, ... gelten, folgt auch die Gültigkeit der Folgerung C. Mithin ist die Annahme der vom Eigenschaftsgenerator (23) erzeugten Eigenschaft "second_reset_test" anwendbar. Diese sichert die Gleichheit der Ausgangssignale in einem gewissen Zeitbereich zu. Ferner wird die Gleichheit der Dateninterpretationsfunktionen zum jeweiligen Auswertungszeitpunkt zugesichert.

**Induktionsschritt:** Es wird angenommen, dass die Anwendbarkeit der Eigenschaften $P_0$ ... $P_n$ auf die Eingabefolge gesichert ist, wobei t jeweils durch die Elemente der streng monoton wachsenden Folge $s_0$, $s_1$, ... $s_n$ zu instantiieren ist. Es wird ferner angenommen, dass die Anwendbarkeit der Eigenschaften $P°_0$ bis $P°_n$ auf die Eingabefolge gesichert ist. Ferner wird angenommen, dass bei der Anwendung von $P°_n$ auch t auf $s_n$ gesetzt werden kann und dass davon ausgehend die Zeitvariablenbelegungen Bel und Bel° in $P_n$ und $P°_n$ gleich gewählt werden können. Dies liefert die Gleichheit der Ausgabesignale $o_i$ und $o'_i$ bis zu dem Zeitpunkt, der sich aus $k_i$ unter der Belegung Bel ergibt.

Zur einfacheren Darstellung wird geschrieben: $P = P_n$ und $P° = P°_n$. Da P auf der Schaltung S gilt, gilt auch die Zusicherung C und demnach ist die Eigenschaft first_case_split anwendbar, die vom Eigenschaftsgenerator (13) für P erzeugt wurde. Demnach gibt es eine Teileigenschaft $P'_0$, die eine Quelle im Teileigenschaftsgraphen repräsentiert, und eine Belegung $Bel'_0$, unter der die Voraussetzung $A'_0$ und die Lokalisationsbedingungen $L'_{01}$, $L'_{02}$, ... auf der Eingabefolge In gelten. Da $P'_0$ auf S gilt, gilt auch $C'_0$. Damit ist die Eigenschaft second_case_split aus dem Eigenschaftstransformator (17) anwendbar, die uns die Existenz einer Teileigenschaft $P'_1$ zusichert, die länger ist als $P'_0$ und zu der eine Belegung $Bel'_1$ existiert, sodass $A'_1$ und $L'_{11}$, $L'_{12}$, ... auf der Eingabefolge In gelten. Diese Überlegung lässt sich wiederholt anwenden, bis eine Haupteigenschaft P' und eine Belegung Bel' der Zeitvariablen von P' gefunden ist, sodass A' und die Lokalisationsbedingungen $L'_1$, $L'_2$ von P' auf der Eingabefolge In gelten. Aus dem ersten Element von Bel' ergibt sich der Wert für $s_{n+1}$, der wegen einer Forderung über die Referenzzeitpunkte größer ist als $s_n$., sodass nun auch die Folge $s_0$, $s_1$,... $s_{n+1}$ als streng monoton wachsend erkannt ist.

Nach den Überlegungen im vorangegangenen Abschnitt ist auf In die Annahme der von dem Eigenschaftsgenerator (6) erzeugten Eigenschaft first_test für P und P' erfüllt. Demnach ist auch die Voraussetzung A'° und Lokalisationsbedingungen $L'°_i$ der kopierten P'° erfüllt, wenn die Zeitvariablen von P'° wie in Bel' gewählt werden. Damit sind Voraussetzung und Lokalisationsbedingungen von P' und P'° erfüllt. Da P' auf S und P'° auf S° gelten, ist damit die Gültigkeit von C' bzw. C'° unter der Belegung Bel' gezeigt. Damit ist die Annahme der von dem Eigenschaftsgenerator (9) für P und P' erzeugten Konsistenzeigenschaft second_test erfüllt. Die Gleichheit der Ausgangssignale $o_i$ und $o°_i$ bis zum Zeitpunkt $k'_i$ und die Gleichheit der Dateninterpretationsfunktionen $D'_i$ und $D'°_i$ an ihren Auswertungspunkten p'i kann somit festgestellt werden. Dies beweist den Induktionsschritt.

Es soll gezeigt werden, dass der Wert der Ausgabesignale zu jedem Zeitpunkt gleich ist: Sei o ein Ausgabesignal, P eine beliebige Eigenschaft und $k_P$ die zu o gehörige obere Schranke des Determiniertheitsbereichs von o in der Eigenschaft P. $k_P$ ist gegeben durch $T + v_P$, T eine beliebige Zeitvariable, $v_P$ ein von der Eigenschaft abhängender konstanter Offset. Durch die Einschränkungen über die Wahl der Zeitvariablen ist $T >= t$, und daher $k_P >= t+v_P$. Sei V das Minimum aller $v_P$ aus der Eigenschaftsmenge. Wegen der strengen Monotonie der Folge der $s_i$ ist $s_n > n$ und damit $k_P >= n + V$. Für einen beliebigen Zeitpunkt X ergibt sich demnach spätestens nach dem X-V ten Induktionsschritt, dass $o_i$ @ X = $o°_i$ @ X gilt.

Damit ist der Beweis erbracht.

Anwendungsbeispiel eines Interruptcontroller. Ein Interruptcontroller soll 8 Interrupteingänge bearbeiten, die von 0 bis 7 nummeriert seien. Sie sollen entsprechend der Nummerierung feste Prioritäten haben, wobei 7 die höchste ist. Interrupts dürfen als Pulse aufscheinen. Sie werden in dem Register pending_int zwischengespeichert. Mit dem Register mask können einzelne Interrupts abgeschaltet werden, falls ihr zugehöriges Bit auf 0 gesetzt wird.

Wenn ein Interrupt vorliegt, wird das Request-Signal int_req aktiviert. Dann wird auf die Quittung gewartet, die als Puls auf dem Signal int_ack codiert ist. Diese Quittung erscheine zwischen dem 2. und 11. Takt nach der steigenden Flanke von int_req. Einen Takt nach dem Eintreffen der Quittung gibt der Interruptcontroller über den Bus d_out aus, welcher Interrupt der höchstpriore unmaskierte ist. Gleichzeitig sperrt er diesen und alle niedrigerprioreren Interrupts.

Der Prozessor kann das Maskenregister über einen Buszugriff beschreiben. Er aktiviert dazu das Signal write_mask und stellt den gewünschten Wert auf dem Signal d_in zur Verfügung.

Die Bestimmung des höchstprioren unmaskierten Interrupts finde in der Funktion prioritize statt. Die Funktion reduce_mask modifiziere das Maskenregister wie verlangt. Die annotierte Eigenschaftsmenge (1) enthalte:

**Signale:**

| | | |
|---|---|---|
| input | reset: | bit; |
| input | int_ack: | bit; |
| input | write_mask: | bit; |
| input | int_in : | bit_vector(7 downto 0); |
| input | d_in: | bit_vector(7 downto 0); |
| state | state: | state_t; |
| state | pending_int: | bit_vector(7 downto 0); |
| state | mask: | bit_vector(7 downto 0); |

(fortgesetzt)

**Signale:**

| output | int_req: | bit; |
|--------|----------|------|
| output | d_out: | bit_vector(7 downto 0); |

Dabei ist der Typ state_t ein Aufzählungstyp, der den Wert idle und weitere Werte enthält, die als Zwischenschritte für die RTL-Implementierung erforderlich sind, aber in den Eigenschaften nicht referenziert werden.

**Reseteigenschaft:** Name ist "reset" und $T_{reset} = t+1$

**Makros zur Definition der Umgebungsbedingungen:**

```
e0 :=       reset = 0;
e1 :=       if int_req = '1' and prev(int_req) = '0' then
                   next(int_ack, 1)  = '1' or
                   next(int_ack, 2)  = '1' or
                   next(int_ack, 3)  = '1' or
                   next(int_ack, 4)  = '1' or
                   next(int_ack, 5)  = '1' or
                   next(int_ack, 6)  = '1' or
                   next(int_ack, 7)  = '1' or
                   next(int_ack, 8)  = '1' or
                   next(int_ack, 9)  = '1' or
                   next(int_ack, 10) = '1'
            end if;
```

$e_1$ sichert zu, dass der Prozessor nach spätestens 10 Takten den Interrupt durch die Aktivierung des Signals int_ack quittiert.

**Eigenschaftsmenge**

Eigenschaft reset:

Zeitvariablenmenge $TT_{reset}$ besteht nur aus der Zeitvariable $T_0$, zu der es keine Laufbereichsdeklaration und keine Lokalisationsinformation gibt.

Voraussetzung $A_{reset}$:

```
at T_0:                    reset = '1';
at T_0+1:                  reset = '0';
```

Folgerung $C_{reset}$:
```
during [T_0,  T_0+1]:    int_req = '0';
during [T_0,  T_0+1]:    d_out = 0;
at     T_0+1:            mask = "11111111";
at     T_0+1:            pending_int = 0;
at     T_0+1:            state = idle;
```

Umgebungsbedingung E:
during $[T_0+2, T_0+12]$:$e_0$ and $e_1$;

Determiniertheitsbereich
Für int_req:  $[K_{reset, int\_req}, k_{reset, int\_req}] = [T_0, T_0+1]$
Für d_out:  $[K_{reset, d\_out}, k_{reset, d\_out}] = [T_0, T_0+1]$

Dateninterpretationsfunktion und Auswertungszeitpunkt:
```
D_0 = pending_int,    p_0 = T_0+1,
D_1 = d_out,          p_1 = T_0+1,
```

Nachfolgermenge und Referenzzeitpunkt
```
N_0 = idle,           R_0 = T_0+1,
N_1 = wm,             R_1 = T_0+1
```
Die Eigenschaft int gehört nicht zur Nachfolgermenge, weil sie pending_int /= 0 voraussetzt, was die Folgerung hier verbietet.

Eigenschaft int über die Abarbeitung des Interruptprotokolls mit dem Prozessor:
Zeitvariablenmenge $TT_{int}$ besteht aus den Variablen $T_0$ und $T_1$ = t_ack mit der Deklaration

```
t_ack = T_0 + 2 .. 12;
```

und der Lokalisationsinformation

```
during [T_0+2,  t_ack-1]:    int_ack = '0';
at     t_ack:                int_ack = '1';
```

Voraussetzung $A_{int}$:
```
during [T_0,  t_ack+1]:    reset = '0';
at T_0:                    state = idle;
at T_0:                    write_mask = '0';
at T_0:                    (pending_int and mask) /= 0;
```

Folgerung $C_{int}$:
```
at t_ack+1:                state = idle;
during [T_0+1,  t_ack]:    mask = prev(mask);
at     t_ack+1:            mask = prev(reduce_mask(
                                   mask, pending_int));
```

```
during [T₀+1, t_ack]:        int_req = '1';
at    t_ack+1:               int_req = '0';
during [T₀+1, t_ack]:        pending_int = prev(
                                 pending_int or int_in);
at    t_ack+1:               pending_int prev(
                                 (pending_int or int_in)
                                 and not prioritize(
                                 pending_int, mask));
during [T₀+1, t_ack]:        d_out = 0;
at    t_ack+1:               d_out = prev(
                                 prioritize(pending_int,
                                 mask));
```

Umgebungsbedingung E:

    during $[T_0+2, T_0+12]$:$e_0$ and $e_1$;

Determiniertheitsbereich

    Für int_req:    $[K_{int, int\_req}, k_{int, int\_req}] = [T_0+1, t\_ack+1]$

    Für d_out:    $[K_{int, d\_out}, k_{int, d\_out}] = [T_0+1, T\_ack+1]$

Dateninterpretationsfunktion und Auswertungszeitpunkt:

```
D₀ = pending_int,    p₀ = t_ack+1,
D₁ = d_out,          p₁ = t_ack+1,
```

Nachfolgermenge und Referenzzeitpunkt

```
N₀ = int,    R₀ = t_ack+1,
N₁ = idle,   R₁ = t_ack+1,
N₂ = wm,     R₂ = t_ack+1
```

Eigenschaft idle darüber, dass keine Operation ausgeführt wird:

    Zeitvariablenmenge $TT_{idle}$ besteht nur aus der Variablen $T_0$

Voraussetzung $A_{idle}$:

```
during [T₀, T₀+1]:    reset = '0';
at T₀:                state = idle;
at T₀:                write_mask = '0';
at T₀:                (pending_int and mask) = 0;
```

Folgerung $C_{idle}$:

```
at T₀+1:    state = idle;
at T₀+1:    mask = prev(mask);
at T₀+1:    int_req = '0';
at T₀+1:    pending_int = prev(
                pending_int or int_in);
at T₀+1:    d_out = 0;
```

Umgebungsbedingung E:

    during $[T_0+2, T_0+12]$:$e_0$ and $e_1$;

Determiniertheitsbereich

Für int_req:    $[K_{idle,\ int\_req},\ k_{idle,\ int\_req}] = [T_0+1,\ T_0+1]$

Für d_out:     $[K_{idle,\ d\_out},\ k_{idle,\ d\_out}] = \quad [T_0+1,\ T_0+1]$

Dateninterpretationsfunktion und Auswertungszeitpunkt:

$D_0$ = pending_int,    $p_0 = T_0+1,$

$D_1$ = d_out,    $p_1 = T_0+1,$

Nachfolgermenge und Referenzzeitpunkt

$N_0$ = int,    $R_0 = T_0+1,$

$N_1$ = idle,    $R_1 = T_0+1,$

$N_2$ = wm,    $R_2 = T_0+1$

Eigenschaft wm über das Verändern des Maskenregisters mask:

Zeitvariablenmenge $TT_{wm}$ besteht nur aus der Variablen $T_0$

Voraussetzung $A_{wm}$:

during $[T_0,\ T_0+1]$ :    reset = '0';

at $T_0$:    state = idle;

at $T_0$:    write_mask = '1';

Folgerung$C_{wm}$:

at $T_0+1$:    int_req = '0';

at $T_0+1$:    mask = prev(d_in);

at $T_0+1$:    state = idle;

at $T_0+1$:    pending_int = prev(pending_int or int_in);

at $T_0+1$:    d_out = 0;

Umgebungsbedingung E:

during $[T_0+2, T_0+12]$:$e_0$ and $e_1$;

Determiniertheitsbereich

Für int_req:    $[K_{wm,\ int\_req},\ k_{wm,\ int\_req}] = \quad [T_0+1,\ T_0+1]$

Für d_out:     $[K_{wm,\ d\_out},\ k_{wm,\ d\_out}] = \quad [T_0+1,\ T_0+1]$

Dateninterpretationsfunktion und Auswertungszeitpunkt:

$D_0$ = pending_int,    $p_0 = T_0+1,$

$D_1$ = d_out,    $p_1 = T_0+1,$

Nachfolgermenge und Referenzzeitpunkt

$N_0$ = int,    $R_0 = T_0+1,$

$N_1$ = idle,    $R_1 = T_0+1,$

$N_2$ = wm,    $R_2 = T_0+1$

**Teileigenschaftsgraph**

Der Teileigenschaftsgraph enthält in diesem Fall zusätzlich nur die Teileigenschaft int_p mit einer Zeitvariablenmenge $TT_{int\_p}$, die nur $T_0$ enthält, einer Voraussetzung $A_{int\_p}$ mit folgender Definition:

```
A_int_p :=
during [T_0, T_0+1]:           reset = '0';
at T_0:                        state = idle;
at T_0:                        write_mask = '0';
at T_0:                        (pending_int and mask) /= 0;
```

und einer Folgerung $C_{int\_p}$ mit

```
C_int_p :=
at    T_0+1:                    int_req = '1';
```

Der Graph besteht aus den isolierten Knoten idle und wm und aus einer Kante zwischen den zusätzlichen Knoten int_p und int.

Im Anhang I sind die Eigenschaften in der Eigenschaftsbeschreibungssprache ITL aufgelistet. Die Makros a_reset, a_int, a_idle, a_wm, a_int_p bezeichnen die Voraussetzungen und ggfs. auch die Lokalisationsinformation für die Zeitvariable t_ack. c_reset, c_int, c_idle, c_wm und c_int_p bezeichnen die Zusicherungen.

Das triviale Modell (3) wird durch die Übersetzung der folgenden VHDL-Beschreibung in das Internformat eines Eigenschaftsprüfers erzeugt.

```
package p is
type state_t is (idle, busy1, busy2, busy3);
end p;
use work.p.all;
entity model is port (
    reset_1:       in bit;
    int_ack_1:     in bit;
    write_mask_1:  in bit;
     int_in_1:     in bit_vector(7 downto 0);
    d_in_1:        in bit_vector(7 downto 0);
     state_1:      in state_t;
    pending_int_1: in bit_vector(7 downto 0);
    mask_1:        in bit_vector(7 downto 0);
     int_req_1:    in bit;
    d_out_1:       in bit_vector(7 downto 0);
     reset_2:      in bit;
     int_ack_2:    in bit;
    write_mask_2:  in bit;
     int_in_2:     in bit_vector(7 downto 0);
    d_in_2:        in bit_vector(7 downto 0);
    state_2:       in state_t;
    pending_int_2: in bit_vector(7 downto 0);
    mask_2:        in bit_vector(7 downto 0);
    int_req_2:     in bit;
    d_out_2: i     n bit_vector(7 downto 0)
) ;
end model;
architecture a of model is
begin
end a;
```

Dies repräsentiert die Bearbeitung durch den Modellerzeuger (2).

Der Eigenschaftskopierer (4) erzeugt Kopien der Eigenschaften auf unterschiedlichen Parametersätzen. Das wird durch die Makrodefinitionen a_int_1, a_int_2, a_int_p_1, a_int_p_2, usf. im Anhang repräsentiert. Die Aktionen der Eigenschaftsgeneratoren werden durch die erzeugten Eigenschaften repräsentiert, die mit dem Eigenschaftsprüfer auf dem trivialen Modell geprüft werden können.

Die formale Verifikation von Eigenschaften über das Modell und die zugehörige Prüfung der Vollständigkeit lässt sich inkrementell durchführen. Eine Eigenschaft wird auf dem Modell bewiesen und anschließend wird vermittels der hier vorgestellten Verfahren nachgewiesen, dass sie mit den anderen Eigenschaften zusammenpasst.

Automatische Bestimmung aller redundanten Vorgaben:

Im folgenden wird eine Vorstufe zu dem erfindungsgemäßen Verfahrens beschrieben, bei dem nur die Eigenschaftsmenge und eine Signaldeklaration vorgegeben werden müssen. Es bestimmt alle daraus bestimmbaren Benutzervorgaben des Hauptverfahrens, sodass dem Hauptverfahren als zusätzliche Benutzervorgabe nur noch die Umgebungsannahmen vorgegeben werden müssen.

Dieser Darstellung ist auf Umgebungsannahmen beschränkt, die nicht von Ausgabe- oder internen Signalen abhängen.

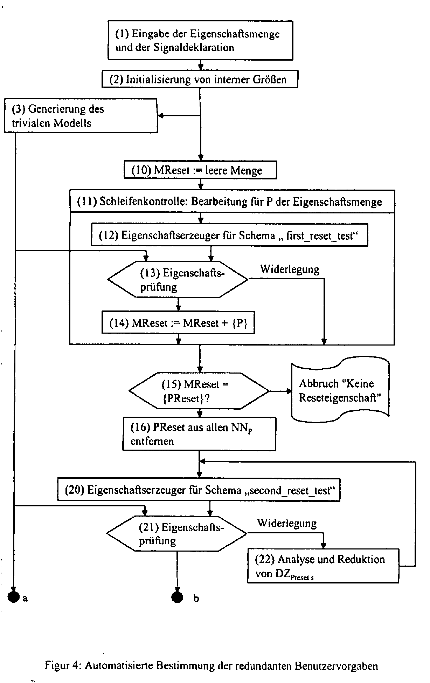

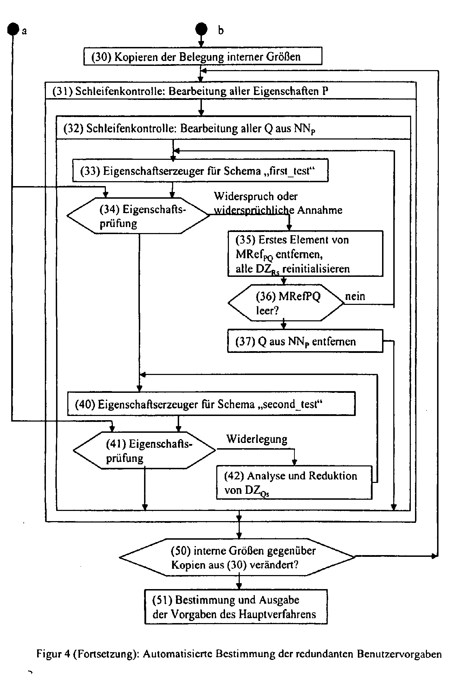

In Fig. 4 ist ein Ablaufdiagramm dieses Verfahrens gegeben. In Schritt 1 des Verfahrens werden die Eigenschaften und die Signale mit Typ und Modus (Eingabe-, Ausgabe-, internes Signal) eingelesen. In Schritt 3 wird aus der Signaldeklaration ein triviales Modell erzeugt.

Das Verfahren selbst arbeitet mit internen Größen, die nichts mit den internen Größen der untersuchten Schaltung zu tun haben. In Schritt 2 des Verfahrens werden die interne Größen des Verfahrens folgendermaßen vorbelegt: Für jede Eigenschaft P wird die Nachfolgermenge $NN_P$ mit der Menge aller Eigenschaften vorbesetzt. Für jedes Paar P, Q wird die Menge $MRef_{PQ}$ aller möglicher Referenzzeitpunkte mit einer Liste aller Zeitpunkte der Form T+u vorbesetzt, für die T eine Zeitvariable der Eigenschaft P ist und eine ganze Zahl u so gewählt ist, dass T+u für mindestens eine Belegung von T im Untersuchungsfenster von P liegt. Die Reihenfolge der Elemente in der Liste ist beliebig.

Für jedes Ausgabe- und interne Signal s wird die Menge der Zeitbereiche $DZ_{Ps}$, auf denen die Eindeutigkeit von s geprüft werden soll, wie folgt vorbesetzt: In einem ersten Vorbesetzungsschritt werden alle Zeitbereiche darin aufgenommen, an denen s in der Eigenschaft P entsprechend der folgenden Definition ausgewertet wird:

- Es werden alle logischen Zeilen der Eigenschaft (entsprechend der ITL-Beschreibung am Beginn des Dokuments) untersucht, unabhängig davon, wie sie untereinander verknüpft sind.

- In einem Ausdruck der Form during [a, b]: P wird P im Zeitbereich [a, b] ausgewertet

- In einem Ausdruck der Form within [a, b]: P wird P im Zeitbereich [a, b] ausgewertet

- In einem Ausdruck der Form at T: P wird P im Zeitbereich [T, T] ausgewertet.

- Um einen Ausdruck in einem Zeitbereich auszuwerten, werden seine Teilausdrücke in diesem Zeitbereich ausgewertet. Wenn einer dieser Teilausdrücke das Signal s ist, wird dieser Zeitbereich in $DZ_{Ps}$ aufgenommen.

- Um next(P,n) im Zeitbereich [a, b] auszuwerten, wird P im Zeitbereich [a+n, b+n] ausgewertet.

- Um prev(P,n) im Zeitbereich [a, b] auszuwerten, wird P im Zeitbereich [a-n, b-n] ausgewertet.

- Um P @ T in einem beliebigen Zeitbereich auszuwerten, wird P im Zeitbereich [T, T] ausgewertet.

Die Definition von "Auswertung an einem Zeitbereich" entspricht der Definition von "Auswertung an einem Zeitpunkt" aus der Einführung von ITL, trägt aber der Tatsache Rechnung, dass die Zeitbereiche durch unterschiedliche Wahl der Zeitvariablen in P unterschiedlich groß werden können.

In einem zweiten Vorbesetzungsschritt wird jeder Zeitbereich [a, b] untersucht, der durch den ersten Vorbesetzungsschritt in $DZ_{Ps}$ aufgenommen wurde. Wenn es darin Zeitpunkte der Form T+u, T eine Zeitvariable, u eine ganze Zahl gibt, die für alle möglichen Belegungen der Zeitvariablen von P in diesem Zeitbereich [a, b] enthalten sind, wird in $DZ_{Ps}$ zusätzlich noch der Zeitpunkt T+u, repräsentiert durch den Zeitbereich [T+u, T+u] aufgenommen.

In den Schritten 10 bis 15 wird die Initialsierungs- oder Reseteigenschaft identifiziert. Dazu wird in Prozessschritt 10 die Menge MReset als leere Menge vorbesetzt, in der sich nachher die Reseteigenschaft befinden soll. In der Schleife 11 werden alle Eigenschaften P durchlaufen und mit dem Eigenschaftserzeuger 12 für das Eigenschaftsschma "first_reset_test" in eine Konsistenzeigenschaft überführt. Diese wird in Schritt 13 auf dem trivialen Modell durch den Eigenschaftsprüfer überprüft. Im Falle eines Beweises wird in Schritt 14 die Eigenschaft P zu MReset hinzugefügt, andernfalls wird sie nicht hinzugefügt. Damit wird die Schleife 11 beendet. In Schritt 15 wird geprüft, dass die MReset nur ein Element enthält, dass also die Reseteigenschaft $P_{Reset}$ eindeutig bestimmt ist. Wenn nicht, bricht das Verfahren ab. In Schritt 16 wird die Reseteigenschaft aus allen Nachfolgermengen $NN_P$ entfernt.

In den Schritten 20 bis 22 wird die Menge der Determiniertheitszeitbereiche der Reseteigenschaft bestimmt. Dazu wird im Eigenschaftserzeuger 20 eine Konsistenzeigenschaft ähnlich second_reset_test aufgestellt. Abweichend von diesem Schema werden die Zeilen 18 bis 23 durch

during [a, b]: s=s°

gebildet, wobei s jedes Ausgabe- und interne Signal ist, und [a,b] jeder Zeitbereich aus $DZ_{PReset\ s}$.

Diese Eigenschaft wird der Eigenschaftsprüfizng 21 auf dem trivialen Modell unterworfen. Im Falle eines Gegenbeispiels wird im Gegenbeispielsanalysator 22 festgestellt, welche Teilbedingungen der Zusicherung der Konsistenzeigenschaft verletzt sind, und die entsprechenden Zeitbereiche aus $DZ_{PReset\ s}$ entfernt. Anschließend wird der Eigenschaftserzeuger 20 erneut gestartet. Diese Schleife wird beendet, wenn die Eigenschansprüfung 21 einen Beweis findet.

In Schritt 30 werden Kopien der aktuellen Belegung der internen Größen des Verfahrens angefertigt. In der von der Schleifenkontrolle 31 verwalteten Schleife werden alle Eigenschaften P durchlaufen. Zu P werden in der von der Schleifenkontrolle 32 verwalteten Schleife alle Eigenschaften Q aus der Nachfolgermenge $NN_P$ durchlaufen. Zu P und Q werden im Eigenschaftserzeuger 33 Konsistenzeigenschaften nach Schema "first_test" erzeugt. Dabei wird als Referenzzeitpunkt der erste Wert in $MRef_{PQ}$ gewählt. Außerdem werden die Zeilen 24 bis 29 in der oben für den Eigenschaftserzeuger 20 beschriebenen Weise durch Aussagen über alle Ausgabe- und internen Signalen zu den in Zeitbereichen in den Mengen $DZ_{Ps}$ ersetzt. Bei der Eigenschaftsprüfung 34 auf dem trivialen Modell kann sich die Annahme als in sich widersprüchlich ergeben oder die Eigenschaft widerlegt werden oder die Eigenschaft bewiesen werden. Bei widersprüchlicher Annahme oder widerlegter Konsistenzeigenschaft wird in Schritt 35 das erste Element von $MRef_{PQ}$ entfernt und alle $DZ_{Rs}$ für alle Eigenschaften mit ihrem Initialwert besetzt. In Schritt 36 wird geprüft, ob $MRef_{PQ}$ dadurch leer wurde. In diesem Fall wird in Schritt 36 die Eigenschaft Q aus $NN_P$ entfernt und mit dem entsprechend der Schleifenverwaltung 32 nächsten Prozessschritt weitergemacht. Wenn in Schritt 36 festgestellt wurde, dass $MRef_{PQ}$ noch nicht leer ist, wird mit Prozessschritt 33 auf der Basis der veränderten Größen weitergemacht.

Wenn bei der Eigenschaftsprüfung 33 die Konsistenzeigenschaft bewiesen wird, wird vom Eigenschaftserzeuger 40 eine Eigenschaft entsprechend "second_test" erzeugt. Wiederum werden die Zeilen 24 bis 29 dieses Eigenschaftsschemas durch Bedingungen über die Zeitbereiche von $DZ_{Ps}$ und die Zeilen 35 bis 40 durch Bedingungen über die Zeitbereiche der $DZ_{Qs}$ ersetzt. Bei der Eigenschaftsprüfung 41 auf dem trivialen Modell kann sich entweder ein Gegenbeispiel ergeben oder die Konsistenzeigenschaft wird bewiesen. Wenn sich ein Gegenbeispiel ergibt, werden im Gegenbeispielsanalysator 42 die verletzenden Zeilen identifiziert und die entsprechenden Zeitbereiche aus $DZ_{Qs}$ entfernt. Danach wird mit Prozessschritt 40 auf der Basis der veränderten Größen weitergemacht.

Wenn die Konsistenzeigenschaft in Schritt 41 bewiesen wird, wird mit dem entsprechend der Schleifenverwaltung 32 nächsten Prozessschritt weitergemacht. Wenn die Schleife 32 und 31 beendet sind, wird in Prozessschritt 50 festgestellt, ob die aktuellen und die im Prozessschritt 30 gespeicherten Kopien der internen Größen des Prozesses gleich geblieben sind. Wenn sie ungleich sind, wird mit Prozessschritt 30 auf der Basis der neuen Belegung der internen Größen weitergemacht.

Wenn sie gleich geblieben sind, ist sichergestellt, dass die durch die $NN_P$ und die Referenzzeitpunkte in den ersten Elemente der $MRef_{PQ}$ beschriebenen Eigenschaftsfolgen Ketten sind. Ferner bestimmen die $DZ_{Qs}$, zu welchen Zeiten die Ausgabesignale in diesen Ketten determiniert sind. Die Eingaben zu dem Hauptverfahren werden nun wie folgt in Schritt 51 bestimmt und ausgegeben:

- Die Eigenschaftsmenge (mit Zeitvariablenbeschreibung und Umgebungsannahmen) ist die in an das Verfahren übergebene.

- Die Signaldeklaration ist die an das Verfahren übergebene.

- Die $NN_P$ beschreiben die Nachfolgermenge einer Eigenschaft P.

- Die ersten Elemente der Listen $MRef_{PQ}$ bilden die Referenzzeitpunkte.

- Die Reseteigenschaft $P_{Reset}$ ist die vom Verfahren bestimmte.

- Zu einer Eigenschaft P und einem internen Signal s werden alle Zeitpunkte in der Form T+u, T eine Zeitvariable, u eine ganze Zahl bestimmt, die für alle Belegungen der Zeitvariablen von P in der Vereinigungsmenge der Zeitbereiche in $MRef_{Ps}$ liegen. Diese Zeitpunkte bilden die Auswertungszeitpunkte p der Dateninterpretationsfunktion D = s.

- Zu einer Eigenschaft P und einem Ausgabesignal o wird ein größtes Intervall [T+u, T' + u'] (T, T' eine Zeitvariable aus P, u, u' eine ganze Zahl) bestimmt, das für alle Zeitvariablenbelegungen eine Untermenge der Vereinigung der Zeitbereiche in $DZ_{Po}$ bildet. Dieses Intervall wird als Determiniertheitsintervall [K, k] des Signals o bezüglich der Eigenschaft P übergeben.

- Die Eigenschaften bilden einen trivialen Teileigenschaftsgraphen, der keine Kanten hat. Das ist möglich, weil vorausgesetzt wurde, dass die Umgebungsbedingungen unabhängig sind von Ausgabe- und internen Signalen.

Damit sind alle redundanten Informationen bestimmt, die die Verfahren zur Vollständigkeitsprüfung und zur Bestimmung der Vollständigkeitsmaßzahl benötigen.

Die Forderung $o_i = o°_i$ für die Determiniertheit der Ausgabesignale kann abgeschwächt werden. Das ist insbesondere nützlich, wenn Ausgangssignale nur dann ausgewertet werden dürfen, wenn sie etwa durch ein Validierungssignal als gültig bezeichnet werden. Dafür wird im annotierten Eigenschaftssatz eine für alle Eigenschaften einheitliche Menge von Determiniertheitsbedingungen $Det_1$, $Det_2$, ... definiert, die auf der Basis aller Signale s und s° beider Signalmengen beschrieben werden. Die zu jeder Haupteigenschaft anzugebenden Determiniertheitszeiträume werden dann nicht mehr für jedes Ausgabesignal, sondern für jede Determiniertheitsbedingung angegeben.

Mittels geringfügiger Anpassung des Verfahrens kann sichergestellt werden, dass die Modelleigenschaften die Gültigkeit einer Booleschen Formel (die mit prev und next auch Signalwerte an anderen Zeitpunkten auswerten darf) zu jedem Zeitpunkt beweist.

Zu diesem Zweck werden die Determiniertheitsbedingungen $o_i = o°_i$ ergänzt durch Forderungen der Form cond ='1', wobei cond die fragliche Boolesche Formel ist. Begründung: Es ist aus dem Beweis des erfundenen Verfahrens offensichtlich, dass eine Bedingung der Form cond = '1' and cond° = '1' beweist, dass cond determiniert und immer '1' ist. Im Falle eines Gegenbeispiels ist also entweder cond ='0'. Dieses Gegenbeispiel würde also auch der Forderung cond = '1' widersprechen. Falls cond° = '0' gibt es eine Belegung der kopierten Variablen, die dieses Gegenbeispiel verursacht. Diese Belegung kann aber auf die unkopierten Variablen übertragen werden, wodurch sich cond = '0' ergibt.

In den Zeilen 21 und 23 des Eigenschaftsschemas first_test und second_test, der Zeile 12 im Eigenschaftsschema first_case_split und den Zeilen 16 und 18 des Eigenschaftsschema second_case_split ist vorgesehen, dass Voraussetzung und Folgerung einer Vorgängereigenschaft P vollständig in die Annahme der jeweiligen Konsistenzeigenschaft aufgenommen wird. In vielen Fällen wird es aber ausreichen, nur Teile a, a°, c und c° der Annahmen A, A°, C und C° der Eigenschaften P und P° zu übernehmen, die so gebildet sind, dass A => a, A° => a°, C => c und C° => c° gilt. Die Zeitvariablenmengen tt bzw. tt°, auf der diese Teile definiert sind, kann dann kleiner sein als die ursprünglichen Zeitvariablenmengen TT bzw. TT°. tt muss so gebildet sein, dass es ein ausgezeichnetes Element $t_0$ aus TT gibt, und dass mit jeder Zeitvariable ungleich $t_0$, die in a, c, bei der Definition der rechten Grenzen $k_i$ der Determiniertheitsintervalle oder bei der Festlegung der Auswertungszeitpunkte $p_i$ der Dateninterpretationsfunktionen $D_i$ verwendet wird, auch jede zugehörige Basiszeitvariable enthält. tt° soll alle Kopien der Zeitvariablen von tt enthalten. Die Deklarationen für die Zeitvariablen $T_i$ und $T°_i$ in den Eigenschaftsschemata können dann auf die Elemente von tt und tt° reduziert werden, sowie auch die Listen der Lokalisationsinformationen $L_i$. Davon abweichend wird $t_0 = t$ deklariert. Der Zeitbereich, in dem die Gleichheit $o_i = o°_i$ der Ausgangssignale angenommen wird, kann ebenfalls reduziert werden, oder diese Annahmen werden komplett gestrichen. Alle beschriebenen Reduktionen verringern die Laufzeiten der Beweise der Konsistenzeigenschaften.

Beispiele für die Bildung von a aus A und c aus C (und in Folge davon auch a° und c°) sind:

- a = true und c eine Benutzervorgabe. Die Benutzervorgabe kann etwa den Endzustand beschreiben, wie er in dem einfachen einleitenden Beispiel verwandt wurde. In diesem Fall können für verschiedene Eigenschaften gleiche Konsistenzeigenschaften entstehen und müssen dann auch nur einmal untersucht werden.

Syntaktische Analyse: Zu jedem Paar P, P' wird die Schnittmenge der Signale gebildet, die einerseits in A oder C und andererseits in A' vorkommen. a und c wird dann aus A und C gebildet, indem alle logischen Zeilen gestrichen werden, in denen keines der Signale aus der Schnittmenge vorkommt. tt wird dann entsprechend den oben genannten Bedingungen gewählt.

Zweites Ausführungsbeispiel:

Das erfindungsgemäße Verfahren der vorangehend beschriebenen bevorzugten Ausführungsform ist nicht auf die explizite Angabe beschränkt, welche Eigenschaften mit welchen Referenzzeitpunkten aufeinanderfolgen. Die Grundidee der Verkettung von Eigenschaften wird auch im nachfolgenden Verfahren aufgegriffen. Allerdings werden in diesem Verfahren Konsistenzeigenschaften aufgebaut, bei deren Beweis diese Ketten implizit gebildet werden, ohne dass dabei z.B. Referenzzeitpunkte bestimmt werden.

Wesentlicher Teil dieser Konsistenzeigenschaften sind Implikationen, in die die Haupt- und Teileigenschaften überführt werden. Zu einer Eigenschaft P mit der Voraussetzung A, der Zusicherung C, den Lokalisationsbedingungen Li und der Umgebungsannahme E wird die Implikation

P' (t, Bel) = (A and $L_1$ and $L_2$ and ... ) implies (C and E) ;

gebildet. P' ist mit dem Zeitpunkt t und der Belegung Bel der Zeitvariablen instantiiert. Zu Eigenschaften $P_1$, $P_2$, $P_3$, ... hierzu wird gebildet:

```
assume_props(t_anf, t_end) =
      forall tt in [t_anf, t_end]:
          P'₁(tt, Bel₁₁) and P'₁(tt, Bel₁₂) and ... and
          P'₂(tt, Bel₂₁) and P'₂(tt, Bel₂₂) and ... and
          ...;
```

Der Zeitraum t_anfund t_end werde hinreichend groß gewählt. assume_props werde auch in den kopierten Variablensatz übertragen, dies ergebe die Bedingung assume_props°(t_anf, t_end).

Sei assume_props und assume_props° in der Annahme einer Konsistenzeigenschaft gegeben. t_anf und t_end sollen einen hinreichend großen Zeitraum überdecken. Zu einem geeigneten Anfang (d.h. einer Bedingung über den Wert interner Signale) und einer beliebigen Folge von Eingabesignalen wird der Beweiser eine Instanz der Implikationen auswählen, deren linke Seite von dem Anfang und der Eingabefolge erfüllt wird. Die rechte Seite stellt dann Information über Ausgaben und interne Signale zur Verfügung, die wiederum eine linke Seite einer Implikation erfüllen können, wodurch weitere Informationen zur Verfügung gestellt werden usf.

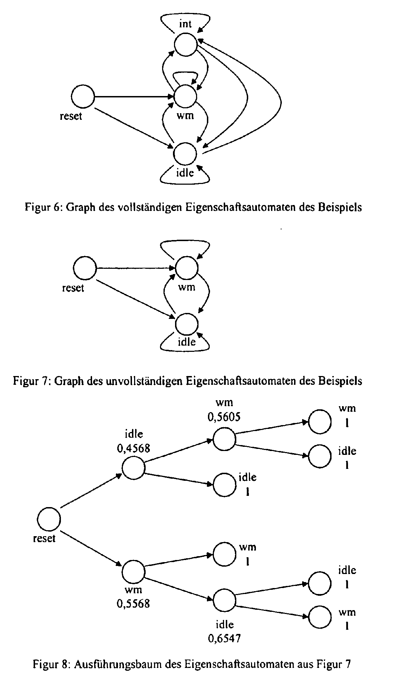

Dies ist die Grundlage des folgenden Verfahrens: Im Eigenschaftsgraph, der exemplarisch in Fig. 6 dargestellt ist werden einige Knoten als Start- und/oder als Endknoten markiert. Die Markierung soll so gewählt werden, dass die folgenden Bedingungen erfüllt sind:

- alle Pfade, die in einem Startknoten beginnen, enthalten einen Endknoten.

- auf jedem Pfad von einem Startknoten zu einem Endknoten, der keinen weiteren Endknoten enthält, darf jede Eigenschaft nur genau einmal vorkommen. Es ist aber erlaubt, dass Start- und Endknoten die selbe Eigenschaft bezeichnen.

Zu jedem Startknoten P wird entsprechend der Annahme in dem Eigenschaftsschema first_test die Bedingung definiert als:

```
det_cond_P(t, Bel):=
      L₁; L₂; ....
      A; C;
      L°₁; L°₂; ....
      A°; C°;
      at    p₀:        D₀ = D°₀;
      at    p₁:        D₁ = D°₁;
      ...
      during [K₀, k₀]:      O₀ = O°₀;
      during [K₁, k₁]:      O₁ = O°₁;
```

Die Bedingung ist in der für first_case_split beschriebenen Weise durch die Belegung Bel der Zeitvariablen parametrisiert. Ferner wird der Zeitpunkt t der Modelleigenschaft hervorgehoben, um ihn geeignet instantiieren zu können. Die Startbedingung wird gebildet durch

```
det_cond_start(t)  :=
either
      det_cond_P1(t, Bel₁₁) or det_cond_P1(t, Bel₁₂) or ... or
      det_cond_P2(t, Bel₂₁) or det_cond_P2(t, Bel₂₁) or ... or
      ...
end either;
```

Dabei durchlaufen die P1, P2, .., alle Startknoten. Die Endbedingung wird gebildet durch

```
det_cond_end(t) :=
either
      det_cond_Q1(t, Bel_11) or det_cond_Q1(t, Bel_12) or ... or
      det_cond_Q2(t, Bel_21) or det_cond_Q2(t, Bel_21) or ... or
      ...
end either;
```

Dabei durchlaufen die Q1, Q2, ... alle Eigenschaften, die als Endknoten markiert wurden.

assume_props wird in der oben beschriebenen Form aus den folgenden Eigenschaften gebildet:

• alle Endknoten

• alle Knoten zwischen einem Start- und einem Endknoten, aber nicht die Startknoten

• alle Teileigenschaften, die im Teileigenschaftsgraph auf einem Pfad zu den oben Eigenschaften führen, die den oben beschriebenen Knoten zugeordnet sind.

Die Konsistenzeigenschaften sind dann:

```
property reach_det_cond is
assume:
      during [t, t+w+m]: input_equality;
      assume_props(t, t+w);
```

```
            assume_props°(t, t+w);
            det_cond_start(t);
            environment_constraints;
        prove:
            exists t_end in [t+1, t+w]: det_cond_end(t_end);
        end property;


        property check_det_out is
        for timepoints:
            t_dc = t+1..wsize;
        assume:
            during [t, t+w]: input_equality;
            assume_props(t, t+w);
            assume_props°(t, t+w);

            det_cond_start(t);
            environment_constraints;
            forall t_v in [t+1, t_dc-1]: not det_cond_end(t_v);
            det_cond_end(t_dc);
        prove:
            during det_interval₁(t_dc): outsig₁ = outsig°₁;
            during det_interval₂(t_dc): outsig₂ = outsig°₂;
            during det_interval₃(t_dc): outsig₃ = outsig°₃;
            ...
        end property;
```

Dabei muss die Variable w groß genug gewählt werden, um auch den zeitlich längsten Pfad durch den Eigenschaftsgraph zu überdecken, und m soll so gewählt werden, dass es die größte Untersuchungsfensterlänge der Eigenschaften, aus denen assume_props gebildet wurde, überdeckt. environment_constraints beschreiben die Umgebungsannahmen, die den Eigenschaften zugeordnet sind, die in det_cond_start vorkommen.

Nach dem Beweis beider Konsistenzeigenschaften ist sichergestellt, dass die Eigenschaften in dem durch die Start- und Endpunkte definierten Teilgraphen des Eigenschaftsgraphen jede Eingabefolge so überdecken können, dass die Werte der Ausgangssignale auf den jeweiligen Intervallen det_interval, eindeutig bestimmt sind.

Wenn bei der Zerlegung des Eigenschaftsgraphen die Menge der Start- und Endknoten gleich ist und die Intervalle det_interval geeignet gewählt wurden, reichen diese beiden Eigenschaften aus, um die Vollständigkeit des entsprechenden Eigenschaftssatzes mit Ausnahme des Verhaltens in der Nähe des Resets zu beweisen. Die Vollständigkeit ergibt sich dann aus Induktion: Zunächst ist det_cond_start(t) = det_cond_end(t). reach_det_cond zeigt, dass nach endlicher Zeit wieder det_cond_start erreicht werden kann und check_det_cond zeigt, dass die Ausgaben in der Zwischenzeit eindeutig bestimmt sind.

Ähnlich kann argumentiert werden, wenn der Eigenschaftsgraph in mehrere Teilgraphen zerlegt wird, sodass alle Endpunkte eines Teilgraphen auch Startpunkte dieses oder eines anderen Teilgraphen sind und umgekehrt jeder Start- auch ein Endpunkt ist.

Dieses Verfahren stellt eine Erweiterung des Vorangehend beschriebenen Verfahrens da, weil es mit ihm die wesentliche Grundidee gemeinsam hat, nämlich die Bildung von Eigenschaftsketten und die Untersuchung, dass entlang dieser Ketten die Werte der Ausgabesignale eindeutig bestimmt sind.


**Drittes Ausführungsbeispiel**

Die Erfindung ist nicht beschränkt auf Eigenschaften, die durch formale Verifikation bearbeitet wurden. Vielmehr können die Eigenschaften statt mit dem Verfahren nach Fig. 3 auch per Simulation überprüft werden, beispielsweise indem sie in Monitore transformiert werden (Assertion based verification). Wenn eine Verletzung der Eigenschaft erkannt wird, meldet sich der Monitor durch die Aktivierung eines Fehlersignals oder durch eine Laufzeitausgabe.

Das hier beschriebene Ausführungsbeispiel überwacht, dass eine Menge von Eigenschaften in der Lage ist, jeden Fehler im Ausgabemuster einer Simulation auch wirklich zu erkennen. Sie ist damit das erste bekannte Hilfsmittel zur automatischen Qualitätssicherung der Fehlererkennungsmaßnahmen bei der Simulation.

**Viertes Ausführungsbeispiel**

Im Verfahren des vierten Ausführungsbeispieles soll die Qualität einer Menge von Meßbedingungen für die Feststellung von Vielfalt und Verschiedenartigkeit von Eingabemustern für die Simulation bestimmt werden. Somit kann sichergestellt werden, dass eine Menge von "Funktionalen Coveragepunkten" in jeden Teil der Schaltung hineinleuchtet.

Bis Dato wurden Bedingungen formuliert, deren Erfüllung während einer Simulation gezählt wird. Diese Zahlen werden genutzt, um die Vielfalt und Verschiedenartigkeit von Eingabemustern einer Simulation zu bewerten (Coverage). Die Aussagekraft dieser Bewertungsverfahren hängt von der Wahl der Bedingungen ab. Es gibt zwei Klassen von Bedingungen: Die eine Klasse erkennt die Ausführung von Teilen der Schaltungsbeschreibung (strukturelle Coverage), die andere erkennt bestimmtes Verhalten auf Signalen der Schaltung. Die Bedingungen der ersten Klasse lassen sich automatisch und damit sehr effizient bestimmen. Eine wichtige Klasse derartiger Bewertungsverfahren ergibt sich aus Bedingungen, die sich am Code der Schaltgungsbeschreibung orientieren. Solche Bedingungen sind beispielsweise dann erfüllt, wenn eine Zeile in der Schaltungsbeschreibung ausgeführt wird. Diese Bedingungen werden automatisch für jede Zeile aufgestellt, und die anschließende Qualitätsbewertung bestimmt das Verhältnis zwischen den Zeilen, die mindestens einmal ausgeführt wurden und allen Zeilen. Dieses Verfahren stellt sicher, dass jeder Schaltungsteil mindestens einmal überprüft wurde. Dieses Qualitätsmaß berücksichtigt aber verschiedene funktionale Effekte nicht, z. B. die inhärente Parallelität von Schaltungsbeschreibungen. Wenn die Verifikationsingenieure Bedarf sehen, fügen sie daher von Hand temporallogische Bedingungen ein, die bei derartig problematischen Abläufen erfüllt sind. Die Vorgabe solcher Bedingungen ist aufwändig und bleibt daher als kritisch erkannten Teilen der Schaltungsfunktionalität vorbehalten.

Die Annahmen aus einer vollständigen Eigenschaftsmenge kombinieren beide Vorteile: Sie kodieren funktionale Aspekte und prüfen jeden Teil der Schaltung. Insofern erlaubt die Erfindung auch die Bereitstellung eines besonders kritischen Satzes derartiger Bedingungen. Dabei sind die Zusicherungen über Ausgabesignale ohne Bedeutung, sodass die Eigenschaften entsprechend des Schemas "second_test" nicht erzeugt und geprüft werden brauchen.

Wenn eine annotierte Eigenschaftsmenge als nicht vollständig erkannt wurde, besteht die Möglichkeit, eine Maßzahl zu erzeugen, die mit dein noch zu leistenden Aufwand in Relation steht, und damit bei der Planung und Überwachung eines Verifikationsprozesses eine ähnliche Rolle spielen kann, wie die (Coverage-) Maßzahlen für Vielfalt und Verschiedenartigkeit der Eingabemuster im Kontext der Simulation.

Im Gegensatz zum Simulationskontext, wo diese Maßzahlen durchaus falsche Sicherheit suggerieren können, liefert das nachfolgend beschriebene Verfahren nur dann den Wert 1, wenn die Eigenschaftsmenge vollständig ist. Darüber hinaus ist die Maßzahl, die für eine Obermenge B einer Eigenschaftsmenge A bestimmt wird, immer größer oder gleich der Maßzahl für A.

Bei der folgenden Darstellung werden ITL-Bedingungen als Boolesche Ausdrücke über Variablen betrachtet, die den Wert eines Signales an einem Zeitpunkt betrachten. Die Variablen selber sind nicht zeitbehaftet, vielmehr ergeben sich mehrere Variablen, wenn ein Signal an verschiedenen Zeitpunkten ausgewertet wird. Eigentlich sind die Variablen Paare (<signal>, n). Ihre Belegung mit einem Wert legt den Wert des Signals zum Zeitpunkt t+n fest. Daher gilt für diese Variablen auch <signal>@ t+n, wobei t der beliebige aber feste Zeitpunkt aus ITL ist, zu dem relativ alle Zeitangaben gemacht werden.

Sei B eine Bedingung, in der außer t keine Zeitvariablen vorkommen. Dann sei der Träger sup(B) die Menge aller Variablen s@t+n, sodass s ein Signal ist, das in der Bedingung B zum Zeitpunkt t+n referenziert wird. Wenn B auch Zeitvariablen enthält, wird sup(B) als sup(B(Bel$_1$) or B(Bel$_2$) or B(Bel$_3$) ...) definiert, wobei die Bel$_i$ alle erlaubten Werte der Zeitvariablen ausloten. sup(B) ist eine endliche Variablenmenge, die irgendwie linear geordnet werde, etwa durch lexikographische Ordnung. Damit bilden die Elemente dieser Variablenmenge ein endliches Tupel. Die Definitionsmenge def(V) einer Variablenmenge sei die Menge aller Wertetupel, die vom Typ her korrekt das Variablentupel aus V belegen können. Statt def(sup(B)) kann man auch schreiben def(B).

Beispiel: Für einen 2-elementigen Bitvektor sig$_1$ und ein bitwertiges Signal sig$_2$ entspricht die ITL-Bedingung B =
at t: sig$_1$ = "00";
during [t, t+1 ] : sig$_2$ ='1';
der Booleschen Bedingung
sig$_1$ @ t = "00" and sig$_2$ @ t ='1'and sig$_2$ @ t+1 ='1',
hat den Support sup(B) = (sig$_1$ @ t), (sig$_2$ @ t), (sig$_2$ @ t + 1)) und die Definitionsmenge def(sup(B)) = {("00", '0', '0'), ("00", '0', '1'), ("00", '1', '0'), ("00", '1', '1'), ("01 ", '0', '0'), ... ("10", '0', '0'),... ("11", '1', '11')};

Sei B eine Bedingung, deren Träger eine Teilmenge einer Variablenmenge V ist. Dann soll die Kardinalität card(B, V) von B auf V die Anzahl der Elemente aus def(V), die B erfüllen, wenn man die Variablen in B entsprechend belegt. card(B, V) lässt sich automatisch bestimmen, etwa indem der BDD zu B aufgebaut wird und dann die einschlägigen Algorithmen dafür eingesetzt werden. Statt card(B, sup(A)) kann man schreiben card(B, A).

Für eine beliebige Menge M bezeichne card(M) die Anzahl der Elemente in M.

Die Grundidee des Verfahrens des vierten Ausführungsbeispieles besteht darin, die Eigenschaften und ihre Nachfolgermenge als Transitionen in einem Automaten zu betrachten, der Eigenschaftsautomat genannt wird. Der Eigenschaftsautomat zum ersten Ausführungsbeispiel ist in Fig. 6 wiedergegeben.

Der Eigenschaftsautomat einer unvollständigen Eigenschaftsmenge wird nicht zu jedem Eingabemuster eindeutig ein Ausgabemuster produzieren. Die Grundidee des Verfahrens besteht darin, über den Anteil der Eingabemuster Rechenschaft abzulegen, zu dem die Ausgaben bestimmt werden können.

Ein Beispiel für einen Eigenschaftsautomat einer unvollständigen Eigenschaftsmenge ist in Fig. 7 angegeben. Es ist der Eigenschaftsautomat zu der in Fig. 6 beschriebenen Schaltung, jedoch ohne die Eigenschaft int. Dies könnte etwa einem Zwischenstand bei der Verifikation der Beispielsschaltung entsprechen.

In einem wichtigen Schritt des Verfahrens wird der Eigenschaftsautomat abgewickelt. Dadurch entsteht ein Baum, der mit $P_{reset}$ beginnt. Jedem Knoten ist eine Eigenschaft zugeordnet und seinen Söhnen sind genau die Eigenschaften aus der Nachfolgemenge zugeordnet. Die Äste des Baumes werden abgeschnitten, sobald einem Knoten eine Eigenschaft zugeordnet wird, die auf dem Pfad zwischen $P_{reset}$ und diesem Knoten bereits auftritt. Der Knoten mit der erneut auftretenden Eigenschaft heißt dann voller Endknoten im Gegensatz zu leeren Endknoten, deren Eigenschaft eine leere Nachfolgemenge hat. Solch ein Baum wird Ausführungsbaum des Eigenschaftssatzes genannt. Fig. 8 gibt ein Beispiel eines Ausführungsbaums zu dem unvollständigen Eigenschaftsautomat aus Fig. 7.

Für jeden Pfad von $P_{reset}$ zu einem vollen oder leeren Endknoten wird bestimmt, welcher Anteil aller möglichen Stimuli von ihm überdeckt wird, wie hoch also die Wahrscheinlichkeit dafür ist, dass ein Stimulus überdeckt wird. Dieser Wert wird verkleinert, wenn der Pfad zu einem leeren Endknoten führt oder wenn die Ausgaben entlang des Pfades ungenau beschrieben sind. Die Summe dieser so angepassten Werte ergibt die Vollständigkeitsmaßzahl.

Sie ist nur 1, wenn die Eigenschaftsmenge im Sinne dieser Anmeldung vollständig ist. Andernfalls ist sie kleiner als 1 und wächst mit jeder Eigenschaft, die den Eigenschaftsautomaten vergrößert.

Das Verfahren zur Bestimmung der Vollständigkeitsmaßzahl ist ein besonders bevorzugtes Verfahren nach der vorliegenden Erfindung. Die Eigenschaften, die nach dem Schema first_test gebildet werden, überprüfen die Korrektheit der Nachfolgermengen. Durch wiederholte Anwendung von Eigenschaften, die nach dem Schema second_test gebildet werden, und sukzessive Reduktion der Zusicherungen über die Ausgabedeterminiertheit kann für ein Eigenschaftspaar P, P' festgestellt werden, wie vollständig die Ausgangsbeschreibung durch P' ist. Ferner wird festgestellt, welchen Anteil an Eingabemustern eine Voraussetzung in der Disjunktion nach first_case_split und second_case_split überdeckt.

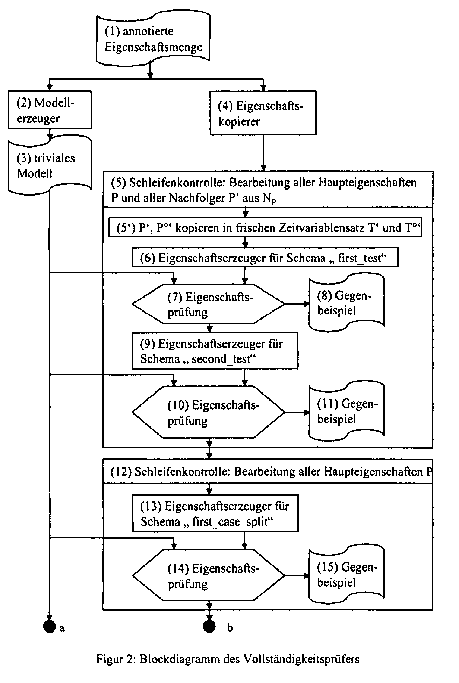

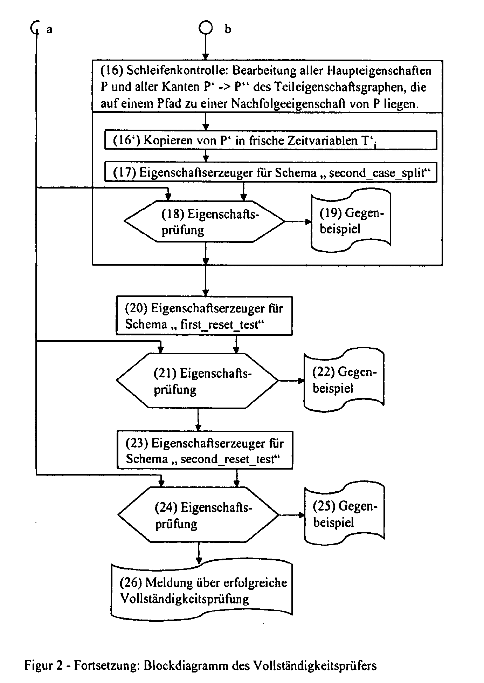

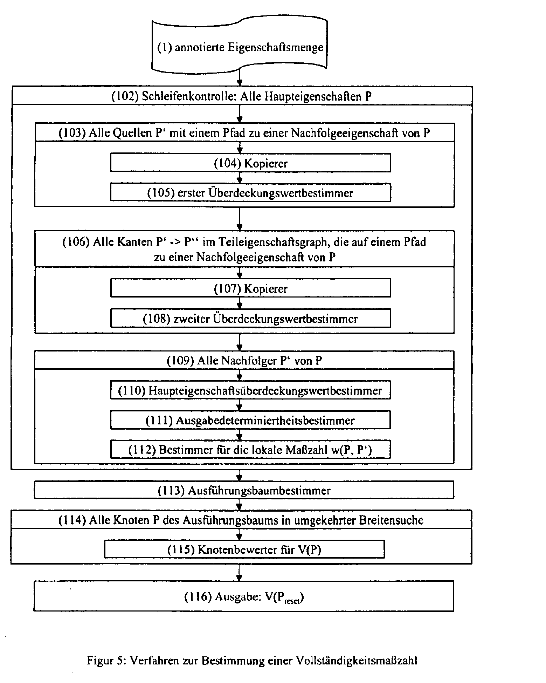

Fig. 5 gibt einen Überblick über das Verfahren des vierten Ausführungsbeispieles an. Ausgangspunkt ist die annotierte Eigenschaftsmenge (1), bei der alle Eigenschaften und ihre Nachfolgermengen die Konsistenzeigenschaften erfüllen, die durch die Schritte (5) bis (7) der Fig. 2 aus dem Eigenschaftsschema first_test erzeugt wurden, bzw. durch die Schritte (5a) bis (7a) der automatisierten Bestimmung der Nachfolgermenge und ihrer Referenzzeitpunkte entsprechend Fig. 4.

Für die folgende Darstellung soll angenommen werden, dass die Annahmen der Haupt- und Teileigenschaften so gewählt sind, dass sich die einzelnen Zeilen

$A'_i(Bel_{ij}); L'_{il}(Bel_{ij}); L'_{i2}(Bel_{ij}); ...$

in den Eigenschaften entsprechend des Schemas first_case_split gegenseitig ausschließen. D.h. die Konjunktion je zweier solcher Zeilen soll unter der durch das Schema gegebenen Annahme leer sein. Ferner sollen sich auch die einzelnen Zeilen

$A''_i(Bel_{ij}); L''_{il}(Bel_{ij}); L''_{i2}(Bel_{ij}); ...$

in den Eigenschaften nach Schema second_case_split gegenseitig ausschließen. Wenn das nicht der Fall sein sollte, muss zwischen den beteiligten Eigenschaften eine Priorität festgelegt werden, etwa durch Numerierung $P_1, P_2, ...$ der Eigenschaften. Die Voraussetzung der ursprünglichen Eigenschaft $P_n$ muss dann ersetzt werden durch

$A_n$ and

not($A_1(Bel_{11})$ and $L_{11}(Bel_{11})$ and $L_{12}(Bel_{11})$ and ...) and

not($A_1(Bel_{12})$ and $L_{11}(Bel_{12})$ and $L_{12}(Bel_{12})$ and ...) and

... and

not($A_2(Bel_{21})$ and $L_{21}(Bel_{21})$ and $L_{22}(Bel_{21})$ and ...) and

not($A_2(Bel_{22})$ and $L_{21}(Bel_{22})$ and $L_{22}(Bel_{22})$ and ...) and

... and

not ($A_{n-1}(Bel_{n-1,1})$ and $L_{n-1,1}(Bel_{n-1,1})$ and $L_{n-1,2}(Bel_{n-1,1})$ and ...) and

not ($A_{n-1}(Bel_{n-1,2})$ and $L_{n-1,2}(Bel_{n-1,2})$ and $L_{n-2,2}(Bel_{n-1,2})$ and ...) and

...

In der Schleifenkontrolle (102) der Fig. 5 werden alle Haupteigenschaften P durchlaufen. In der Schleifenkontrolle (103) werden zu P alle Quellen P' des Teileigenschaftsgraphen durchlaufen, von denen aus Pfade zu einer Nachfolgereigenschaft von P bestehen.

In dem Kopierer (104) werden die Zeitvariablen von P' von denen in P wie im ersten Teil der Erfindung unterscheidbar gemacht und im Folgenden mit $T'_i$ bezeichnet. Gleichzeitig wird $T'_0 = R$ gesetzt und in P die Zeitvariable $T_0$ durch t ersetzt. Im ersten Überdeckungswertbestimmer (105) wird der Abfolge von P und P' dann ein Überdeckungswert w(P, P') wie folgt zugeordnet:

Sei

$G = A$ and $C$ and $E$ and $L_1$ and $L_2$ and ... die Annahme entsprechend des Schemas first_case_split. Sei

$H = G$ and $A'$ and $L'_1$ and $L'_2$ and...

die Bedingung dafür, dass die Eigenschaft P' mit ihren Anteilen $A'$, $C'$, $L'_1$, $L'_2$ in einer Eigenschaft entsprechend first_case_split zum Zuge kommt. Es wird der Überdeckungswert für die Abfolge von P und P' bestimmt als

w(P, P') = card (H, H) / card (G, H)

Damit ist die Schleife (103) über die Quellen P' beendet.

Die Schleifenkontrolle (106) durchlaufe nun jede Kante P' -> P'' im Teileigenschaftsgraphen, die auf einem Pfad zu einer Nachfolgeeigenschaft von P liegt.

Im Kopierer (107) werden die Zeitvariablen $T'_i$ von P' und $T''_i$ von P'' einerseits von denen in P unterscheidbar gemacht, und ferner wird $T_0 = t$, $T'_0 = R$ und $T'_i = T''_i$ für alle Zeitvariablen von P' gesetzt.

Analog zu obiger Darstellung wird in dem zweiten Überdeckungswertbestimmer (108) der Überdeckungswert w(P', P'') wie folgt bestimmt:

Sei:

$G' = G$ and $A'$ and $C'$ and $L'_1$ and $L'_2$ and ...

die Annahme entsprechend des Schemas second_case_split.

Sei: $H' = G'$ and $A''$ and $L''_1$ and $L''_2$ and ...

die Bedingung dafür, dass die Eigenschaft P'' mit ihren Anteilen $A''$, $C''$, $L''_1$, $L''_2$, ... in der Eigenschaft entsprechend second_case_split zum Zuge kommt. Dann wird der Überdeckungswert w(P', P'') definiert zu

w(P', P'') = card (G', H') / card (H', H')

Damit wird die durch die Schleifenkontrolle (106) kontrollierte Schleife verlassen.

Die Schleifenkontrolle (109) durchläuft nun alle Haupteigenschaften P', die Nachfolger von P sind.

In dem Haupteigenschaftsüberdeckungswertbestimmer (110) wird der Überdeckungswert w(P, P') wie folgt bestimmt: Sei $Q_0$, $Q_1$, $Q_2$, ... $Q_n$ der Pfad von einer Quelle des Teileigenschaftsgraphen bis zur Haupteigenschaft P' = $Q_n$. Anschließend wird berechnet:

w(P, Q) = w(P, $Q_0$) * w($Q_0$, $Q_1$) * w($Q_1$, $Q_2$) * ... * w($Q_{n-1}$,P') *

Diese einzelnen Faktoren sind alle bekannt, denn w(P, $Q_0$) wurde im ersten Überdeckungswertbestimmer (105) und die übrigen w($Q_i$, $Q_{i+1}$) im zweiten Überdeckungswertbestimmer (108) berechnet.

Im Ausgabedeterminiertheitsbestimmer (111) wird ausgewertet, ob und wie viele der Zeilen

$$\text{during } [k_0+1, k'_0]: \quad o'_0 = o'^{\circ}_0;$$

$$\text{during } [k_1+1, k'_1]: \quad o'_1 = o'^{\circ}_1;$$

aus den Eigenschaften entsprechend des Schemas second_test gelöscht werden müssen, um die verbleibende Eigenschaft wahr werden zu lassen. Dies wird in einem iterativen Verfahren durchgeführt, bei dem Gegenbeispiele automatisch ausgewertet und vom Gegenbeispiel verletzte Zeilen vor der erneuten Anwendung des Eigenschaftsprüfers gelöscht werden. Der Ausgabedeterminiertheitswert w'(P, P') wird bestimmt als der Quotient der Anzahl verbliebener Zeilen gegen die Anzahl aller Ausgabesignale.

Sei u eine Konstante im abgeschlossenen Intervall [0, 1]. Im Bestimmer für die lokale Maßzahl (112) wird die lokale Maßzahl nun bestimmt durch

$$W(P,Q) = (u + (1-u) * w'(P,Q)) * w(P,Q)$$

Damit enden die innere Schleife (109) und die äußere Schleife (102).

Im Ausführungsbaumerzeuger (113) werde nun der Ausführungsbaum für den annotierten Eigenschaftssatz (1) erzeugt.

Sei v eine Konstante aus dem rechts offenen Intervall [0, 1[. Die Schleifenkontrolle (114) durchlaufe die Knoten des Ausführungsbaums so, dass sie mit den Endknoten anfängt, und einen inneren Knoten erst bearbeitet, wenn alle Nachfolger bereits bearbeitet sind.

Der Knotenbewerter (115) berechnet nun zu jedem Knoten P einen Vollständigkeitswert V(P). Wenn P ein leerer Endknoten ist, wird

$$V(P)=v$$

gesetzt. Wenn P ein voller Endknoten ist, wird

$$V(P) = 1$$

gesetzt. Andernfalls ist P ein innerer Knoten. Dann hat P Söhne, die mit $Q_1$, $Q_2$, ... $Q_n$ bezeichnet werden. Es wird berechnet

$$V(P) = v + (1-v) * (W(P, Q_1) * V(Q_1) + W(P, Q_2) * V(Q_2) + W(P, Q_3) * V(Q_3) + ....)$$

Damit wird die Schleife (114) verlassen. Der Benutzer erhält als resultierende Vollständigkeitsmaßzahl den Wert $V(P_{reset})$ in der Benutzerausgabe (116) angezeigt.

Mit den Konstanten v und u kann die Vollständigkeitsmaßzahl an die Aufwandsverteilung zwischen einzelnen Teilaufgaben während der formalen Verifikation angepasst werden.

Ist u = 0, so fließt die Ausgabedeterminiertheit sehr stark in das Endergebnis ein. Ist u = 1, wird die Ausgabedeterminiertheit gar nicht in Betracht gezogen. Damit kann u benutzt werden, um in die Bestimmung der Vollständigkeitsmaßzahl den erfahrungsgemäßen Aufwandsanteil für die Sicherstellung der Ausgabedeterminiertheit bei der Verifikation einfließen zu lassen und so die berechnete Maßzahl mit dem zu erwartenden Aufwand in Verbindung zu bringen. In jedem Fall ist W(P,Q) = w(P,Q), wenn die Ausgaben vollständig determiniert sind.

v = 0 führt dazu, daß alle Knoten, die nur auf Pfaden zu leeren Endknoten liegen, mit 0 bewertet werden. Entsprechend bleibt dann die Vollständigkeitsmaßzahl 0, solange der Übergangsgraph des Eigenschaftsautomaten keine Schleife enthält. Das ist möglicherweise ein unerwünschter Effekt, da ja bereits Eigenschaften geschrieben sind, sodass ein Wert /= 0 naheliegt. Da aber das Schließen der Schleifen erfahrungsgemäß ein aufwändiger Verifikationsschritt ist, sollte die Vollständigkeitsmaßzahl klein bleiben, solange die Schleifen nicht geschlossen sind und daher auch v nahe bei 0 bleiben.

Es soll gezeigt werden, dass das Verfahren folgende Eigenschaften hat:

1. Die Vollständigkeitsmaßzahl ist 1, wenn die annotierte Eigenschaftsmenge (1) vollständig ist.
2. Wenn die annotierte Eigenschaftsmenge (1) unvollständig ist und die Konstante u /= 1 ist, dann ist die Vollständigkeitsmaßzahl < 1.
3. Die Vollständigkeitsmaßzahl ist monoton, d.h. wenn ein gegebener, unvollständiger Satz von Eigenschaften um eine Eigenschaft ergänzt wird, wird die Maßzahl nicht kleiner.

Zum Beweis von 1) wird zunächst gezeigt, dass die Gültigkeit einer Eigenschaft entsprechend des Schemas first_case_split zur Folge hat, dass in der Situation der Eigenschaften entsprechend des Schemas first_case_split gilt:

$$w(P,P'_1) + w(P,P'_2) + w(P,P'_3) + ... = 1$$

Dabei bezeichnen die $P'_i$ alle Quellen des Teileigenschaftsgraphen, von denen aus ein Pfad zu einer der Eigenschaften aus der Nachfolgermenge führt.

Zuvor werden einige Regeln für das Rechnen mit card(A,B) bewiesen: Sei H eine beliebige Bedingung, V eine endliche Variablenmenge, die Obermenge von sup(H) ist und W eine endliche, zu V disjunkte Variablenmenge. + bezeichne die Mengenvereinigung. Dann ist

$$card(H, V + W) = card(def(W)) * card(H, V)$$

Wenn G eine zweite Bedingung ist mit H => G, so gilt demzufolge

$$card(H, H) / card(G, H) = card(H, sup(H)) / card(G, sup(H)) = card(H, V) / card(G, V)$$

für jede Obermenge V von sup(H). Damit ist insbesondere für die im Überdeckungswertbestimmer (5) errechneten Werte

$$w(P, P') = card(H, V) / card(G, V)$$

für jede Obermenge V von sup(H).

Sei $H_1$, $H_2$, $H_3$, ... die Bedingungen, die im ersten Überdeckungswertbestimmer (105) aus $P'_1$, $P'_2$, $P'_3$ gebildet werden. Die Menge

$V = \sup(H_1) + \sup(H_2) + \sup(H_3) + ...$

(+ steht für die Mengenvereinigung) ist auf jeden Fall eine Obermenge von jedem $\sup(H_i)$. Dann ist das oben gesagte anwendbar und man erhält

$$w(P, P'_1) + w(P, P'_2) + w(P, P'_3) + ... =$$

$$(card(H_1, V) + card(H_2, V) + card(H_3, V) + ... ) / card(G, V) =$$

$$card(H_1 \text{ or } H_2 \text{ or } H_3 \text{ or } ..., V) / card(G, V)$$

Die letzte Umformung ist möglich, weil angenommen wurde, dass die Voraussetzungen der $P'_i$ disjunkt sind und daher die Konjunktion beliebiger Paare der $H_i$ leer ist. Folgende Umformung ist daher möglich:

$$card(H_1 \text{ or } H_2 \text{ or } H_3 \text{ or } ..., V) / card(G, V) =$$

$$card(G \text{ and } ((A'_1 \text{ and } L'_{11} \text{ and } L'_{12} \text{ and } ... ) \text{ or }$$

$$(A'_2 \text{ and } L'_{21} \text{ and } L'_{22} \text{ and } ... ) \text{ or }$$

$$(A'_3 \text{ and } L'_{31} \text{ and } L'_{32} \text{ and } ... ) \text{ or }$$

$$...), V) / card(G, V) =$$

$$card(G, V) / card(G, V) = 1$$

Die vorletzte Umformung gilt, weil die Gültigkeit der Eigenschaft entsprechend Schema first_case_split vorausgesetzt wurde.

Auf ähnliche Weise kann man sehen, dass für eine Teileigenschaft P' und ihre Söhne $P''_1$, $P''_2$, $P''_3$, ... im Teileigenschaftsgraphen

$w(P', P''_1) + w(P', P''_2) + ... = 1$

gilt.

Für jede Haupteigenschaft P und jeden beliebigen Knoten Q' im Teileigenschaftsgraph von P sei s(P, Q') die Summe aller w(P, Q), wobei Q alle Nachfolgeeigenschaften von P durchlaufe, die durch einen Pfad von Q' aus zu erreichen sind. Sei $Q_0$, $Q_1$,... $Q_n$ ein Pfad von einer Quelle zu Q' und $Q_n = Q'$. Dieser Pfad ist durch die Festlegungen über den Teileigenschaftsgraphen eindeutig bestimmt. Durch vollständige Induktion wird bewiesen, dass

$s(P, Q') = w(P, Q_0) * w(Q_0, Q_1) * w(Q_1, Q_2) * ... * w(Q_{n-1}, Q')$

Induktionsverankerung: Die Behauptung ist trivial, wenn für Q' eine Senke des Teileigenschaftsgraphen gewählt wird, weil die Senken ja die Haupteigenschaften repräsentieren.

Induktionsschritt: Die Induktion durchlaufe den Knoten von den Senken bis zu Quelle in Breitensuche, sodass zur Bestimmung von s(P, Q') die Behauptung schon für alle Nachfolger $R_1$, $R_2$, ... von Q' im Teileigenschaftsgraphen gilt. Zunächst führen wegen der Forderungen an den Teileigenschaftsgraphen alle Pfade durch P und Q' zu Haupteigenschaften, die in der Nachfolgermenge von P stehen. Damit ist

$$s(P, Q') = s(P, R_1) + s(P, R_2) + ... =$$

$$w(P, Q_0) * w(Q_0, Q_1) * ... * w(Q_{n-1}, Q') * w(Q', R_1) +$$

$$w(P, Q_0) * w(Q_0, Q_1) * ... * w(Q_{n-1}, Q') * w(Q', R_2) +$$

$$w(P, Q_0) * w(Q_0, Q_1) * ... * w(Q_{n-1}, Q') * w(Q', R_3) +$$

$$.... =$$

$$w(P, Q_0) * w(Q_0, Q_1) * ... * w(Q_{n-1}, Q') * (w(Q', R_1) + w(Q', R_2) + ...)$$

Für den Inhalt der Klammer in der letzten Zeile wurde weiter oben nachgewiesen, dass er sich zu 1 ergibt. Also ist $s(P, Q') = w(P, Q_0) * w(Q_0, Q_1) * ... * w(Q_{n-1}, Q')$

Damit ist die Induktionsbehauptung bewiesen.

Die Haupteigenschaften aus der Nachfolgermenge von P werden mit $P_1$, $P_2$, ...benannt Ferner werden die Quellen des Teileigenschaftsgraphen, von denen aus Pfade zu Eigenschaften aus der Nachfolgermenge von P führen, mit $Q_1$, $Q_2$, $Q_3$, ... bezeichnet Die Überlegung oben hat gezeigt, dass

$$w(P, P_1) + w(P, P_2) + w(P, P_3) + .... =$$

$$s(P, Q_1) + s(P, Q_2) + s(P, Q_3) + .... =$$

$$w(P, Q_1) + w(P, Q_2) + w(P, Q_3) + ...$$

Dieser Wert ist nach den obigen Überlegungen 1.

Es wird nun gezeigt, dass für jeden Knoten P im Ausführungsbaum einer vollständigen Eigenschaftsmenge gilt V(P) = 1. Dies wird durch vollständige Induktion über den Ausführungsbaum bewiesen:

Induktionsverankerung: In einer vollständigen Eigenschaftsmenge gibt es keine Eigenschaft ohne Nachfolger. Damit ist jeder Endknoten voll und daher gilt die Induktionsbehauptung für alle Endknoten.

Induktionsschritt: Die Induktion traversiere alle Knoten in rückwärtsgewandter Breitensuche, d.h. ein Knoten P wird erst ausgewählt, wenn die Induktionsannahme bereits für seine Söhne $Q_1$, $Q_2$, ... bewiesen wurde. Dann gilt

$$V(P) = v + (1\text{-}v) * (W(P, Q_1) * V(Q_1) + W(P, Q_2) * V(Q_2) + W(P, Q_3) * V(Q_3) + ....)$$

$$= v + (1\text{-}v) * (W(P, Q_1) + W(P, Q_2) + W(P, Q_3) + ....)$$

Unter der Annahme, dass die Eigenschaftsmenge vollständig ist, sind auch alle Ausgabesignale durch die Eigenschaft second_test geprüft wurden. Daher ist W(P, Q) = w(P, Q) und damit
$V(P) = v + (1 - v) * (w(P, Q_1) + w(P, Q_2) + ...)$

Die Summe in der Klammer ist wegen der Überlegungen oben 1, also
$V(P) = v + 1 - v = 1$

Damit ist die Induktion bewiesen. Insbesondere gilt damit auch, dass $V(P_{reset}) = 1$ ist und damit das Vollständigkeitsmaß 1 ist.

Sei $M_1$ und $M_2$ eine annotierte Eigenschaftsmenge und $M_1$ eine Untermenge von $M_2$. Die zusätzlich enthaltenen Eigenschaften von $M_2$ sollen keine widersprüchlichen Annahmen haben. Die Konsistenzbedingungen über die Nachfolgermengen verlangt für $M_2$, dass der Ausführungsbaum von $M_2$ dann auch die zusätzlichen Eigenschaften enthält. Ferner gelte v /= 1, v /= 0 und u /= 0.

Der Ausführungsbaum von $M_1$ ist ein Unterbaum von $M_2$. Zunächst wird nachgewiesen, dass für jeden Knoten P des Ausführungsbaums von $M_1$ und für die Relation zwischen den Bewertungen $V_1$ und $V_2$ für $M_1$ bzw. $M_2$ gilt:

$V_1(P) <= V_2(P)$

und sogar

$V_1(P) < V_2(P)$, falls der in P beginnende Teilbaum des Ausführungsbaums Eigenschaften enthält, die in $M_2$, aber nicht in $M_1$ vorkommen.

Der Beweis wird wieder durch Induktion geführt. Diese folgt einer umgekehrten Breitensuche.

Induktionsverankerung:

Wenn P ein voller Endknoten in $M_1$ ist, so ist es auch ein voller Endknoten im $M_2$. Also gilt die Induktionsbehauptung.

Wenn P ein leerer Endknoten in $M_1$ ist, so kann es ein innerer Knoten in $M_2$ sein. Wenn es ein innerer Knoten ist, dann ist

$V_1(P) < V_2(P)$

Das ergibt sich aus der Definition von $V_1$ bzw. $V_2$, aus v < 1, aus V(P) > 0 für jeden Knoten und aus W(P, Q) > 0, weil u /= 0 vorausgesetzt wurde. Das entspricht der Induktionsbehauptung.

Wenn P ein leerer Endknoten in $M_1$ ist und kein innerer Knoten in $M_2$ ist, dann ist es auch ein leerer Endknoten in $M_2$, sodass erneut die Induktionsbehauptung gilt.

**Induktionsschritt:**

Es wird ein traversieren des Ausführungsbaumes wieder in rückwärtsgewandter Breitensuche durchgeführt. Betrachtet werde ein innerer Knoten P in dem Ausführungsbaum von $M_1$. Er habe die Söhne $Q_1$, $Q_2$, ..., für die die Induktionsbehauptung gilt. Wenn die mit $Q_i$ beginnenden Teilbäume der beiden Ausführungsbäume gleich sind, gilt $V_1(Q_i) = V_2(Q_i)$ für alle i. Damit ist dann auch $V_1(P) = V_2(P)$, weil in die Definition die gleichen Zahlen eingesetzt werden.

Andernfalls gibt es mindestens ein Q unter den $Q_i$ mit unterschiedlichen Teilbäumen und daher $V_1(Q) < V_2(Q)$. Wenn diese Zahlen in die Definitionen von $V_1(P)$ und $V_2(P)$ eingesetzt werden, ergibt sich daher

$V_1(P) < V_2(P)$

weil mit positiven Zahlen multipliziert wird. Damit ist die Induktionsbehauptung auch für den Induktionsschritt bewiesen.

Als Folge davon ist

$V_1(P_{reset}) < V_2(P_{reset})$.

**Maßzahl bei unvollständiger Eigenschaftsmenge**

Es sei eine unvollständige annotierte Eigenschaftsmenge gegeben. Daher ist sie um mindestens eine Eigenschaft ergänzbar, die disjunkt zu allen anderen ist. Der vorstehende Beweis zeigt, daß die ergänzte Eigenschaftsmenge eine echt größere Vollständigkeitsmaßzahl hat als die ursprüngliche Eigenschaftsmenge. Gleichzeitig ist die Vollständigkeitsmaßzahl nach oben durch 1 beschränkt, wie der erste Beweisteil zeigt. Demnach ist die Vollständigkeitsmaßzahl einer unvollständigen Eigenschaftsmenge kleiner als 1.

**Anwendungsbeispiel des vierten Ausführungsbeispieles**

Es wird Bezug genommen auf den Interruptcontroller entsprechen dem Anwendungsbeispiel des ersten Ausführungsbeispieles, und man betrachtet eine unvollständige Eigenschaftsmenge, die aus den Eigenschaften reset, wm und idle besteht. Alle Ausgabebeschreibungen sollen präzise sein. Die Nachfolgermengen seien entsprechend um int reduziert, im Teileigenschaftsgraph tauchen int_p und int nicht auf. Es sei v = 0.1 gegeben.

Der Graph des sich ergebenden Eigenschaftsautomaten ist in Fig. 7 gegeben, der Ausführungsbaum dazu in Fig. 8. Die Überdeckungswerte ergeben sich wie folgt:

w(reset, wm):

$G_{reset} =$

(reset @ t = '1' and reset @ t+1 = '0' and

int_req @ t = '0' and int_req @ t+1 = '0' and

d_out @ t = "00" and d_out @ t+1 = "00" and

mask @ t+1 = "FF" and

pending_int @ t+1 = "00" and

state @ t+1 = idle and

reset @ t+1 = '1' and reset @ t+2 = '1' and

$e_l$ @ t+1 and $e_l$ and t+2);

$H_{reset, wm} =$ ($G_{reset}$ and

reset @ t+1 = '0' and reset @ t+2 = '0' and

state @ t+1 = idle and

write_mask @ t+1 = '1')

= ($G_{reset}$ and

write_mask @ t+1 = '1');

Zur letzten Umformung wurden Konjunkte gestrichen, die in $G_{reset}$ bereits auftreten. Für die folgende Umformung werden einige Rechenregeln über card aus: Seien A und B zwei Bedingungen, V eine Obermenge von sup(A), W eine Obermenge von sup(B) und V und W zueinander disjunkt verwendet. Dann ist card(A and B, V + W) = card(A, V) * card(B, W). Wenn A und B zwei Bedingungen sind und V eine Obermenge von sup(A + B), dann ist card(A or B, V) = card(A, V) + card(B and not A, V).

Die Elemente von sup(H) sind aus der obigen Repräsentation leicht abzulesen. sup(G) enthält write_mask @ t+1 nicht, sodass

$$w(\text{reset}, wm) = \text{card}(H, H) / \text{card}(G, H) =$$

$$\text{card}(\text{write\_mask}@t+1 = '1', \{\text{write\_mask}@t+1\}) /$$

$$\text{card}(\text{true}, \{\text{write\_mask}@t+1\})$$

$$= 0.5$$

w(reset, idle): Es ist

$$H_{\text{reset, idle}} = \quad (G_{\text{reset}} \text{ and}$$

reset @ t+1 = '0' and reset @ t+2 = '0' and

state @ t+1 = idle and

write_mask @ t+1 = '0' and

(pending_int @ t+1 and mask @ t+1) = 0)

$$= \quad (G_{\text{reset}} \text{ and}$$

write_mask @ t+1 = '0')

Analog zu oben ergibt sich daher

$$w(\text{reset}, \text{idle}) = 0.5$$

Dass sich w(reset, idle) und w(reset, wm) zu 1 ergänzen stimmt mit der Gültigkeit der Eigenschaft entsprechend first_case_split überein.

w(wm, wm):

$$G_{wm} =$$

(reset @ t = '0' and reset @ t + 1 = '0' and
state @ t = idle and
write_mask @ t = '1' and

int_req @ t+1 = '0' and
mask @ t+1 = d_in @ t and
state @ t+1 = idle and
pending_int @ t+1 = (pending_int @ t or int_in @ t) and
d_out @ t+1 = "00" and

$$\text{reset } @ \text{ } t+1 = \text{'0' and reset } @ \text{ } t+2 = \text{'0' and}$$
$$e_l @ \text{ } t+2 \text{ and } e_l @ \text{ } t+3 \text{ and } e_l @ \text{ } t+4 \text{ and } .... \text{ and } e_l @ \text{ } t+12);$$

$$H_{wm, \text{ } wm} = (G_{wm} \text{ and}$$
$$\text{reset } @ \text{ } t+1 = \text{'0' and reset } @ \text{ } t+2 = \text{'0' and}$$
$$\text{state } @ \text{ } t+1 = \text{idle and}$$
$$\text{write\_mask } @ \text{ } t+1 = \text{'1'})$$

$$= \quad (G_{wm} \text{ and}$$
$$\text{write\_mask } @ \text{ } t+1 = \text{'1'})$$

Also ist

$$w(wm, \text{ } wm) = 0.5$$

$$w(wm, \text{ } idle):$$

$$H_{wm,idle} = (G_{wm} \text{ and}$$
$$\text{reset } @ \text{ } t+1 = \text{'0' and reset } @ \text{ } t+2 = \text{'0' and}$$
$$\text{state } @ \text{ } t+1 = \text{idle and}$$
$$\text{write\_mask } @ \text{ } t+1 = \text{'0' and}$$
$$(\text{pending\_int } @ \text{ } t+1 \text{ and mask } @ \text{ } t+1) = 0)$$

$$= \quad (G_{wm} \text{ and}$$
$$\text{write\_mask} = \text{'0' and}$$
$$((\text{pending\_int } @ \text{ } t \text{ or int\_req } @ \text{ } t) \text{ and d\_in } @ \text{ } t = 0))$$

Sei G'$_{wm}$ definiert wie G$_{wm}$ wobei allerdings die Zeile über pending_int übergangen wird. Dann ist

$$H_{wm,idle} = (G'_{wm} \text{ and}$$
$$\text{pending\_int } @ \text{ } t+1 = (\text{pending\_int } @ \text{ } t \text{ or int\_in } @ \text{ } t) \text{ and}$$
$$((\text{pending\_int } @ \text{ } t \text{ or int\_req } @ \text{ } t) \text{ and d\_in } @ \text{ } t = 0) \text{ and}$$
$$\text{write\_mask } @ \text{ } t+1 = \text{'0'});$$

Mit g = (pending_int @ t+1 = (pending_int @ t or int_in @ t) and ((pending_int @ t or int_req @ t) and d_in @ t = 0)) ist

$$w(wm, \text{ } idle) = card(H_{wm,idle}, H_{wm, \text{ } idle}) / card(G_{wm}, H_{wm,idle}) =$$

$$(card(G'_{wm}, G'_{wm}) * card(g, g) *$$
$$card(\text{write\_mask } @ \text{ } t+1 = \text{'0'}, \{\text{write\_mask } @ \text{ } t+1\})) /$$
$$(card(G'_{wm}, G'_{wm}) *$$
$$card(\text{pending\_int } @ \text{ } t+1 = (\text{pending\_int } @ \text{ } t \text{ or int\_in } @ \text{ } t), g) *$$
$$card(1, \{\text{write\_mask } @ \text{ } t+1\})) =$$

$$0.5 * card(g, g) / card(\text{pending\_int } @ \text{ } t+1 = (\text{pending\_int } @ \text{ } t \text{ or int\_in } @ \text{ } t), g)$$

Zunächst ist card(pending_int @ t+1 = (pending_int @ t or int_in @ t), g) = 2 ** 32, denn von den fünf 8-bit-Signalen in sup(g) können alle bis auf pending_int @ t+1 frei gewählt werden, und zu jeder Wahl gibt es genau ein passendes pending_int @ t+1.

Zur Bestimmung von card(g,g) machen wird eine Fallunterscheidung über die Anzahl von Nullen in d_in@t vorgenommen. Es gibt jeweils 8! / ((8-n)! * n!) viele Möglichkeiten einen Bitvektor mit n Nullen zu erzeugen. An den Positionen dieser Nullen dürfen in pending_int @ t und in int_req @ t Einsen vorkommen, alle anderen Positionen müssen 0 sein. Für jede Variable gibt es 2 ** n Möglichkeiten, die erlaubten Positionen mit 0 oder 1 zu füllen. Daher gibt es (8! * 2 ** 2n) / ((8-n)! * n!) Möglichkeiten, diese drei Variablen so zu belegen, daß einerseits d_in @ t genau n Nullen enthält und andererseits ((pending_int @ t or int_req @ t) and d_in @ t = 0) gilt. Die Summe über diesen Ausdruck für n = 0, 1, ... 8 ergibt 390625. Zu jeder Kombination darf int_in@t frei gewählt werden, und dann gibt es nur genau ein passendes pending_int@t+1 . Mithin ist

$$w(wm, idle) = 0.5 * 390625 / 2 ** 24 = 0.0116415.$$

w(idle, wm):

$G_{idle} =$
   reset @ t = '0' and reset @ t + 1 = '0' and
   state @ t = idle and
   write_mask @ t = '0' and
   (pending_int @ t and mask @ t) = 0 and

   state @ t+1 = idle and
   mask @ t+1 = mask @ t and
   int_req @ t+1 = '0' and
   pending_int @ t+1 = (pending_int @ t or int_in @ t) and
   d_out @ t+1 = "00" and

   reset @ t+1 = '0' and reset @ t+2 = '0' and
   $e_l$ @ t+2 and $e_l$ @ t+3 and $e_l$ @ t+4 and .... and $e_l$ @ t+12;

$H_{idle, wm} = G_{idle}$ and
   reset @ t+1 = '0' and reset @ t+2 = '0' and
   state @ t+1 = idle and
   write_mask @ t+1 = '1'

= $G_{wm}$ and

write_mask @ t+1 = '1'

Also ist

$$w(\text{idle}, wm) = 0.5$$

$$w(\text{idle}, \text{idle})$$

$$H_{\text{idle, idle}} = G_{\text{idle}} \text{ and}$$

reset @ t+1 = '0' and reset @ t+2 = '0' and
state @ t+1 = idle and
write_mask @ t+1 = '0' and
(pending_int @ t+1 and mask @ t+1) = 0

$$= \quad G_{\text{idle}} \text{ and}$$

write_mask @ t+1 = '0' and
((pending_int @ t or int_in @ t) and mask @ t) = 0

$$= \quad G_{\text{idle}} \text{ and}$$

write_mask @ t+1 = '0' and
(int_in @ t and mask @ t) = 0

Sei

$$G'_{\text{idle}} =$$

reset @ t = '0' and reset @ t + 1 = '0' and
state @ t = idle and
write_mask @ t = '0' and

state @ t+1 = idle and
int_req @ t+1 = '0' and
d_out @ t+1 = "00" and

reset @ t+1 = '0' and reset @ t+2 = '0' and
$e_l$ @ t+2 and $e_l$ @ t+3 and e1 @ t+4 and .... and $e_l$ @ t+12;

Mit der Abkürzung

```
g' = (pending_int @ t and mask @ t) = 0 and
    mask @ t+1 = mask @ t and
    pending_int @ t+1 = (pending_int @ t or int_in @ t)
und
g = g' and (int_in @ t and mask @ t) = 0
gelangt man zu
w(idle, idle) = card(Hidle, idle, Hidle, idle) / card(Gidle, Hidle, idle) =
    ((card(G'idle, G'idle) * card(g, g) *
        card(write_mask @ t+1 ='0', {write_mask @ t+1})) /
    ((card(G'idle, G'idle) * card(g', g) *
        card(true, {write_mask @ t+1}))
= 0.5 * card(g, g) / card(g', g)
```

card(g', g) berechnet sich wie folgt: Aus Überlegungen ähnlich den obigen folgt, dass es 6561 Möglichkeiten gibt, (pending_int @ t and mask @ t) = 0 zu erfüllen. Zu jeder dieser Möglichkeiten kann int_in frei gewählt werden und es gibt dann genau ein mask @ t+1 bzw. pending_int @ t+1, das dazu passend gewählt werden kann. Damit ist card(g', g) = 1679616. Zur Berechnung von card(g, g) kann wie oben gefolgert werden, dass es 390625 Möglichkeiten gibt, int_in@t, pending_int@t und mask@t zu wählen. Aus dieser Wahl ergeben sich mask @ t+1 und pending_int @ t+1 eindeutig.

Damit ist w(idle, idle) = 0.5 * 390625 / 1679616 = 0.116284

Die V-Werte der Knoten ergeben sich nun wie in Fig. 8. Der Vollständigkeitswert ergibt sich zu 0.5561781

Erweiterungen zu den zweiten bis vierten Ausführungsbeispielen:

**Überdeckungswertberechnung**

Die Überdeckungswerte lassen sich nach verschiedenen Algorithmen berechnen. Ein denkbarer alternativer Algorithmus approximiert sie, indem Zufallswerte erzeugt werden, die G erfüllen und geprüft wird, wie viele dieser Zufallswerte die Annahmen der möglichen Nachfolgeeigenschaften erfüllen.

**Ausgabedeterminiertheitsbestimmung**

Zu allgemeineren Determiniertheitskriterien kann übergegangen werden. Ferner können die Kriterien für die Bestimmung des Wertes w'(P, Q) recht unterschiedlich gewählt werden: Eine Vorgehensweise setzt w'(P,Q) = u, sobald die Eigenschaft entsprechend Schema second_test nicht erfüllt ist, und andernfalls 1. Dies verzichtet ganz auf Iterationen. Im anderen Extrem wird die Determiniertheit eines Signals zu jedem Zeitpunkt separat geprüft.

**Verkürzte Annahmen über die Vorgängereigenschaft**

Wie im ersten Ausfiihrungsbeispiel kann zu verkürzten Annahmen über die Vorgängereigenschaft übergegangen werden. Das hat den Vorteil, das u. U. mehrere Eigenschaften die selben verkürzten Annahmen produzieren und auf diese Weise Berechnungen reduziert werden können.

Die Erfindung ist nicht auf die beschriebene temporale Logik beschränkt. Sie kann auf alle linearen temporalen Logiken, d.h. insbesondere auf die Standards PSL und SVA übertragen werden. Maßgeblich ist letztendlich, dass die Eigenschaften nicht mehr singulär sondern unter Bildung von Ketten eine strukturierte Anwendung erlauben.

**Patentansprüche**

1. Ein in der Hardware implementiertes Verfahren zur funktionalen Verifikation digitaler Schaltungen, bei welchem die digitale Schaltung mit einer Menge von Eigenschaften überprüft wird, die ein Verhalten der digitalen Schaltung beschreiben, das Eingabewerte einliest und über mindestens eine Ausgabegröße Ausgabewerte ausgibt, wobei die digitale Schaltung eine Vielzahl von ersten internen Werten aufweist und ausgehend von der Vielzahl von ersten internen Werten eine Folge von Eingabewerten bearbeitet, indem die digitale Schaltung zu zumindest einem der Eingabewerte und zu zumindest einem der internen Werte einen neuen internen Wert und einen Ausgabewert generiert, das Verfahren umfassend:

   a) Feststellen der Existenz zumindest einer Untermenge von Eigenschaften durch die Bildung von weiteren Eigenschaften in einem Eigenschafterzeuger und die Prüfung (33) der weiteren Eigenschaften in einem Eigenschaftsprüfer, wobei die Untermenge von Eigenschaften einen vorgegebenen Ausdruck Q(t) über die Ausgabewerte zu mindestens einem Zeitpunkt in Abhängigkeit von den Eingabewerten eindeutig bestimmt, wobei der vorgegebene Ausdruck Q(t) zu dem Zeitpunkt von den einzelnen Eigenschaften allein nicht in Abhängigkeit von den Eingabewerten eindeutig bestimmt ist, und wobei die Untermenge von Eigenschaften zumindest eine Eigenschaftskette umfasst und untersucht wird, dass entlang der Eigenschaftskette die Werte der Ausgabesignale eindeutig bestimmt sind, wobei Zeitbereiche berechnet werden, an denen Ausgabesignale der Eigenschaften eindeutig definiert sind,
   b) Auswählen einer Vielzahl der vorgegebenen Ausdrücke Q(t), bei welchem Q(t) der Wert einer der Ausgabewerte zu einem Zeitpunkt t ist,
   c) Bestimmung einer Gütermaßzahl in Abhängigkeit davon, zu welchen Zeitpunkten und zu welchen der vorgegebenen Ausdrücken Q(t) und für welche Folgen der Eingabewerte der jeweilige vorgegebene Ausdruck Q(t) eindeutig bestimmt ist,
   d) Ausgabe der Gütemaßzahl.

2. Verfahren nach einem der vorangegangenen Ansprüche, wobei eine erste Eigenschaft das Initialisierungsverhalten der digitalen Schaltung beschreibt.

3. Verfahren nach einem der vorangegangenen Ansprüche, wobei weitere der Eigenschaften ermittelt und ausgegeben werden, die weder zur Bildung der Kette von Eigenschaften ($P_0$, $P_i$, ... $P_n$) geeignet sind, noch zu einer Folge von Eingabewerten den Wert des vorgegebenen Ausdrucks (Q(t)) eindeutig bestimmen.

4. Verfahren nach Anspruch 2 oder 3, bei welchem die Eigenschaften $(P_0, P_i, ... P_n)$ der Eigenschaftkette die Form $P_i$ = forall t: $A_i(t) => Z_i(t)$ haben mit implikativ verknüpften Booleschen Ausdrücken $A_i(t)$ und $Z_i(t)$, die von den Eingabewerten, den Ausgabewerten und den internen Werten zu Zeitpunkten relativ zu t abhängen, wobei im Schritt der Existenzfeststellung geprüft wird, ob eine Folge von Referenzzeitpunkten $(T_1, T_2, ... T_n)$ existiert, so dass die durch die Eigenschaftskette $(P_0, P_1,... P_n)$ bezüglich der Referenzzeitpunkte gegebene Eigenschaft

$$E = \text{forall } t \qquad (A_0(t) => Z_0(t)) \text{ und}$$
$$((A_0(t) \text{ und } A_1(T_1)) => Z_1(T_1)) \text{ und}$$
$$((A_0(t) \text{ und } A_1(T_1) \text{ und } A_2(T_2)) => Z_2(T_2)) \text{ und}$$
$$\dots \text{und}$$
$$((A_0(t) \text{ und } A_1(T_1) \text{ und } \dots \text{ und } A_n(T_n)) => Z_n(T_n))$$

zu zumindest einer Folge von Eingabewerten einen der Ausgabewerts der digitalen Schaltung zu mindestens einem Zeitpunkt eindeutig beschreibt.

5. Verfahren nach einem der vorangehenden Ansprüche, bei welchem eine Menge der Folge von Eingabewerten bestimmt wird, auf denen der vorgegebene Ausdruck (Q(t)) zu jeweils mindestens einem Zeitpunkt eindeutig bestimmt ist.

6. Verfahren nach Anspruch 4 und 5, bei dem die Menge der Folgen von Eingabewerten **dadurch** bestimmt wird, dass es zu einer Folge dieser Menge der Folge der Eingabewerte mindestens eine Wertefolge der internen Werte und der Ausgabewerte gibt, so dass es mindestens einen Zeitpunkt t gibt, für den auf diesen Wertefolgen $A_0(t)$ und $Z_0(t)$ und $A_1(T_1)$ und $Z_1(T_1)$ und ... und $A_n(T_n)$ gilt.

7. Verfahren nach Anspruch 4, bei welchem die Referenzzeitpunkte $T_1, T_2, ... T_n$ von Eingabewerten unabhängig sind.

8. Verfahren nach einem der vorangegangen Ansprüche, bei welchem die Eigenschaften aus der Untermenge von Eigenschaften $(P_0, P_i, ... P_n)$ in einer Nachfolgebeziehung stehen, wobei für $i \neq 0$ solche Ausgabewerte und interne Werten, durch die $Z_{i-1}(t)$ bei geeigneter Wahl der Folge der Eingabewerte erfüllt wird, auch $A_i(t')$ bei geeigneter Wahl von t' und der Folge der Eingabewerte erfüllt wird.

9. Verfahren nach einem der vorangegangenen Ansprüche, bei welchem die Eigenschaften aus der Untermenge von Eigenschaften in einer Nachfolgebeziehung stehen, wobei für $i \neq 0$ die $Z_{i-1}(t)$ und $A_i(t)$ syntaktisch bis auf zeitliche Verschiebung gleiche Teilausdrücke über interne Werte und Ausgabewerte enthalten.

10. Verfahren nach einem der vorangegangenen Ansprüche, bei welchem geprüft wird, dass eine endliche Menge der Eigenschaften zu mindestens einer Folge von Eingabewerten die Ausgabewerte, die über eine Ausgabegröße ausgegeben werden zu allen Zeitpunkten nach einem ersten Zeitpunkt eindeutig bestimmt.

11. Verfahren nach einem der vorangegangen Ansprüche, bei welchem der Schritt des Existenzfeststellens von zumindest einer geringeren Untermenge der Untermenge der Eigenschaften wiederholt wird, um weitere Untermengen zu ermitteln, die den Ausdruck (Q(t)) für zumindest eine andere Folge von Eingabewerten an mindestens einem Zeitpunkt eindeutig bestimmen.

12. Verfahren nach einem der vorangegangen Ansprüche, bei welchem das Verfahren wiederholt wird bezüglich aller Ausgabegrößen und aller Folgen der Eingabewerte, so dass sichergestellt wird, dass zu jeder Folge von Eingabewerten alle Ausgabewerte zu jedem Zeitpunkt nach einem ersten Zeitpunkt eindeutig bestimmt sind.

13. Verfahren nach Anspruch 12, bei welchem solche Folgen der Eingabewerte identifiziert und ausgegeben werden, auf denen die Eigenschaften mindestens einen Ausgabewert zu mindestens einem Zeitpunkt nach dem ersten Zeitpunkt nicht eindeutig bestimmen.

14. Verfahren nach einem der vorangegangenen Ansprüche, wobei die digitale Schaltung zumindest teilweise von Software gesteuert ist.

15. Verfahren nach einem der vorangegangenen Ansprüche, wobei die digitale Schaltung teilweise in Hardware implementiert ist.

16. Verfahren nach einem der vorangegangenen Ansprüche, wobei zumindest einige der Eingabewerte über Eingabesignale eingelesen werden.

17. Verfahren nach einem der vorangegangenen Ansprüche, wobei zumindest einige der Ausgabewerte über Ausgabesignale ausgegeben werden.

18. Verfahren nach einem der vorangegangenen Ansprüche, wobei die Gütemaßzahl einen vorher bestimmten maximalen Wert hat, wenn alle vorgegebenen Ausdrücke (Q(t)) zu allen Zeitpunkten und zu allen Folgen der Eingabewerte eindeutig bestimmt sind.

19. Verfahren nach einem der vorangegangenen Ansprüche, wobei die vorgegebenen Ausdrücke (Q(t)) die Werte sind, die einige von einem Nutzer ausgewählte Ausgabegrößen ausgeben.

20. Verfahren nach einem der vorangegangenen Ansprüche, wobei die Gütemaßzahl durch Hinzufügung einer weiteren Eigenschaft nicht kleiner wird.

21. Verfahren nach einem der vorangegangenen Ansprüche zur funktionalen Verifikation digitaler Schaltungen, bei welchem die digitale Schaltung mit einer Menge von Eigenschaften überprüft wird, deren Gütemaßzahl einer definierten Vorgabe entspricht.

22. Verfahren nach einem des Ansprüche 1 bis 20, zur Spezifikation von digitalen Schaltungen, bei welchem die Spezifikation erstellt wird, ausgehend von einer Menge von Eigenschaften, deren Gütemaßzahl nach einem Verfahren nach einem der Ansprüche 1 bis 20 bestimmt wird und einer definierten Vorgabe entspricht.

23. Verfahren nach einem des Ansprüche 1 bis 20, zur simulativen Verifikation digitaler Schaltungen, bei welchem Monitore verwendet werden, wobei die Monitore Automaten darstellen, und die Qualität der Monitore bestimmt wird anhand der Gütemaßzahl einer den Monitor beschreibenden Menge von Eigenschaften, die nach einem Verfahren nach einem der Ansprüche 1 bis 20/ bestimmt wird.

24. Verfahren nach einem des Ansprüche 1 bis 20, zur simulativen Verifikation digitaler Schaltungen, bei welchem Coverage bestimmt wird durch Monitore, die aus den Annahmen eines Satzes von Eigenschaften gewonnen werden, deren Gütemaßzahl nach einem der Verfahren der Ansprüche 1 bis 20 ermittelt wird und einer definierten Vorgabe entspricht.

**Claims**

1. A hardware implemented method for functional verification of digital circuits, wherein the digital circuit is checked with a set of properties representing the functionality of the digital circuit, reading input values and providing output parameters via at least one output device, wherein the digital circuit comprises a plurality first internal values and processes a pattern of input values based on said plurality of first internal values, in that said digital circuit generates for at least one input value and for at least one internal value a new internal value and a output value, the method comprising:

   a) determination of the existence of at least one sub-quantity of properties by providing further properties in a property-generator and checking (33) of the further properties in a property-checker, wherein said sub-quantity uniquely determines a predetermined expression Q(t) via said output parameters for at least one point of time in response to input pattern, wherein said predetermined expression Q(t) is not uniquely determined at said point of time by said single properties in respons to input values alone, and wherein said sub-quantity of properties comprises at least one property-chain and it being analysed along said property-chain, whether the values of the output signal are uniquely defined, wherein time frames are calculated, during which output signals of said properties are uniquely defined,

b) selecting a plurality of given or predetermined expressions Q(t) such that Q(t) is the value of one of the output values at said point in time t,

c) determining a quality factor in dependency of the fact as to at what points in time and with respect to which predetermined expressions Q(t) and for which among said patterns of input values the respective predetermined expressions Q(t) is uniquely determined,

d) outputting said quality factor.

2. Method according to any of the preceding claims, wherein the first property describes the initialization behaviour of the digital circuit.

3. Method according to any of the preceding claims, wherein further of said properties are determined and issued, which are neither suited to the formation of a series or chain of properties $(P_0, P_i, ..... P_n)$ nor uniquely determining the value of said predetermined expression Q(t) for any one pattern of input values.

4. Method according to claim 2 or 3, wherein the properties $(P_0, P_i, ..... P_n)$ of said chain of properties have the form $P_i = $ forall t: $A_i(t) => Z_i(t)$ with implicatively linked Boolean expressions $A_i(t)$ und $Z_i(t)$, which are dependant on the input values, the output values and on the internal parameters or values at points in time relative to t, wherein it is checked in the step of determination of the existence, whether a chain or sequence of reference points in time $T_1$, $T_2$, ... $T_n$ exists such that the property given by means of the property-chain $(P_0, P_i, ..... P_n)$ with respect to the reference points in time

$$E = \text{forall } t. \ (A_0(t) => Z_0(t)) \text{ and}$$
$$((A_0(t) \text{ and } A_1(T_1)) => Z_1(T_1)) \text{ and}$$
$$((A_0(t) \text{ and } A_1(T_1) \text{ und } A_2(T_2)) => Z_2(T_2)) \text{ and}$$
$$...\text{and}$$
$$((A_0(t) \text{ and } A_1(T_1) \text{ and } ... \text{ and } A_n(T_n)) => Z_n(T_n))$$

uniquely describes the value of an output value or parameter of the digital circuit at least for one point in time for at least one succession of input values or parameters.

5. Method according to any of the preceding claims, wherein a quantity of input patterns is determined on which Q(t) is uniquely determined for at least one point in time respectively.

6. Method according to claims 4 and 5, wherein the quantity of the input patterns is determined by the existence of at least one value series of input and output parameters for one input pattern of this quantity such that there is at least one point in time t, to which on these value series $A_0(t)$ and $Zo(t)$ and $A_1(T_1)$ and $Z_1(T_1)$ and ... and $A_n(T_n)$ are valid.

7. Method according to claim 4, wherein the reference points in time $T_1$, $T_2$, ... $T_n$ are independent on inputs.

8. Method according to any of the preceding claims, wherein the interrelated properties are in a sequential relation to one another, wherein for $i \neq 0$ such values for output an internal parameters, by which $Z_{i-1}(t)$ with a suitable selection of an input pattern is fulfilled, also $A_i(t')$ is fulfilled with a suitable selection of t' and the inputs.

9. Method according to any of the preceding claims, wherein the interrelated properties are in sequential relation to one another, wherein $Z_{i-1}(t)$ and $A_i(t)$ for $i \ /= 0$ syntactically contain equal partial expressions concerning internal and external parameters except for temporal delay.

10. Method according to any of the preceding claims, wherein it is checked that a finite quantity of properties uniquely determines the values of an output parameter for all points in time following a primary point in time for at least one input pattern.

11. Method according to any of the preceding claims, wherein the step of determining the existence of at least one sub-quantity of interrelated properties is repeated in order to determine additional sub-quantities, which uniquely determine Q(t) for at least one further sequence of input pattern or values at least one point in time.

12. Method according to any of the preceding claims, wherein the check is repeated with respect to all output parameters and all sequences of input values or input patterns such that it is ensured that the behavior of the output parameters at every point in time following the primary point in time is uniquely determined for every input pattern.

13. Method according to claim 12, wherein such input patterns are identified and issued, on which the properties do not uniquely determine the values of some output parameters for at least one point in time following the primary point in time.

14. Method according to any of the preceding claims, wherein the digital circuit is at least in part controlled by software.

15. Method according to any of the preceding claims, wherein the digital circuit is at least in part implemented by hardware.

16. Method according to any of the preceding claims, wherein at least some of the input values are read in via input signals.

17. Method according to any of the preceding claims, wherein at least some of the output values are output or issued via output signals.

18. Method according to any of the preceding claims, wherein the quality factor is having a predetermined value if all predetermined expressions (Q(t)) at all points of time and for all input patterns or sequences of input values are uniquely defined.

19. Method according to any of the preceding claims, wherein predetermined expressions (Q(t)) are the values that issue some of user selected output parameters.

20. Method according to any of the preceding claims, wherein the quality factor is not reduced by adding a further property.

21. Method according to any one of the preceding claims for the functional verification of digital circuits, wherein the digital circuit is checked with a quantity of properties, whose quality factor complies with a predetermined reference.

22. Method according to any one of claims 1 to 20 for the specification of digital circuits, wherein the specification is generated, assuming a quantity of properties, whose quality factor was determined in accordance with a method according to the claims 1 to 20 and whose quality factor complies with a predetermined reference.

23. Method according to any one of claims 1 to 20 for the simulative verification of digital circuits, wherein monitors are utilized, wherein the monitors represent machines and the quality of the monitors is determined using the quality factor of a quantity of properties that describes the monitor being determined according to any one of claims 1 to 20.

24. Method according to any one of claims 1 to 20 for the simulative verification of digital circuits, wherein the coverage is determined by monitors, which are acquired based on the assumption of a set of properties whose quality factor is determined by a method according to any one of claims 1 to 20 and which complies with a predetermined reference.

**Revendications**

1. Procédé implémenté par matériel pour vérification fonctionnelle de circuits numériques, dans lequel le circuit numérique est vérifié avec un ensemble de propriétés qui décrivent un comportement du circuit numérique, lisant des valeurs d'entrée et fournissant des valeurs de sortie par l'intermédiaire d'au moins une grandeur de sortie, dans lequel le circuit numérique comprend une pluralité de premières valeurs internes, et traite une suite de valeurs d'entrée sur la base de la pluralité de premières valeurs internes, le circuit numérique engendrant pour au moins une des valeurs d'entrée et au moins une des valeurs internes une nouvelle valeur interne et une valeur de sortie, le procédé comprenant des étapes consistant à:

a) déterminer l'existence d'au moins une sous-quantité de propriétés par la formation de propriétés additionnelles dans un créateur de propriétés et la vérification (33) des propriétés additionnelles dans un vérificateur de propriété, dans lequel la sous-quantité de propriétés détermine de manière univoque une expression prédéterminée Q(t) pour la valeur de sortie pour au moins un instant en relation avec les valeurs d'entrée, dans lequel l'expression prédéterminée Q(t) pour l'instant n'est pas déterminée de manière univoque par les propriétés individuelles en dépendance que des valeurs d'entrée, et la sous-quantité de propriétés comprenant au moins un enchainement de propriétés et est analysée, les valeurs de signal de sortie étant déterminées de manière univoque le long de l'enchainement de propriétés, des domaines de temps etant calculés, pour lesquels des signaux de sortie des propriétés sont définis de manière univoque,

b) choisir une pluralité d'expressions prédéterminées Q(t), l'expression Q (t) étant la valeur d'une des valeurs de sortie à un instant t,

c) déterminer un taux de qualité qui dépend de savoir pour quels instants et pour quelles expressions prédéterminées Q(t), et pour quelles suites de valeurs d'entrée l'expression prédéterminée correspondante Q(t) est déterminée de manière univoque,

d) l'émission du taux de qualité.

2. Procédé selon la revendication précédente, dans lequel une première propriété décrit le comportement d'initialisation du circuit numérique.

3. Procédé selon l'une quelconque des revendications précédentes, dans lequel d'autres propriétés sont obtenues et émises, qui sont ni appropriées pour la construction de l'enchainement de propriétés $(P_0, P_i, ... P_n)$, ni a déterminer de manière univoque, pour une suite de valeurs d'entrée, la valeur de l'expression prédéterminée $(Q(t))$.

4. Procédé selon la revendication 2 ou 3, dans lequel les propriétés $(P_o, P_i, ... P_n)$ de l'enchainement de propriétés ont la forme $P_i = $ forall t : $A_i(t) => Z_i(t)$, avec des expressions booléennes combinées de manière impliquante $A_i(t)$ et $Z_i(t)$, qui sont dépendantes des valeurs d'entrée, des valeurs de sortie, et des valeurs internes à des instants par rapport à t, dans lequel, lors de l'étape de détermination de l'existence, on vérifie si une suite d'instants de référence $(T_1, T_2, ...T_n)$ existe, de sorte que la propriété donnée E au moyen de la suite de propriétés $(P_0, P_1... P_n)$ par rapport aux instants de référence par l'intermédiaire de l'enchainement de propriétés $((P_0, P_i, ... P_n)$,

$$E = \text{forall } t \quad (A_0(t) =>Z_0(t) \text{ et}$$
$$((A_0(t) \text{ et } A_1(T_1)) \ =>Z_1(T_1)) \text{ et}$$
$$((A_0(t) \text{ et } A_1(T_1) \text{ et } A_2(T_2)) \ =>Z_2(T_2)) \text{ et}$$
$$\ldots \text{et}$$
$$((A_0(t) \text{ et } A_1(T_1) \text{ et}\ldots.. \text{ et } A_n(T_n)) \ =>Z_n(T_n))$$

décrit de manière univoque une des valeurs de sortie du circuit numérique pour au moins une suite de valeurs d'entrée en au moins un instant.

5. Procédé selon l'une quelconque des revendications précédentes, dans lequel une quantité de la suite de valeurs d'entrée est déterminée, pour lesquelles l'expression prédéterminée $(Q(t))$ est déterminée de manière univoque pour respectivement au moins un instant.

6. Procédé selon la revendication 4 ou 5, dans lequel la quantité de la suite de valeurs d'entrée est vérifiée par l'existence d'au moins une série de valeurs dés valeurs internes et des valeurs de sortie pour une suite de cette quantité de la suite de valeurs d'entrées, de sorte qu'il existe au moins un instant t pour lequel les suites de valeurs $A_o(t)$ et $Z_o(t)$ et $A_1(T_1)$ et $Z_1(T_1)$ et ... et $A_n(T_n)$ sont valables.

7. Procédé selon la revendication 4, dans lequel les instants de référence $T_1, T_2, ... T_n$ sont indépendants des valeurs d'entrée.

8. Procédé selon l'une quelconque des revendications précédentes, dans lequel les propriétés de la sous-quantité de propriétés $(P_0, P_i, ... P_n)$ sont en relation séquentielle, dans lequel pour $i \neq 0$, de telles valeurs de sortie et valeurs internes, pour lesquelles $Z_{i-1}(t)$ est satisfait par une sélection appropriée d'une suite de valeurs d'entrée, également $A_i(t')$ est satisfait avec une sélection appropriée de t' et la suite de valeurs d'entrées.

9. Procédé selon l'une quelconque des revendications précédentes, dans lequel les propriétés de la sous-quantité de propriétés sont en relation séquentielle, dans lequel, pour $i \neq 0$, les $Z_{i-1}(T)$ et $A_i(t)$ contiennent de manière syntaxique des expressions partielles égales, excepté pour le délai temporel, pour des valeurs internes et des valeurs de sortie.

10. Procédé selon l'une quelconque des revendications précédentes, dans lequel on vérifie si une quantité finie de propriétés détermine de manière univoque, pour au moins une suite de valeurs d'entrée, les valeurs de sortie qui sont données sur une grandeur de sortie pour tous les instants suivant un premier instant,.

11. Procédé selon l'une quelconque des revendications précédentes, dans lequel l'étape de détermination de l'existence d'au moins une sous-quantité plus étroite de la sous-quantité des propriétés est répétée, afin de déterminer des sous-quantités additionnelles, qui déterminent de manière univoque l'expression ($Q(t)$) pour au moins une autre suite de valeurs d'entrée à au moins un instant.

12. Procédé selon l'une quelconque des revendications précédentes, dans lequel le procédé est répété par rapport à toutes les grandeurs de sortie et à toutes les suites de valeurs d'entrée, de sorte qu'on s'assure que, pour chaque suite de valeurs d'entrée, toutes les valeurs de sortie pour chaque instant suivant un premier instant sont déterminées de manière univoque.

13. Procédé selon la revendication 12, dans lequel de telles suites de valeurs d'entrée sont identifiées et déterminées, pour lesquelles les propriétés ne déterminent pas de manière univoque au moins une valeur de sortie pour au moins un instant suivant le premier instant.

14. Procédé selon l'une quelconque des revendications précédentes, dans lequel le circuit numérique est piloté au moins en partie par logiciel.

15. Procédé selon l'une quelconque des revendications précédentes, dans lequel le circuit numérique est implémenté au moins partiellement par matériel.

16. Procédé selon l'une quelconque des revendications précédentes, dans lequel au moins quelques unes des valeurs d'entrée sont lues par des signaux d'entrée.

17. Procédé selon l'une quelconque des revendications précédentes, dans lequel au moins quelques unes des valeurs de sortie sont données par des signaux de sortie.

18. Procédé selon l'une quelconque des revendications précédentes, dans lequel le taux de qualité a une valeur maximale prédéterminée, lorsque toutes les expressions prédéterminées $Q(t)$ pour tous les instants et pour toutes les suites de valeurs d'entrée sont déterminées de manière univoque.

19. Procédé selon l'une quelconque des revendications précédentes, dans lequel les expressions prédéterminées $Q(t)$ sont des valeurs qui donnent quelques unes des grandeurs de sortie choisies par un utilisateur.

20. Procédé selon l'une quelconque des revendications précédentes, dans lequel le taux de qualité ne devient pas plus petit par l'ajout d'une propriété additionnelle.

21. Procédé selon l'une quelconque des revendications précédentes pour la vérification fonctionnelle de circuits numériques, dans lequel le circuit numérique est vérifié avec une quantité de propriétés, dont le taux de qualité correspond à une référence définie.

22. Procédé selon l'une quelconque des revendications 1 à 20 pour la spécification de circuits numériques, dans lequel la spécification est émise, à partir d'une quantité de propriétés dont le taux de qualité est déterminé selon un procédé selon l'une des revendications 1 à 20 et qui correspond à une référence définie.

23. Procédé selon l'une quelconque des revendications 1 à 20 pour la vérification par simulation de circuits numériques, par lequel des moniteurs sont utilisés, dans lequel les moniteurs représentent des automates, et la qualité des moniteurs est déterminée au moyen du taux de qualité d'une quantité de propriétés décrivant un moniteur, déterminée selon un procédé selon l'une des revendications 1 à 20.

24. Procédé selon l'une quelconque des revendications 1 à 20 pour la vérification par simulation de circuits numériques, par lequel est déterminé au moyen de moniteurs, qui sont gagnés à partir des hypothèsse d'une phrase de propriétés, et dont la qualité est établie selon un procédé selon l'une des revendications 1 à 20 et qui correspond à une référence définie.

Figur 1: Verschiedene Teileigenschaftsgraphen

Figur 2: Blockdiagramm des Vollständigkeitsprüfers

a       b

(16) Schleifenkontrolle: Bearbeitung aller Haupteigenschaften P und aller Kanten P' -> P'' des Teileigenschaftsgraphen, die auf einem Pfad zu einer Nachfolgeeigenschaft von P liegen.

(16') Kopieren von P' in frische Zeitvariablen T'$_i$

(17) Eigenschaftserzeuger für Schema „ second_case_split"

(18) Eigenschafts-prüfung

(19) Gegen-beispiel

(20) Eigenschaftserzeuger für Schema „ first_reset_test"

(21) Eigenschafts-prüfung

(22) Gegen-beispiel

(23) Eigenschaftserzeuger für Schema „ second_reset_test"

(24) Eigenschafts-prüfung

(25) Gegen-beispiel

(26) Meldung über erfolgreiche Vollständigkeitsprüfung

Figur 2 - Fortsetzung: Blockdiagramm des Vollständigkeitsprüfers

EP 1 764 715 B1

58

(1) annotierte
Eigenschaftsmenge

(32) Schaltungsbeschreibung

(30) Schleifenkontrolle
Bearbeitung aller Haupt- und Teileigenschaften P

(31) Eigenschaftserzeuger für
Schema „circuit_property"

(33) Eigenschaftsprüfung

(35) Gegenbeispiel

(34) Meldung des erfolgreichen Beweises

Figur 3: Eigenschaftsprüfung entsprechend Stand der Technik

Figur 4: Automatisierte Bestimmung der redundanten Benutzervorgaben

EP 1 764 715 B1

EP 1 764 715 B1

● a     ● b

(30) Kopieren der Belegung interner Größen

(31) Schleifenkontrolle: Bearbeitung aller Eigenschaften P

(32) Schleifenkontrolle: Bearbeitung aller Q aus $NN_P$

(33) Eigenschaftserzeuger für Schema „first_test"

(34) Eigenschafts-prüfung

Widerspruch oder widersprüchliche Annahme

(35) Erstes Element von $MRef_{PQ}$ entfernen, alle $DZ_{Rs}$ reinitialisieren

(36) MRefPQ leer?   nein

(37) Q aus $NN_P$ entfernen

(40) Eigenschaftserzeuger für Schema „second_test"

(41) Eigenschafts-prüfung

Widerlegung

(42) Analyse und Reduktion von $DZ_{Qs}$

(50) interne Größen gegenüber Kopien aus (30) verändert?

(51) Bestimmung und Ausgabe der Vorgaben des Hauptverfahrens

Figur 4 (Fortsetzung): Automatisierte Bestimmung der redundanten Benutzervorgaben

(1) annotierte Eigenschaftsmenge

(102) Schleifenkontrolle: Alle Haupteigenschaften P

(103) Alle Quellen P' mit einem Pfad zu einer Nachfolgeeigenschaft von P

(104) Kopierer

(105) erster Überdeckungswertbestimmer

(106) Alle Kanten P' -> P'' im Teileigenschaftsgraph, die auf einem Pfad zu einer Nachfolgeeigenschaft von P

(107) Kopierer

(108) zweiter Überdeckungswertbestimmer

(109) Alle Nachfolger P' von P

(110) Haupteigenschaftsüberdeckungswertbestimmer

(111) Ausgabedeterminiertheitsbestimmer

(112) Bestimmer für die lokale Maßzahl w(P, P')

(113) Ausführungsbaumbestimmer

(114) Alle Knoten P des Ausführungsbaums in umgekehrter Breitensuche

(115) Knotenbewerter für V(P)

(116) Ausgabe: V(P_{rest})

Figur 5: Verfahren zur Bestimmung einer Vollständigkeitsmaßzahl

Figur 6: Graph des vollständigen Eigenschaftsautomaten des Beispiels

Figur 7: Graph des unvollständigen Eigenschaftsautomaten des Beispiels

Figur 8: Ausführungsbaum des Eigenschaftsautomaten aus Figur 7

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6594804 B

- WO 200079421 A2

**In der Beschreibung aufgeführte Nicht-Patentliteratur**

- Verification Methodology Manual - Techniques for Verifying HDL Designs. **D. DEMPSTER ; M. STUART.** Teamwork International. 2001
- Coverage Metrics for Functional Validation of Hardware Designs. **S. TARISAN ; K. KEUTZER.** IEEE Design & Test of Computers. 2001
- **A.BIERE ; A.CIMATTI ; M.FUJITA ; Y.ZHU.** Symbolic Model Checking using SAT procedures instead of BDDs. *Proc. of 36th Design Automation Conference,* 1999

- Formale Verifkation für Nicht-Formalisten (Formal Verification for Non-Formalists. **BORMANN, J ; SPALINGER, C.** Informationstechnik und Technische Informatik. Oldenburg Verlag, 2001, vol. 43
- **Nimmer et al.** Static verification of dynamically detected program invariants. *Electronic notes in computer science,* 2001, (2), 255-276
- **Katz et al.** Have I written enough properties?. *LCNS,* vol. 1703 (19999), 280-297